(19)

Europäisches
Patentamt
European
Patent Office
Office européen
des brevets

(11) **EP 4 782 425 A1**

(12) **EUROPEAN PATENT APPLICATION**
published in accordance with Art. 153(4) EPC

(43) Date of publication:
**29.07.2026 Bulletin 2026/31**

(21) Application number: **24868151.2**

(22) Date of filing: **06.09.2024**

(51) International Patent Classification (IPC):
**C04B 35/587** (2006.01)   **C01B 21/068** (2006.01)
**H05K 1/03** (2006.01)

(52) Cooperative Patent Classification (CPC):
**C01B 21/068; C04B 35/587; H05K 1/03**

(86) International application number:
**PCT/JP2024/032058**

(87) International publication number:
**WO 2025/063073 (27.03.2025 Gazette 2025/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.09.2023   JP 2023151069**

(71) Applicant: **UBE Corporation
Ube-shi, Yamaguchi 755-8633 (JP)**

(72) Inventors:
- **YAMADA, Tetsuo
  Tokyo 105-8449 (JP)**
- **OHMARU, Takuji
  Ube-shi, Yamaguchi 755-8633 (JP)**
- **SHIBATA, Koji
  Ube-shi, Yamaguchi 755-8633 (JP)**

(74) Representative: **Plougmann Vingtoft a/s
Strandvejen 70
2900 Hellerup (DK)**

(54) **SILICON NITRIDE POWDER AND METHOD FOR PRODUCING SILICON NITRIDE SINTERED BODY**

(57)     A main object of the present invention is to provide sinterable crystalline silicon nitride powder capable of yielding a silicon nitride sintered body having sufficient mechanical strength properties, as well as excellent thermal conductivity.

The present invention provides a silicon nitride powder containing primary particles of silicon nitride, wherein the silicon nitride powder has on the surface of the primary particles an amorphous layer composed of silicon oxide and/or silicon oxynitride, the average value of the thickness of the amorphous layer is 5.0 nm or less, the coefficient of variation of the thickness of the amorphous layer as represented by the specific expression (1) is 0.60 or less, and the silicon nitride powder has a halogen content of 130 ppm or less. The present invention also provides a method for producing a silicon nitride sintered body, including a step of molding and sintering a sintering material containing the silicon nitride powder described above, and a sintering aid.

Figure 1

**EP 4 782 425 A1**

**Description**

[Technical Field]

The present invention relates to a crystalline silicon nitride powder suitable as a starting material for production of a silicon nitride sintered body useful in heat-resistant structural materials, wear-resistant materials and circuit board materials, as well as to a method for producing the silicon nitride sintered body.

[Background Art]

Silicon nitride sintered bodies have high strength and excellent corrosion-resistance and thermal shock resistance, and are therefore considered promising as heat-resistant structural components such as gas turbine parts and automobile engine parts, and wear-resistant components such as bearing parts. Silicon nitride sintered substrates are also increasingly being used as insulating substrates for use in power modules designed for electric vehicles (EV) and railway vehicles. Such silicon nitride sintered bodies are usually produced by mixing a sintering aid into a silicon nitride powder and forming a compact by press molding, injection molding, extrusion forming or sheet casting, and then sintering the compacts in an atmospheric pressure atmosphere or pressurized atmosphere, or by applying pressurized press. When producing a silicon nitride sintered body by these methods, it is known that the powder properties of the silicon nitride powder starting material, including especially the oxygen content, have a major effect on the sinterability and properties of the sintered body. Specifically, silicon nitride powders with high oxygen content are generally easy to sinter but cannot provide sufficient high-temperature strength. Silicon nitride powders with low oxygen content are difficult to sinter and are difficult to produce sufficiently densified materials.

Patent Literature 1, for example, discloses a method for improving the high-temperature properties of a silicon nitride sintered body, whereby the specific surface area of the silicon nitride powder is 10 $m^2$/g or higher and the total oxygen content is 1.5 wt% or lower, thereby reducing the proportion of the grain boundary phase generated during sintering, and maintaining a high melting temperature, to improve the high-temperature properties.

Patent Literature 2 discloses a ceramic substrate composed of $Si_3N_4$, wherein the concentration of silicon oxide and silicon complex oxide on the substrate surface is set to no greater than 2.7 Atom% based on surface concentration measurement using an electronic probe microanalyzer, thereby producing a substrate for a power module having sufficient bonding strength for bonding with metal members such as aluminum, and increasing the bonding reliability during thermal cycling. Such insulating substrates must have high insulating properties and heat dissipation properties.

[Citation List]

[Patent Literature]

[Patent Literature 1] Japanese Unexamined Patent Publication No. HEI 7(2005)-206409
[Patent Literature 2] Japanese Unexamined Patent Publication No. 2009-231388
[Patent Literature 3] Japanese Unexamined Patent Publication No. HEI 5(2003)-70110
[Patent Literature 4] International Patent Publication No. WO2021/200868
[Patent Literature 5] Japanese Examined Patent Publication No. HEI 5(2003)-87441
[Patent Literature 6] Japanese Unexamined Patent Publication No. HEI 6(2004)-329404
[Patent Literature 7] International Patent Publication No. WO2013/146713
[Patent Literature 8] International Patent Publication No. WO2021/200830

[Non Patent Literature]

[Non Patent Literature 1] G.P. Gazzara and D.P. Messier, Am. Ceram. Soc. Bull., 56[9], pp.777-80(1977).

[Summary of Invention]

[Technical Problem]

The oxygen in silicon nitride powder is generally defined by the oxygen present in the silicon oxide layer and/or silicon oxynitride layer on the particle surfaces (surface oxygen), the oxygen present as solid solution in the silicon nitride crystals in the particle interiors (internal oxygen) and the total oxygen content (sum of the surface oxygen content and internal oxygen content). When the oxygen in silicon nitride powder is divided into surface oxygen and internal oxygen, it is said that surface oxygen in particular has a significant effect on sinterability.

Patent Literature 3 discloses a silicon nitride powder coated with amorphous $SiO_2$. The thickness of the amorphous film readable from the published TEM photograph is about 6 nm; however, no TEM photograph that allows determination of the thickness distribution of the amorphous film is disclosed. Further, the $SiO_2$ amount based on the amorphous $SiO_2$ film is an excessive value of 1.7 wt% or higher, and the ratio of the surface oxygen content to the BET specific surface area is a large value of 0.75 $m^2$/g or higher (the inherent excellent thermal and mechanical properties of the silicon nitride sintered body cannot be expected). Furthermore, since the carbon content contained in the silicon nitride powders A and B is a high value of 0.20 wt% or higher, voids are likely to occur in the silicon nitride sintered body, resulting in a problem that variations in the thermal and mechanical properties become large.

Patent Literature 4 discloses a silicon nitride powder having an oxide film on the surface of the primary particles, the thickness of the oxide film being 20.0 nm or less. However, the expression "the primary particles have an oxide film on at least a portion of the surface" is ambiguous, and no measurement data that allows determination of the thickness distribution of the oxide film is disclosed. Furthermore, the thickness of the oxide film disclosed in the examples is a large value of 6.0 nm or more. Accordingly, the resulting "flexural strength of the silicon nitride sintered body can be, for example, 550 MPa or higher... or 610 MPa or higher (paragraph [0044])" remains at such a low level, and the results substantiate that when the thickness of the oxide film is excessively large, the inherent excellent thermal and mechanical properties of the silicon nitride sintered body cannot be expected. Further, since the surface oxygen content is not described, the ratio of the surface oxygen content to the BET specific surface area cannot be determined.

Patent Literature 5 describes a silicon nitride powder having a surface oxygen content of 0.3 to 0.6 wt% and an internal oxygen content of 0.5 to 1.1 wt%. However, while these inventions disclose the surface oxygen content and internal oxygen content, they nowhere mention the effect of the ratio of the surface oxygen content to the specific surface area, or the effect of the ratio of the total oxygen content to the specific surface area, and therefore the high-temperature flexural strength of the obtained sintered body is 550 MPa or lower for sintered body A and 640 MPa or lower for sintered body B.

Patent Literature 6 discloses a silicon nitride powder wherein the oxygen content present as hydroxide or oxide on the particle surfaces is 0.2 to 1.0 wt% while the oxygen content present as solid solution is 0.5 to 1.2 wt%, and of the oxygen present as solid solution, the oxygen content present in a range of 3 nm directly beneath the particle surfaces is 0.1 to 0.5 wt% while the oxygen content present at a depth of 3 nm or more from the particle surfaces is 0.8 wt% or less. The same patent publication defines the surface oxygen content (O) as the sum of the oxygen content present as hydroxide or oxide on the particle surfaces (surface oxygen content (A)) and the oxygen content present as solid solution in a range of 3 nm directly beneath the particle surfaces (surface oxygen content (B)). In paragraph [0010] of the patent publication, it is stated to the effect that "with a surface oxygen content of less than 0.3 wt%, the wettability between the silicon nitride particles and the liquid phase containing the sintering aid is reduced during sintering", explaining the importance of having a surface layer of suitable thickness on the surfaces of the silicon nitride particles (a layer containing oxygen present as hydroxide, oxide or solid solution). According to Table 2 in paragraph [0020], the surface oxygen content (O) in Examples 1 to 8 was 0.48 to 0.86 wt%, the specific surface area (S) was 9.5 to 12.2 $m^2$/g, and the ratio of the specific surface area (S) to the surface oxygen content (O), S/O, was 11.9 to 20.2. In other words, the ratio O/S of the surface oxygen content (O) to the specific surface area (S), O/S, is listed as being 0.50 to 0.84 mg/$m^2$ (also expressed as 0.050 to 0.084%/$m^2 g^{-1}$).

Patent Literature 7 discloses that using a silicon nitride powder having low internal oxygen and surface oxygen suitable for sintering, can yield a silicon nitride sintered body which is dense and exhibits excellent mechanical strength, and especially a silicon nitride sintered body having both high thermal conductivity and excellent mechanical strength. However the method for producing the silicon nitride powder disclosed in that patent publication involves flowing an amorphous Si-N(-H)-based compound through a continuous kiln while firing under a nitrogen-containing inert gas atmosphere or under a nitrogen-containing reducing gas atmosphere at a temperature of 1400 to 1700°C. Since an amorphous Si-N(-H)-based compound is rapidly subjected to high-temperature firing in this method, the degree of supersaturation near the particles increases, promoting nucleation (a greater number of nuclei), such that the resulting silicon nitride particles are micronized and a higher specific surface area is obtained. In contrast, when using an conventional firing process (such as a process of loading the starting material into a crucible and firing in a batch furnace or pusher furnace without flow), it is difficult to stably produce a crystalline silicon nitride powder with a BET specific surface area of 8 $m^2$/g or higher if the oxygen content of the starting material is too low. The surface oxygen content of the crystalline silicon nitride powders described in Examples 1 to 12 is high at 0.62 mass% or more, presumably as a feature of the method of firing an amorphous Si-N(-H)-based compound in a continuous kiln with flow.

Patent Literature 8 discloses a silicon nitride powder in which the ratio of surface oxygen content to specific surface area is 0.02 to 0.09%/$m^2 g^{-1}$ (corresponding to 0.2 to 0.9 mg/$m^2$ in the expression of the present specification). However the definition of 0.02 to 0.09%/$m^2 g^{-1}$ is a surface oxygen content of 0.2 to 0.9 wt% for a BET specific surface area of 10 $m^2$/g, and it therefore includes the surface oxygen content range disclosed in Patent Literature 5 (0.3 to 0.6 wt%). Patent Literature 8 also contains no mention of the internal oxygen content. This patent document also describes prolonged immersion of a pulverized product having a very high oxygen concentration of 3.6 to 5.1 mass%, in a high-concentration hydrofluoric acid solution as acid treatment. Moreover, nothing is mentioned regarding the fluorine content of the resulting silicon nitride powder, even though treating a pulverized product in a high-concentration hydrofluoric acid solution having a hydrofluoric acid concentration of 10 to 40 mass% to remove the oxygen in the pulverized product leaves fluorine in the silicon nitride powder even after washing with water. In Table 1 under the Examples, the properties (such as flexural strength and thermal conductivity) of silicon nitride sintered bodies obtained by sintering for 10 hours under a 1 MPa nitrogen pressurized atmosphere at a temperature of 1900°C are listed as relative values, making it impossible to judge the effect of the invention.

It is an object of the present invention to solve the aforementioned problems and provide a sinterable crystalline silicon nitride powder that can yield a silicon nitride sintered body having excellent properties including fracture toughness. It is another object of the present invention to provide a crystalline silicon nitride powder that allows production of a silicon nitride sintered body having sufficient mechanical strength properties, as well as excellent thermal conductivity. It is yet another object of the present invention to provide a method for producing a silicon nitride sintered body having high strength properties and excellent thermal conductivity.

[Solution to Problem]

The present inventors have extensively studied the effects of the specific surface area, halogen content, oxygen content, and oxygen distribution of silicon nitride powder, on the sinterability and sintered body properties, especially strength properties (such as fracture toughness) and thermal conductivity. As a result, they found that a sinterable silicon nitride powder capable of providing a silicon nitride sintered body having excellent properties such as high toughness has an amorphous film composed of silicon oxide and/or silicon oxynitride on the surface of the primary particles, and that the thickness of the amorphous film is not more than a prescribed value and the coefficient of variation thereof is less than a predetermined value (i.e., the thickness distribution of the amorphous film falls within a narrow range). In other words, an embodiment of the present invention provides a crystalline silicon nitride powder wherein the crystalline silicon nitride powder contains primary particles of silicon nitride, and has on the surface of the primary particles an amorphous film composed of silicon oxide and/or silicon oxynitride, the average value of the thickness of the amorphous film is 5.0 nm or less, and the coefficient of variation of the thickness of the amorphous film as represented by the following expression (1) is 0.60 or less.

[Expression 1]

$$C_v = \frac{\sqrt{\dfrac{1}{n}\sum_{i=1}^{n}(x_i - \overline{x})^2}}{\overline{x}} \qquad \cdots \cdots \cdots \quad (1)$$

wherein, in the expression (1), $\overline{x}$ represents the average value of the thickness of the amorphous film, n represents the number of measurement points for the thickness of the amorphous film, and $x_i$ represents the thickness of the amorphous film measured at the i-th point, respectively.

The silicon nitride powder of an embodiment of the present invention contains primary particles of silicon nitride, wherein the primary particles have an amorphous film on at least a portion of their surface. As used herein, the amorphous film means the amorphous portion existing on the surface of the primary particles. In other words, the amorphous film means a portion having a contrast different from the portion in which lattice fringes corresponding to specific lattice planes of crystalline silicon nitride ($\alpha$-type $Si_3N_4$ or $\beta$-type $Si_3N_4$) are observed, and in which lattice fringes are not observed. The portion in which lattice fringes are not observed contains a larger amount of oxygen atoms than the interior of the primary particles. The thickness of the amorphous film can be determined by measuring the thickness of the portion in which lattice fringes are not observed, with reference to a specific lattice plane of crystalline silicon nitride (for example, the (1010) plane of $\alpha$-$Si_3N_4$, wherein the I(el) in the exemplary Miller indices (hklm) represents a 1 with an overbar). The chemical composition (that the amount of oxygen atoms is larger than interior of the particles) can be confirmed by elemental analysis using energy-dispersive X-ray spectroscopy (EDX). The amorphous film contains, for example, silicon oxide and/or silicon oxynitride.

In an embodiment of the present invention, the thickness of the amorphous film is measured at two or more locations on any silicon nitride particle and for 15 or more silicon nitride particles, for a total of 30 or more locations, and the average value and coefficient of variation thereof are determined. In the above expression (1), the value of n is defined as 30 or more, but it is preferable that the value of n be large, with 40 or higher being more preferable and 60 or higher being still more preferable. When the value of n is lower than 30, the dispersion of the thickness of the amorphous film cannot be accurately reflected. The coefficient of variation is expressed by the above expression (1), and when expressed as a percentage, the value obtained by the above expression (1) is multiplied by 100 to give a percent representation.

The above silicon nitride powder has an amorphous film of a prescribed thickness on the surface of the primary particles, and exhibits a small coefficient of variation. It offers such characteristics and is suitable as a raw material for producing a silicon nitride sintered body having sufficient strength properties and excellent thermal conductivity. The above silicon nitride powder further enables a production of a silicon nitride sintered body having high strength properties and excellent thermal conductivity. The reasons why such effects can be obtained are considered as follows. In the sintering of the silicon nitride compacts, during the heating process, the sintering aid reacts with the amorphous film on the surface of the primary particles to form a low-melting-point silicate phase. After the α-type silicon nitride dissolves into the molten silicate phase, a dense microstructure of particles is formed in the process of reprecipitation as β-type silicon nitride. The melting point of the silicate phase varies depending on its chemical composition. Thus, owing to the small coefficient of variation in the thickness of the amorphous film on the surface of the primary particles, a uniform molten phase is formed in the molded body, whereby rearrangement of the silicon nitride particles, dissolution of the α-type silicon nitride, and smooth reprecipitation as β-type silicon nitride proceed. Accordingly, a favorable microstructure is formed. Further, owing to the small coefficient of variation in the thickness of the amorphous film, rapid densification can be achieved with a minimum amount of molten phase, and a highly dense silicon nitride sintered body with a small proportion of grain boundary phase can be obtained. Furthermore, as densification proceeds with a minimum amount of molten phase, favorable columnar silicon nitride crystals grow, thereby improving strength properties, and a high-density microstructure with a small proportion of grain boundary phase develops. As a result, a silicon nitride sintered body having higher thermal conductivity than conventional ones can be obtained.

In the present description, unless otherwise specified, the exemplified materials may be used singly or in combination of two or more kinds. The content of each component in the composition, when a plurality of substances corresponding to each component are present in the composition, unless otherwise specified, means the total content of the plurality of substances present in the composition.

The average value of the thickness of the amorphous film is 5.0 nm or less, and the coefficient of variation of the thickness of the amorphous film as represented by the above expression (1) is 0.60 or less.

An embodiment of the present invention provides a crystalline silicon nitride powder wherein the average thickness of the amorphous film composed of silicon oxide and/or silicon oxynitride is 2.0 nm or less, and the coefficient of variation of the thickness of the amorphous film is 0.50 or less.

An embodiment of the present invention provides a crystalline silicon nitride powder wherein the BET specific surface area (SA) is 3.0 m$^2$/g to 13.0 m$^2$/g, the surface oxygen content (FSO) measured by linear temperature ramp mode analysis is 0.15 mass% to 0.65 mass%, and the internal oxygen content (FIO) measured by linear temperature ramp mode analysis is 0.25 mass% to 1.00 mass%.

An embodiment of the present invention provides a crystalline silicon nitride powder wherein the BET specific surface area (SA) is 3.0 m$^2$/g or higher and lower than 8.0 m$^2$/g, the surface oxygen content (FSO) measured by linear temperature ramp mode analysis is 0.15 mass% to 0.40 mass%, the internal oxygen content (FIO) measured by linear temperature ramp mode analysis is 0.25 mass% to 0.90 mass%, and a ratio of the surface oxygen content to the BET specific surface area (FSO/SA) is 0.25 mg/m$^2$ or more and less than 0.50 mg/m$^2$.

An embodiment of the present invention provides a crystalline silicon nitride powder wherein the BET specific surface area (SA) is 8.0 m$^2$/g to 13.0 m$^2$/g, the surface oxygen content (FSO) measured by linear temperature ramp mode analysis is 0.20 mass% to 0.65 mass%, the internal oxygen content (FIO) measured by linear temperature ramp mode analysis is 0.50 mass% to 1.00 mass%, and a ratio of the surface oxygen content to the BET specific surface area (FSO/SA) is 0.23 mg/m$^2$ or more and less than 0.50 mg/m$^2$.

The ratio of the surface oxygen content (FSO) measured by linear temperature ramp mode analysis to the BET specific surface area (SA), FSO/SA, of the silicon nitride powder of an embodiment of the present invention serves as a measure for evaluating the thickness of amorphous film composed of the silicon oxide and/or silicon oxynitride on the surfaces of silicon nitride primary particles. When the BET specific surface area (SA) is 3.0 m$^2$/g to 13.0 m$^2$/g, if the value of FSO/SA is 0.23 mg/m$^2$ or more and less than 0.50 mg/m$^2$, an amorphous film of suitable thickness will be formed on the primary particle surfaces, allowing a highly dense silicon nitride sintered body to be easily fabricated, due to formation of a molten phase of suitable volume by reaction with the sintering aid during the sintering process.

However, in the silicon nitride powder, since the primary particles are aggregated to form secondary particles and further tertiary particles, the thickness of the amorphous film calculated, based on a geometrical model, from the ratio of the surface oxygen content (FSO) to the BET specific surface area (SA), FSO/SA, differs from the thickness of the amorphous film measured by transmission electron microscopy observation. Furthermore, since the amorphous film contains silicon oxynitride and the ratio of silicon oxide to silicon oxynitride varies depending on the production conditions, it is difficult to calculate the thickness of the amorphous film from FSO/SA based on a geometrical model, and even if the thickness of the amorphous film is calculated on the basis of certain assumptions, it greatly differs from and does not coincide with the thickness of the amorphous film measured by transmission electron microscopy observation. Thus, in an embodiment of the present invention, the thickness of the amorphous film measured by transmission electron microscopy observation and the ratio of the surface oxygen content (FSO) measured by linear temperature ramp mode analysis to the BET specific surface area (SA), FSO/SA, are treated as completely separate and independent physical quantities.

Yet another embodiment of the present invention provides a crystalline silicon nitride powder wherein the halogen content is 130 ppm or lower. In an embodiment of the present invention, the halogen content means the total content of fluorine content and chlorine content.

An embodiment of the present invention provides a crystalline silicon nitride powder wherein the fluorine content is lower than 120 ppm.

Yet another embodiment of the present invention provides a crystalline silicon nitride powder wherein the surface fluorine content is 110 ppm or lower.

Yet another embodiment of the present invention provides a crystalline silicon nitride powder wherein the cumulative 10% diameter $D_{10}$ is 0.20 $\mu$m to 0.50 $\mu$m.

Yet another embodiment of the present invention provides a crystalline silicon nitride powder wherein a $\beta$ fraction ($\beta/(\alpha+\beta)$) is 1.3 mass% to 14.0 mass%. The $\beta$ fraction refers to the mass ratio $\beta/(\alpha+\beta)$ of the $\beta$ phase (composed of $\beta$-type silicon nitride, hereinafter referred to as "$\beta$ phase") to the total content of the $\alpha$ phase (composed of $\alpha$-type silicon nitride, hereinafter referred to as "$\alpha$ phase") and the $\beta$ phase.

Yet another embodiment of the present invention provides a method for producing a silicon nitride sintered body, including a step of molding and sintering a raw material containing the crystalline silicon nitride powder described above, and a sintering aid.

Throughout the present specification, the surface oxygen content and internal oxygen content as measured by linear temperature ramp mode analysis will be sometimes referred to simply as "surface oxygen content" and "internal oxygen content", respectively, omitting "as measured by linear temperature ramp mode analysis".

[Advantageous Effects of Present Invention]

According to the present invention it is possible to provide a silicon nitride powder capable of yielding a silicon nitride sintered body having excellent mechanical strength properties and high thermal conductivity. It is also possible to provide a method for producing a silicon nitride sintered body having excellent mechanical properties and high thermal conductivity.

[Brief Description of Drawings]

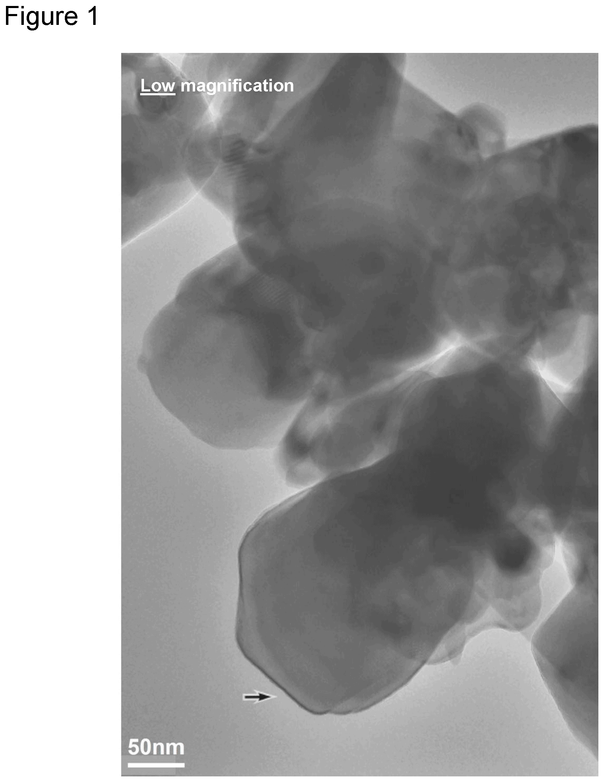

[Figure 1] Figure 1 is a transmission electron micrograph of the silicon nitride powder obtained in Example 1.

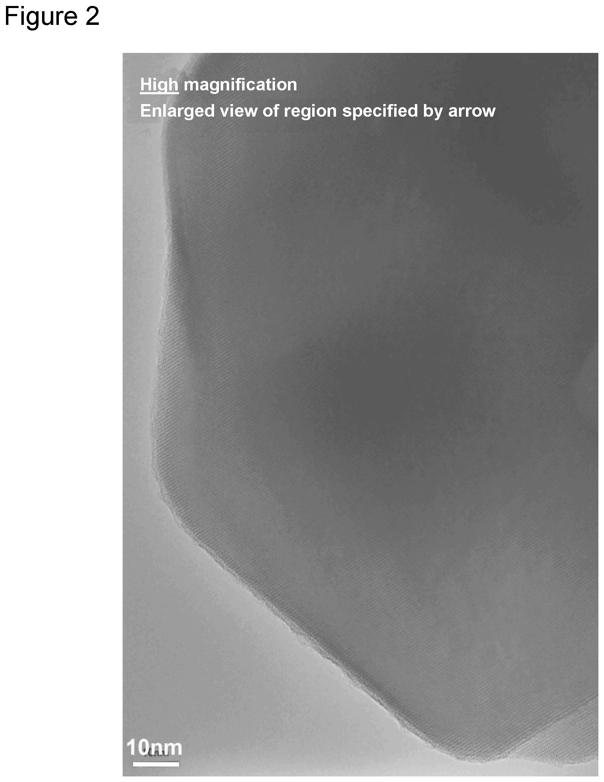

[Figure 2] Figure 2 is a partial enlarged view of region R specified by the arrow in Figure 1.

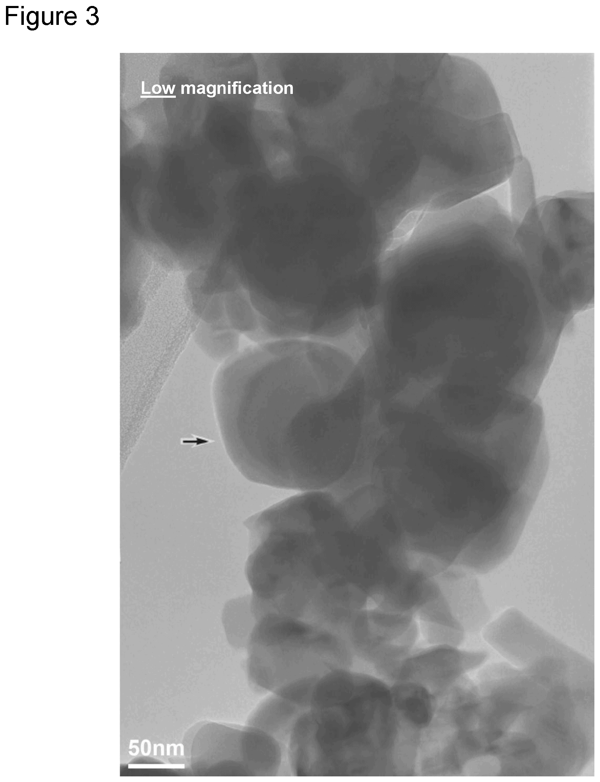

[Figure 3] Figure 3 is a transmission electron micrograph of the silicon nitride powder obtained in Example 10.

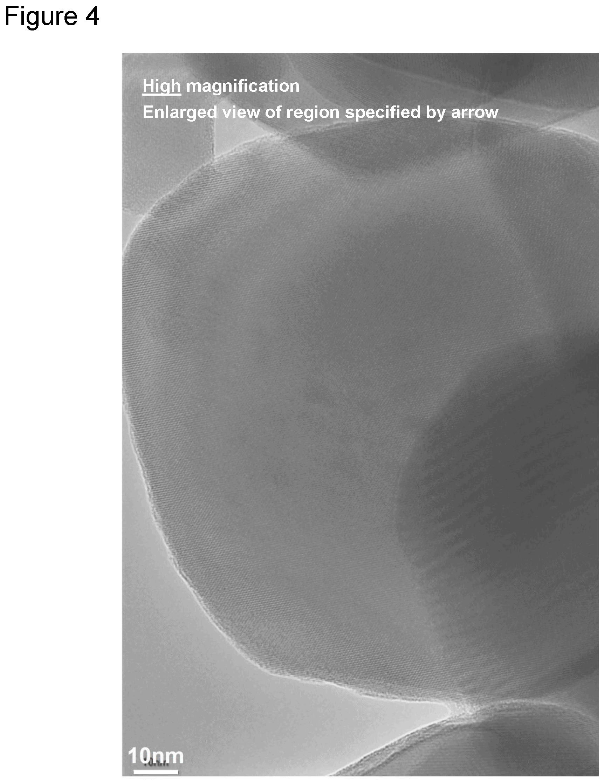

[Figure 4] Figure 4 is a partial enlarged view of region R specified by the arrow in Figure 3.
[Figure 5] Figure 5 is a diagram showing an example of an oxygen/nitrogen analysis chart.

[Description of Embodiments]

<<Silicon Nitride Powder>>

(Thickness of Amorphous Film on Primary Particle Surface)

The average value of the thickness of the amorphous film is 5.0 nm or less, and the coefficient of variation of the thickness of the amorphous film as represented by the above expression (1) is 0.60 or less. The lower limit of the average value of the thickness of the above amorphous film may be, for example, 0.4 nm or more, 0.6 nm or more, 0.8 nm or more, or 0.9 nm or more. When the lower limit of the average value of the thickness of the above amorphous film is within the above range, the sinterability can be further improved. In addition, grain growth during sintering can be promoted, whereby columnar crystals of $\beta$-$Si_3N_4$ develop, resulting in improved mechanical strength and toughness. Furthermore, thermal conductivity is further improved. The upper limit of the average value of the thickness of the above amorphous film may be 4.0 nm or less, 3.0 nm or less, 2.0 nm or less, or less than 1.0 nm, for example. When the upper limit of the average value of the thickness of the above amorphous film is within the above range, the development of columnar crystals of $\beta$-$Si_3N_4$ is not excessively suppressed. Fine columnar crystals develop, thereby increasing mechanical strength. In addition, the thickness (or volume fraction) of the grain boundary phase to be formed does not become excessively large, and the thermal conductivity can be controlled to an appropriate level. The thickness of the amorphous film present on the surface of the primary particles does not necessarily have to be uniform; however, in order to ensure easy sinterability and uniformity of the sintered body structure and to achieve favorable strength properties and thermal conductivity, it is necessary to control the coefficient of variation of the thickness of the amorphous film, as expressed by the above expression (1), within an appropriate range. The upper limit of the coefficient of variation of the thickness may be 0.50 or less, 0.40 or less, or 0.36 or less, for example. The lower limit of the coefficient of variation of the thickness may be 0.10 or more, 0.20 or more or 0.24 or more, for example.

(Adjustment of Thickness of Amorphous Film)

In the production of silicon nitride powder by imide decomposition method, the average value of the thickness of the above amorphous film and the coefficient of variation thereof can be controlled, for example, by adjusting the components in the atmosphere (oxygen concentration and moisture concentration), the milling conditions (milling intensity and treatment time), or the like during the deagglomeration step of the fired powder. In order to reduce the coefficient of variation of the thickness, comprehensive condition setting is carried out, for example, by setting the mill amplitude and the moisture concentration somewhat lower and by extending the treatment time somewhat longer.

In the production of silicon nitride powder by direct nitriding method, the average value of the thickness of the above amorphous film and the coefficient of variation thereof can be controlled, for example, by adjusting the hydrofluoric acid concentration during acid solution treatment of the pulverized powder, or the like. In order to reduce the coefficient of variation of the thickness, comprehensive condition setting is carried out, for example, by setting the hydrofluoric acid concentration somewhat lower and by extending the treatment time somewhat longer. Since the coefficient of variation of thickness is influenced by the particle size distribution of the primary particles, it may be necessary to take measures such as narrowing the particle size distribution of the primary particles.

(BET Specific Surface Area)

The silicon nitride powder of an embodiment of the present invention has a silicon oxide layer and/or silicon oxynitride layer on the particle surfaces, the crystalline silicon nitride powder having a specific surface area of 3.0 $m^2$/g to 13.0 $m^2$/g based on the BET method. The specific surface area is an important powder property which controls densification throughout the process of dissolution and precipitation of the silicon nitride particles into the molten phase during sintering, a BET specific surface area of lower than 8.0 $m^2$/g causing the driving force of sintering to begin to fall, and a BET specific surface area of lower than 3.0 $m^2$/g causing the driving force of sintering to fall significantly, making it difficult to obtain a high-density silicon nitride sintered body without addition of a large amount of sintering aid. Addition of a sintering aid in large amounts can impair the properties of the silicon nitride sintered body. If the BET specific surface area exceeds 13.0 $m^2$/g, this not only lowers the green density and hampers molding in conventional molding methods, but also generates microcracks and voids after sintering. In addition, it has an adverse effect on dimensional precision, while also being undesirable due to chippings or damages (cluster of cracks) at the corner sections of sintered bodies during sintering of complex shapes. The BET specific surface area is preferably 4.5 $m^2$/g to 12.7 $m^2$/g, more preferably 8.0 $m^2$/g to 12.3 $m^2$/g and even more preferably 8.6 $m^2$/g to 12.0 $m^2$/g.

For production of silicon nitride powder by imide decomposition method, the specific surface area can be controlled by adjusting the specific surface area and oxygen content of the amorphous Si-N(-H)-based compound, for example. For production of silicon nitride powder by a direct nitriding method, the specific surface area can be controlled by adjusting the pulverizing treatment conditions during production, for example.

The specific surface area in an embodiment of the present invention is the value measured by the BET one-point method using nitrogen gas, as described in JIS Z 8830: 2013 "Determination of the Specific Surface Area of Powders (Solids) by Gas Adsorption" (BET specific surface area).

(Surface Oxygen Content (FSO))

The surface oxygen content (FSO) of the silicon nitride powder of an embodiment of the present invention is in the range of 0.15 mass% to 0.65 mass%. If the surface oxygen content (FSO) is less than 0.15 mass%, the amount of molten phase generated during the sintering process will be lower, thus reducing the densification rate and making it difficult to obtain a high-density sintered body. If the surface oxygen content is more than 0.65 mass%, on the other hand, a high-density sintered body can be obtained but the amount of grain boundary phase in the sintered body increases, not only lowering the strength properties (strength and toughness, etc.) of the resulting sintered body, but also lowering its thermal conductivity. The surface oxygen content (FSO) is more preferably 0.20 mass% to 0.60 mass%, with an optional lower limit of 0.25 mass% or more, or 0.30 mass% or more. The upper limit may be 0.50 mass% or less, or 0.40 mass% or less. For the purpose of this disclosure, the surface oxygen content is the ratio of the mass of oxygen on the surface with respect to the total mass of the silicon nitride powder. The detailed measurement method will be described later.

(Relationship between Specific Surface Area (SA) and Surface Oxygen Content (FSO))

The surface oxygen content of silicon nitride powder suitable for achieving favorable sintered body strength properties (strength and toughness, etc.) and high thermal conductivity also varies depending on its specific surface area.

For example, when the BET specific surface area (SA) is 3.0 $m^2/g$ or higher and lower than 8.0 $m^2/g$, the surface oxygen content (FSO) is preferably 0.15 mass% to 0.40 mass%. The lower limit may be 0.18 mass% or more or 0.23 mass% or more. The upper limit may be 0.35 mass% or less or 0.30 mass% or less. If the surface oxygen content (FSO) is lower than 0.15 mass%, the amount of molten phase generated during the sintering process will be lower, thus reducing the densification rate and making it difficult to obtain a high-density sintered body. If the surface oxygen content is more than 0.40 mass%, on the other hand, not only the strength properties (strength and toughness, etc.) of the resulting sintered body may be lowered, but also its thermal conductivity may be lowered.

When the BET specific surface area (SA) is 8.0 $m^2/g$ to 13.0 $m^2/g$, the surface oxygen content (FSO) is preferably 0.20 mass% to 0.65 mass%. The lower limit may be 0.23 mass% or more or 0.28 mass% or more. The upper limit may be 0.60 mass% or less or 0.55 mass% or less. If the surface oxygen content (FSO) is less than 0.20 mass%, the amount of molten phase generated during the sintering process will be lower, thus reducing the densification rate and making it difficult to obtain a high-density sintered body. If the surface oxygen content is more than 0.65 mass%, on the other hand, not only the strength properties (strength and toughness, etc.) of the resulting sintered body is lowered, but also its thermal conductivity is lowered.

The BET specific surface area (SA) of the silicon nitride powder is preferably selected as appropriate depending on the production conditions of the sintered body using the powder (for example, the type and amount of sintering aid, sintering conditions) and the intended use of the resulting sintered body.

(Adjustment of surface oxygen content (FSO))

For production of silicon nitride powder by imide decomposition method, the surface oxygen content (FSO) can be controlled, for example, by adjusting the components in the firing furnace atmosphere (the oxygen concentration and carbon monoxide concentration), or the components in the atmosphere during the step of milling the fired powder (the oxygen concentration and moisture concentration).

For production of silicon nitride powder by direct nitriding method, the surface oxygen content (FSO) can be controlled, for example, by adjusting the components in the firing furnace atmosphere (the oxygen concentration and carbon monoxide concentration), as well as the pulverizing conditions and the hydrofluoric acid concentration during acid solution treatment of the pulverized powder, for example.

(Internal Oxygen Content (FIO))

The internal oxygen content (FIO) of the silicon nitride powder of an embodiment of the present invention is 0.25 mass% to 1.00 mass%. An internal oxygen content (FIO) of less than 0.25 mass% will undesirably result in abnormal grain growth of β-type columnar crystals, resulting in lower strength properties. In conventional firing methods, the particle size distribution of the fired powder is not stable under conditions with an internal oxygen content (FIO) of less than 0.25 mass%, making it difficult to stably produce crystalline silicon nitride powder with a BET specific surface area of 3.0 $m^2/g$ or higher, and thus stronger pulverizing in subsequent steps may be applied. For the purpose of this disclosure, the internal oxygen content is the ratio of the mass of oxygen inside with respect to the total mass of the silicon nitride powder. The detailed measurement method will be described later.

When the internal oxygen content (FIO) is more than 1.00 mass%, on the other hand, the composition of the grain boundary phase is changed when the silicon nitride particles dissolve at the grain boundary phase containing the sintering aid during the silicon nitride sintering process, interfering with precipitation and growth of β-type columnar crystals, so it would be difficult to expect to exhibit sufficient sintered body properties (especially high-temperature strength). The thermal conductivity of the sintered body is also lowered. The internal oxygen content is more preferably 0.35 mass% to 0.95 mass%, with an optional lower limit of 0.45 mass% or more, 0.55 mass% or more or 0.65 mass% or more, for example. The upper limit may be 0.90 mass% or less, 0.85 mass% or less or 0.80 mass% or less.

The internal oxygen content (FIO) of silicon nitride powder suitable for achieving favorable sintered body strength properties (strength and toughness, etc.) and high thermal conductivity also varies depending on its specific surface area.

For example, when the BET specific surface area (SA) is 3.0 $m^2/g$ or higher and lower than 8.0 $m^2/g$, the internal oxygen content (FIO) is preferably 0.25 mass% to 0.90 mass%. The lower limit may be 0.35 mass% or more or 0.45 mass% or more. The upper limit may be 0.80 mass% or less, or 0.70 mass% or less.

When the BET specific surface area (SA) is 8.0 $m^2/g$ to 13.0 $m^2/g$, the internal oxygen content (FIO) is preferably 0.50 mass% to 1.00 mass%. The lower limit may be 0.60 mass% or more or 0.70 mass% or more. The upper limit may be 0.95 mass% or less or 0.90 mass% or less. When the internal oxygen content (FIO) is less than 0.50 mass%, the densification rate in the latter stage of the sintering process decreases, and the achieved density (relative density) of the sintered body tends to decrease. If the internal oxygen content is more than 1.00 mass%, on the other hand, not only the strength properties (strength and toughness, etc.) of the resulting sintered body is lowered, but also its thermal conductivity is lowered.

(Ratio of Surface Oxygen Content (FSO) to BET Specific Surface Area (SA), FSO/SA)

Since the densification rate of the molded body containing the silicon nitride powder and sintering aid varies depending on the specific surface area of the silicon nitride powder used as the starting material, the preferred value for the surface oxygen content (FSO) of the silicon nitride powder of an embodiment of the present invention will differ depending on the specific surface area (SA). According to an embodiment of the present invention, assuming $\% \times g = g/100 = 10$ mg, the units for the ratio of surface oxygen content (FSO) to BET specific surface area (SA), FSO/SA, are $mg/m^2$ (where the numerator m means $10^{-3}$ and the denominator m means meters), and therefore $\%/m^2g^{-1} = 10$ $mg/m^2$. When the BET specific surface area (SA) is 3.0 $m^2/g$ to 13.0 $m^2/g$, the range for the ratio of surface oxygen content (FSO) to BET specific surface area (SA), FSO/SA, is 0.23 $mg/m^2$ or more and less than 0.50 $mg/m^2$ (which may also be represented as: 0.023$\%/m^2g^{-1}$ or more and less than 0.050$\%/m^2g^{-1}$). When the FSO/SA ratio is within this range, the densification rate will be increased and grain growth during sintering will be appropriate, to yield a high-density silicon nitride sintered body composed of β-type columnar crystals with the desired long axis diameter and aspect ratio, and having a lower percentage of grain boundary phase. Consequently, it satisfies both high-level strength properties (strength, toughness, etc.) and thermal conductivity.

If the FSO/SA ratio is less than 0.23 $mg/m^2$, the amount of molten phase generated by reaction with the sintering aid will be low, making it difficult to sufficiently cover the silicon nitride particles with the molten phase, and thus lowering the densification rate and making it difficult to obtain a high-density sintered body. If the FSO/SA ratio is 0.50 $mg/m^2$ or more, an excessive amount of molten phase will be generated, with more grain boundary phase, which will not only lower the strength properties (strength and toughness, etc.) of the sintered body but will also result in lower thermal conductivity. The FSO/SA ratio is more preferably 0.25 $mg/m^2$ to 0.47 $mg/m^2$, optionally with a lower limit of 0.27 $mg/m^2$ or more, 0.30 $mg/m^2$ or more or 0.33 $mg/m^2$ or more, for example. The upper limit may be 0.45 $mg/m^2$ or less, 0.43 $mg/m^2$ or less or 0.41 $mg/m^2$ or less, for example.

(Adjustment of FSO/SA Ratio)

For production of silicon nitride powder by imide decomposition method, the FSO/SA ratio can be controlled, for example, by adjusting the components in the atmosphere (oxygen concentration and moisture concentration) during the milling step of the fired powder, and in addition, it is also influenced by the components in the firing furnace atmosphere (oxygen concentration and carbon monoxide concentration).

For production of silicon nitride powder by the direct nitriding method, the FSO/SA ratio can be controlled, for example, by adjusting the acid solution treatment conditions (such as the hydrofluoric acid concentration) during production, and in addition, it is influenced by, for example, the components in the firing furnace atmosphere (oxygen concentration and carbon monoxide concentration) and the milling conditions.

(Ratio of Internal Oxygen Content (FIO) to BET Specific Surface Area (SA), FIO/SA)

Since the latter stage process of densification of the molded body containing the silicon nitride powder and sintering aid is governed mainly by the ratio (FIO/SA) between the internal oxygen content (FIO) and the BET specific surface area (SA), the preferred value for the internal oxygen content (FIO) of the silicon nitride powder of an embodiment of the present invention will differ depending on the specific surface area (SA). Specifically, the ratio (FIO/SA) between the internal oxygen content (FIO) and the BET specific surface area (SA) is preferably 0.60 $mg/m^2$ to 1.30 $mg/m^2$ (which may also be represented as 0.060$\%/m^2g^{-1}$ to 0.130$\%/m^2g^{-1}$). When the FIO/SA ratio is within this range, it will be possible to reduce abnormal grain growth during sintering, and increase the homogeneity of the sintered body structure composed of β-type columnar crystals. Moreover since a high-density silicon nitride sintered body with an appropriately controlled composition and abundance ratio grain boundary phase will be obtained, it becomes possible to produce sintered body parts with increased oxidation resistance and high-temperature strength, as well as excellent thermal conductivity.

When the FIO/SA ratio is 0.60 $mg/m^2$ or more, abnormal grain growth of the β-type columnar crystals will be less likely to occur, with less risk of reduced strength properties and with satisfactory oxidation resistance of the obtained sintered body, which is preferred for use in high-temperature mechanical parts, for example.

When the FIO/SA ratio is 1.30 $mg/m^2$ or less, on the other hand, the composition of the grain boundary phase is stable when the silicon nitride particles dissolve at the grain boundary phase containing the sintering aid during the silicon nitride sintering process, thus helping to avoid inhibiting precipitation and growth of β-type columnar crystals, so that sufficient sintered body properties, and especially fracture toughness may be expected. The high-temperature strength and thermal conductivity will be satisfactory as well. The FIO/SA ratio is more preferably 0.63 mg/m$^2$ to 1.20 mg/m$^2$, optionally with a lower limit of 0.65 mg/m$^2$ or more, 0.70 mg/m$^2$ or more or 0.74 mg/m$^2$ or more, for example. The upper limit may be 1.10 mg/m$^2$ or less, 1.00 mg/m$^2$ or less or 0.90 mg/m$^2$ or less, for example.

(Total Oxygen Content (TO))

When the BET specific surface area (SA) is 3.0 m$^2$/g to 13.0 m$^2$/g, the total oxygen content (TO) is preferably 0.50 mass% to 1.60 mass%. When the total oxygen content is 0.50 mass% or more, the amount of molten phase generated during the sintering process will be sufficient, thus increasing the densification rate and allowing a high-density sintered body to be obtained. When the total oxygen content (TO) is 1.60 mass% or less, on the other hand, it will be possible to obtain a densified sintered body, while the oxygen content of the sintered body will not be excessive and the amount of grain boundary phase will not overly increase, thus resulting in satisfactory strength properties (such as room-temperature strength, high-temperature strength and fracture toughness). The thermal conductivity of the sintered body will also be high. The total oxygen content (TO) is more preferably 0.60 mass% to 1.50 mass%. For the purpose of this disclosure, the total oxygen content refers is the ratio of the total mass of oxygen with respect to the total mass of the silicon nitride powder. The detailed measurement method will be described later.

(Halogen Content)

In an embodiment of the present invention, the halogen content means the total content of fluorine content and chlorine content. The halogen content of the silicon nitride powder of an embodiment of the present invention is preferably 130 ppm or less, and is particularly preferably 10 ppm to 130 ppm. A halogen content within this range will facilitate densification during sintering, and will also result in satisfactory strength properties such as high-temperature strength. Confirming a halogen content of less than 10 ppm is difficult by analysis methods in terms of detection sensitivity. When the halogen content is 130 ppm or less, it will be possible to limit the increase in the proportion of halogens in the grain boundary phase of the obtained silicon nitride sintered body. This prevents the softening of the grain boundary phase under high temperature, and avoids reduction in the high-temperature strength. Furthermore, it also prevents deterioration in high temperature creep properties. The halogens in the silicon nitride powder are mainly fluorine and chlorine, the total content of the fluorine content and chlorine content preferably being 10 ppm to 130 ppm. The upper limit for the total content of the fluorine content and chlorine content may be 120 ppm or less, 100 ppm or less, or 90 ppm or less, for example. The lower limit may be 20 ppm or more, 25 ppm or more or 30 ppm or more, for example.

(Fluorine Content)

The total fluorine content of the silicon nitride powder of an embodiment of the present invention is preferably less than 120 ppm, and is particularly preferably 5 ppm to 120 ppm. A total fluorine content within this range will facilitate densification during sintering, and will also result in satisfactory strength properties such as high-temperature strength. Confirming a total fluorine content of less than 5 ppm is difficult by analysis methods, in terms of detection sensitivity. When the total fluorine content is less than 120 ppm, it will be possible to limit increase in the proportion of fluorine in the grain boundary phase of the obtained silicon nitride sintered body, prevent softening of the grain boundary phase under high temperature, and avoid reduction in the high-temperature strength. Furthermore, it also prevents deterioration in high temperature creep properties. The total fluorine content is preferably 5 ppm to 100 ppm, with a lower limit of 10 ppm or more, 20 ppm or more or 30 ppm or more, for example. The upper limit may be 90 ppm or less, 80 ppm or less or 70 ppm or less, for example.

Since the impurity fluorine in silicon nitride powder influences the high-temperature strength of the resulting sintered body, a silicon nitride powder with a low fluorine content has conventionally been desired; however, the influence of the combination of fluorine content and other powder properties has not been clarified. In an embodiment of the present invention, it has been found that not the fluorine content alone, but the combination of the halogen content or fluorine content with the thickness of the amorphous film on the particle surface and the coefficient of variation thereof, influences the thermal and mechanical properties of the resulting sintered body.

Fluorine is present mainly on the particle surfaces of the silicon nitride powder. The surface fluorine content of the silicon nitride powder is preferably 5 ppm to 110 ppm. A surface fluorine content within this range will facilitate densification during sintering, and will also result in satisfactory strength properties such as high-temperature strength. Confirming a surface fluorine content of less than 5 ppm is difficult by analysis methods, in terms of detection sensitivity. When the surface fluorine content is 110 ppm or less, it will be possible to avoid reduction in the high-temperature strength of the silicon nitride sintered body, similar to when the total fluorine content is less than 120 ppm. Furthermore, it is also possible to prevent the deterioration of creep properties at high temperatures.

The surface fluorine content is preferably 5 ppm to 110 ppm, with a lower limit of 15 ppm or more or 25 ppm or more, for example. The upper limit may be 90 ppm or less or 70 ppm or less, for example. The ratio of the surface fluorine content to the total fluorine content is preferably 0.7 or higher and more preferably 0.8 or higher.

For production of silicon nitride powder by imide decomposition method, it is not necessary to carry out acid solution treatment of the fired powder, which facilitates obtaining a total fluorine content of less than 120 ppm. Since pulverizing is basically necessary in a direct nitriding method for micronization, it is necessary to carry out acid solution treatment to reduce the impurities produced by pulverizing. Chemical components used in acid solution treatment remain, as a result, increasing the content of impurities such as fluorine. This has led to attempts to lower the fluorine content of silicon nitride powder, with dependence on post-treatment (washing, etc.) after firing.

(Chlorine Content)

The total chlorine content of the silicon nitride powder of an embodiment of the present invention is preferably 110 ppm or less, and is particularly preferably 5 ppm to 110 ppm. A total chlorine content within this range will facilitate densification during sintering, and will also result in satisfactory strength properties such as high-temperature strength. Confirming a total chlorine content of less than 5 ppm is difficult by analysis methods, in terms of detection sensitivity. When the total chlorine content is 110 ppm or less, it will be possible to avoid excessive increase in the proportion of chlorine in the grain boundary phase of the obtained silicon nitride sintered body, helping to prevent softening of the grain boundary phase under high temperature and reduction in the high-temperature strength. Furthermore, it is also possible to prevent the deterioration of creep properties at high temperatures. The total chlorine content is preferably 10 ppm to 100 ppm, with a lower limit of 20 ppm or more or 30 ppm or more, for example. The upper limit may be 90 ppm or less or 80 ppm or less, for example.

Chlorine is present mainly on the particle surfaces of the silicon nitride powder. The surface chlorine content of the silicon nitride powder is preferably 100 ppm or less, and is particularly preferably 5 ppm to 100 ppm. A surface chlorine content within this range will facilitate densification during sintering, and will also result in satisfactory strength properties such as high-temperature strength. Confirming a surface chlorine content of less than 5 ppm is difficult by analysis methods, in terms of detection sensitivity. When the surface chlorine content is 100 ppm or less it will be possible to avoid reduction in the high-temperature strength of the silicon nitride sintered body, similar to when the total chlorine content is 110 ppm or less. Furthermore, it is also possible to prevent the deterioration of creep properties at high temperatures.

(Adjustment of Halogen Content)

Since production of silicon nitride powder by imide decomposition method uses a silicon halide as the starting material, ammonium halides such as ammonium chloride generated as by-products during the imide synthesis reaction must be thoroughly washed out and removed with liquid ammonia, to lower the halogen content of nitrogen-containing silane compounds such as silicon diimide to 250 ppm or less and preferably 180 ppm or less. Alternatively, a large amount of ammonia gas is supplied during pyrolysis of the generated imide to significantly lower the hydrogen halide concentration (for example, the hydrochloric acid concentration) in the atmosphere.

Since pulverizing is basically necessary in a direct nitriding method for micronization, it is necessary to carry out acid solution treatment to reduce the impurities produced by pulverizing. This results in residue of chemical components used in acid solution treatment, thereby increasing the content of impurities such as chlorine. Similar to the fluorine content, therefore, the chlorine content is also carefully managed by post-treatment (washing, etc.) after firing, for example.

(Method of Measuring Total Fluorine Content and Surface Fluorine Content)

The total fluorine content of silicon nitride powder can be determined by using an ion chromatograph to quantify the content of fluorine desorbed by combustion of the silicon nitride powder in oxygen and a water vapor stream, according to JIS R 1603: 2007, "Chemical analysis method for silicon nitride fine powder for fine ceramics". The surface fluorine content can be determined by first boiling water obtained by dispersing silicon nitride powder in water to extract the fluorine on the silicon nitride powder surfaces into the water, and then quantifying the extracted fluorine using ion chromatography. The internal fluorine content is determined by subtracting the surface fluorine content from the total fluorine content. For the purpose of this disclosure, the total fluorine content is the ratio of the total mass of fluorine with respect to the total mass of the silicon nitride powder. The surface fluorine content is the ratio of the mass of surface fluorine with respect to the total mass of the silicon nitride powder. The internal fluorine content is the ratio of the mass of internal fluorine with respect to the total mass of the silicon nitride powder.

(Method of Measuring Total Chlorine Content and Surface Chlorine Content)

The total chlorine content of silicon nitride powder can likewise be determined by using an ion chromatograph to quantify the content of chlorine desorbed by combustion of the silicon nitride powder in oxygen and a water vapor stream, according to JIS R 1603: 2007, "Chemical analysis method for silicon nitride fine powder for fine ceramics". The surface chlorine content can be determined by first boiling water obtained by dispersing silicon nitride powder in water to extract the chlorine on the silicon nitride powder surfaces into the water, and then quantifying the extracted chlorine using ion chromatography. The total chlorine content is the ratio of the total mass of chlorine with respect to the total mass of the silicon nitride powder, and for the purpose of this disclosure the total chlorine content is referred to as the "chlorine content".

(Carbon Content)

The silicon nitride powder of an embodiment of the present invention preferably has a carbon content of 0.01 mass% to 0.14 mass% with respect to the total mass of the silicon nitride powder. During the process of temperature increase, the silicon oxide layer and silicon oxynitride layer on the silicon nitride particle surfaces is reduced by carbon, and a carbon content of 0.14 mass% or less is therefore preferred because it can ensure the molten phase amount generated at high temperature, increase the densification rate, and help obtain a high-density sintered body. The carbon content is more preferably 0.01 mass% to 0.10 mass%.

(Mass Ratio of $\beta$ Phase with respect to Total Content of $\alpha$ Phase and $\beta$ Phase, $\beta/(\alpha + \beta)$)

In the silicon nitride powder of an embodiment of the present invention, the mass ratio of the $\beta$-phase with respect to the total content of the $\alpha$ phase and $\beta$ phase, $\beta/(\alpha+\beta)$ (sometimes referred to as the $\beta$ fraction), is preferably 1.3 mass% to 14.0 mass%. A $\beta/(\alpha + \beta)$ ratio of 14.0 mass% or less can prevent increase in the short axis diameter of the $\beta$-type columnar crystals composing the sintered body and can increase the aspect ratio (long axis diameter/short axis diameter ratio), allowing satisfactory strength properties to be obtained. In particular, it can prevent the fracture toughness from being notably lowered. The $\beta/(\alpha + \beta)$ ratio is more preferably 3.0 mass% to 12.0 mass% and even more preferably 4.0 mass% to 8.0 mass%. A $\beta/(\alpha + \beta)$ ratio of less than 1.3 mass% is not preferred because abnormal grain growth will proceed during sintering and the sintered body structure composed of the $\beta$-type columnar crystals will become heterogeneous.

(Particle Size Distribution)

For the silicon nitride powder of an embodiment of the present invention, preferably the cumulative 10% diameter $D_{10}$ is 0.22 $\mu$m to 0.50 $\mu$m, the cumulative 90% diameter $D_{90}$ is 1.90 $\mu$m to 2.40 $\mu$m and the difference [$D_{90} - D_{10}$] is 1.60 $\mu$m to 2.00 $\mu$m, in the volume-based cumulative particle size distribution. When the volume-based cumulative particle size distribution is within this range, the filling property of the silicon nitride powder will be satisfactory with virtually no molding defects, allowing a homogeneous silicon nitride molded body to be obtained.

(Cumulative 10% Diameter $D_{10}$)

When the cumulative 10% diameter $D_{10}$ is 0.22 $\mu$m or more, the proportion of microparticles will not be too great, helping to ensure a suitable green density when molding by conventional molding methods, and helping to prevent generation of microcracks or voids after sintering. This is also preferred as it will avoid producing an adverse effect on dimensional precision, and can inhibit formation of chippings or damages (cluster of cracks) at the corner sections of sintered bodies during sintering of complex shapes. When the cumulative 10% diameter $D_{10}$ is 0.50 $\mu$m or less, the proportion of microparticles will increase, creating a driving force for sintering so that a high-density silicon nitride sintered body can be obtained even without addition of large amounts of sintering aid. Addition of a sintering aid in large amounts can potentially impair the properties of the silicon nitride sintered body. The upper limit for the cumulative 10% diameter $D_{10}$ is 0.48 $\mu$m or less, 0.46 $\mu$m or less or 0.44 $\mu$m or less, for example. The lower limit for the cumulative 10% diameter $D_{10}$ is 0.25 $\mu$m or more, 0.29 $\mu$m or more or 0.32 $\mu$m or more, for example.

(Cumulative 90% Diameter $D_{90}$)

The cumulative 90% diameter $D_{90}$ in the volume-based cumulative particle size distribution is preferably 1.90 $\mu$m to 2.40 $\mu$m. When the cumulative 90% diameter $D_{90}$ is 1.90 $\mu$m or more, the particle size distribution will not be too sharp, allowing a suitable green density to be ensured by conventional molding methods. Sintering in this case will yield a sintered body with a fine microstructure, but the individual silicon nitride grains will not be too fine, tending to result in satisfactory fracture toughness. The high-temperature strength will also be high. When the cumulative 90% diameter $D_{90}$ is 2.40 $\mu$m or

less, the proportion of coarse particles will be lower, which not only prevents further growth to coarse grains during sintering but also helps prevent generation of microcracks or voids around the coarse grains, which can become sources of the fracture generation. The upper limit for the cumulative 90% diameter $D_{90}$ is 2.35 $\mu$m or less, 2.25 $\mu$m or less or 2.15 $\mu$m or less, for example. The lower limit for the cumulative 90% diameter $D_{90}$ is 1.95 $\mu$m or more, 2.00 $\mu$m or more or 2.05 $\mu$m or more, for example.

(Difference between Particle Sizes [$D_{90}$ - $D_{10}$])

Thus, the cumulative 90% diameter $D_{90}$ and cumulative 10% diameter $D_{10}$ in the volume-based cumulative particle size distribution can be adjusted within the above-mentioned range, and it is preferable that the difference [$D_{90}$ - $D_{10}$] be 1.60 $\mu$m to 2.00 $\mu$m. When [$D_{90}$ - $D_{10}$] is 1.60 $\mu$m or more, the particle size distribution does not become excessively sharp, and the green density can be ensured by conventional forming methods. When [$D_{90}$ - $D_{10}$] is 2.00 $\mu$m or less, the particle size distribution is not excessively broad, and a uniform sintered microstructure can be obtained. Specifically, this can prevent growth of coarse grains during sintering and generation of microcracks or voids around the coarse grains, which can become sources of the fracture generation. [$D_{90}$ - $D_{10}$] may be, for example, 1.65 $\mu$m to 1.95 $\mu$m or 1.70 $\mu$m to 1.90 $\mu$m.

The cumulative 10% diameter $D_{10}$ and cumulative 90% diameter $D_{90}$ in the volume-based cumulative particle size distribution of an embodiment of the present invention mean the respective particle diameters ($D_{10}$ and $D_{90}$) such that the cumulative value in the volume-based cumulative particle size distribution is 10% or 90%, when the particle size distribution is measured by laser diffraction/scattering method. Laser diffraction/scattering method is measured according to the method described in JIS Z 8825: 2013, "Particle size analysis-laser diffraction/scattering method ".

<<Method for Producing Silicon Nitride Powder>> <<Imide Decomposition Method >>

There are no particular restrictions on the method for producing the silicon nitride powder of an embodiment of the present invention. In imide decomposition method, for example, an amorphous Si-N(-H)-based compound is fired to produce crystalline silicon nitride powder. The method may be a publicly known method, such as a method of reacting a silicon halide with ammonia, and specifically a method of reacting a silicon halide such as silicon tetrafluoride, silicon tetrachloride, silicon tetrabromide or silicon tetraiodide with ammonia in a gas phase, or a method of reacting liquid silicon halide with liquid ammonia, to produce a nitrogen-containing silane compound such as silicon diimide, silicon tetraamide or silicon chlorimide.

<Nitrogen-containing Silane Compound as Starting Material>

(Amorphous Si-N(-H)-based Compounds)

These nitrogen-containing silane compounds are represented by the following compositional formula (I).
[Formula 1]

$$Si_6(NH)_n(NH_2)_{24-2n} \cdots \qquad (I)$$

(where n = 0 to 12, including compounds containing halogens as impurities which are not represented by the compositional formula)

The amount of halogens present as impurities may be 0.05 mass% or less, and is preferably 0.02 mass% or less. According to an embodiment of the present invention, a nitrogen-containing silane compound where n = 8 to 12 will be referred to as a silicon diimide for convenience.

An amorphous Si-N(-H)-based compound is produced by a publicly known method, such as a method comprising the step of heating and decomposing the obtained nitrogen-containing silane compound in a nitrogen or ammonia gas atmosphere at a temperature of 1100°C or lower, or a method comprising the step of reacting a silicon halide such as silicon tetrafluoride, silicon tetrachloride, silicon tetrabromide or silicon tetraiodide with ammonia at high temperatures.

The amorphous Si-N(-H)-based compound to be used for an embodiment of the present invention is an amorphous Si-N-H-based compound containing the elements Si, N and H or an amorphous silicon nitride containing Si and N obtained by thermally decomposing some or all of the aforementioned nitrogen-containing silane compound, and it is represented by the following compositional formula (II). According to an embodiment of the present invention, the amorphous Si-N(-H)-based compound includes all of the series of compounds of compositional formula (II) from $Si_6N_2(NH)_9$ where x = 1 to amorphous $Si_3N_4$ where x = 4, with "$Si_6N_6(NH)_3$ where x = 3" being referred to as silicon nitrogen imide.
[Formula 2]

$$Si_6N_{2x}(NH)_{12-3x} \cdots \qquad (II)$$

(where x = 0 to 4, including compounds containing halogens as impurities which are not represented by the compositional formula)

The value of x is preferably 1.30 to 3.60, and more preferably 1.65 to 3.10.

In compositional formula (II), $Si_6(NH)_{12}$ where x = 0 is silicon diimide, this silicon diimide being a nitrogen-containing silane compound and not included in the definition of the amorphous Si-N(-H)-based compound of an embodiment of the present invention.

(Halogen Content)

The amount of halogens, such as chlorine, contained as impurities in the amorphous Si-N(-H) compound is preferably 0.020 mass% (200 ppm) or less, and more preferably 0.012 mass% (120 ppm) or less. The halogen content can be controlled by the volume of washing liquid ammonia per kilogram of imide produced. The ratio of the volume of washing liquid ammonia/amount of imide (the volume of liquid ammonia for washing per 1 kg of silicon diimide produced) is 50 litres/kg to 300 litres/kg, for example, and is more preferably 60 litres/kg to 250 litres/kg.

(Carbon Content)

The amount of carbon present as impurity in the silicon nitride powder depends on the content of hydrocarbons such as toluene in the nitrogen-containing silane compound. For example, when the nitrogen-containing silane compound is silicon diimide, the toluene content of the silicon diimide may be controlled to 0.01 mass% to 0.40 mass% so as to obtain a silicon nitride powder with carbon content of 0.01 mass% to 0.14 mass% after high-temperature firing. The toluene content of the silicon diimide is more preferably 0.01 mass% to 0.30 mass%.

(Specific Surface Area)

The specific surface area of the amorphous Si-N(-H)-based compound as the intermediate raw material for producing silicon nitride powder according to an embodiment of the present invention, is preferably 300 $m^2$/g to 680 $m^2$/g. When the specific surface area is 300 $m^2$/g or higher, it prevents rapid crystallization in the temperature range of 1000 to 1400°C, and suppresses the formation of needle-like particles or aggregated particles. Sintered body fabricated from such powder exhibits a homogeneous microstructure, resulting in excellent strength and thermal conductivity. When the specific surface area is 680 $m^2$/g or lower, on the other hand, the degree of supersaturation near the particles increases during crystallization, leading to a high number of nucleation sites and thus avoiding the lowering of the specific surface area of the crystalline silicon nitride powder. This results in good sinterability and excellent strength and thermal conductivity of the sintered body. The specific surface area of the amorphous Si-N(-H)-based compound is preferably 340 $m^2$/g to 610 $m^2$/g, and is more preferably 360 $m^2$/g to 570 $m^2$/g.

The specific surface area of the amorphous Si-N(-H)-based compound can be adjusted by changing the maximum temperature used for thermolysis of the nitrogen-containing silane compound used as the starting material. A lower maximum temperature during the thermolysis can increase the specific surface area of the amorphous SiN(-H)-based compound. When the nitrogen-containing silane compound is silicon diimide, the maximum temperature for pyrolysis may be 400°C to 1000°C, for example, and is preferably 550°C to 950°C.

(Oxygen Content Percentage)

The oxygen content percentage of the amorphous SiN(-H)-based compound can be controlled by adjusting the oxygen content in the nitrogen-containing silane compound and the oxygen partial pressure (oxygen concentration) in the atmosphere during thermolysis of the nitrogen-containing silane compound. Reducing the oxygen content of the nitrogen-containing silane compound and/or lowering the oxygen partial pressure in the atmosphere during the thermolysis can lower the oxygen content percentage of the amorphous Si-N(-H)-based compound. The oxygen concentration in the inert gas supplied to the thermolysis furnace may be, for example, 60 ppm (Volume/Volume) (hereinafter, ppm (Volume/Volume) is sometimes referred to as ppm (V)) to 1000 ppm (V), and more preferably 100 ppm (V) to 600 ppm (V). The oxygen content of the amorphous Si-N(-H)-based compound may be 0.36 mass% to 1.20 mass%, for example, and is preferably 0.55 mass% to 1.10 mass% and more preferably 0.62 mass% to 1.00 mass%.

When the oxygen content of the amorphous Si-N(-H)-based compound is 0.36 mass% or more, the degree of supersaturation near the particles increases during crystallization, leading to a higher nucleation rate. Consequently, the crystalline silicon nitride powder exhibits a satisfactory specific surface area. It is preferable for the oxygen content of the amorphous SiN(H) compound to be 1.20 mass % or less, as this inhibits the increase in the internal oxygen content (FIO) of the resulting crystalline silicon nitride powder.

<Firing and Crystallization of Amorphous Si-N(-H)-based Compound>

According to an embodiment of the present invention, the amorphous Si-N(-H)-based compound is fired under a nitrogen-containing inert gas atmosphere or under a nitrogen-containing reducing gas atmosphere, preferably at a temperature of 1400 to 1600°C, for conversion to crystalline silicon nitride powder. The firing furnace used for heating the amorphous Si-N(-H)-based compound may be a common firing furnace such as a batch electric furnace or pusher electric furnace.

The pusher furnace is a firing furnace provided with a furnace chamber that can control the temperature and atmosphere conditions while carrying out firing of a ceramic starting material as the substance to be fired, by successively pushing in and conveying a plurality of base plates, onto each of which has been loaded a crucible housing the substance to be fired, into the furnace using a pusher mechanism.

(Nitrogen-containing Inert Gas Atmosphere)

The nitrogen-containing inert gas atmosphere is a nitrogen atmosphere, or an inert gas atmosphere containing nitrogen and a rare gas such as argon. In order to obtain a fired powder with a low oxygen content the atmosphere preferably contains absolutely no oxygen, but if it does contain oxygen, the oxygen concentration may be 100 ppm (V) or lower, and preferably 70 ppm (V) or lower. The nitrogen-containing reducing gas atmosphere is an atmosphere containing an inert gas such as nitrogen and a reducing gas such as hydrogen or ammonia.

(Carbon Monoxide (CO) Concentration within the Furnace)

In the crystallization and firing step, the carbon monoxide (CO) concentration in the furnace tends to increase due to volatilization of adsorbed water from the heat-insulating material component of the firing furnace. CO concentration in the furnace is preferably from 60 ppm (V) to 240 ppm (V), for example. The CO concentration in the furnace is preferably 240 ppm (V) or lower to limit increase in the internal oxygen content and total oxygen content of the obtained silicon nitride powder. When the CO concentration in the furnace is 60 ppm (V) or higher, there will be no need to supply a large amount of nitrogen-containing inert gas for dilution of the generated CO gas, thus helping to avoid cost increase. The CO concentration in the furnace may be 120 ppm (V) to 190 ppm (V). The CO concentration in the furnace also influences the surface oxygen content derived from the silicon oxynitride layer on the particle surfaces.

(Firing Temperature and Heating Rate)

The specific surface area of the crystalline silicon nitride powder is influenced by the specific surface area of the amorphous Si-N(-H)-based compound, and by the heating rate and maximum holding temperature during its firing. The heating rate is therefore preferably set to 40°C/h to 95°C/h, and the maximum holding temperature to 1470°C to 1600°C, for example. Moreover since the $\beta/(\alpha + \beta)$ ratio in the crystal phase is also influenced by the heating rate and maximum holding temperature, more preferably the heating rate is 45°C/h to 90°C/h and the maximum holding temperature is 1480°C to 1570°C. The holding time at the maximum temperature may be 1 hour to 5 hours, for example.

<Deagglomeration Treatment>

The obtained crystalline silicon nitride powder is subjected to Deagglomeration treatment under an oxygen-containing inert gas atmosphere (such as an air stream), to adjust the surface oxygen content (FSO) and the ratio of the surface oxygen content (FSO) to the BET specific surface area (SA), FSO/SA. Deagglomeration may be carried out by milling using a common pulverizing apparatus such as a bead mill, vibration mill, planetary ball mill or jet mill. The surface oxygen content of the silicon nitride powder is influenced by the moisture concentration in the gas supplied to the milling vessel. The moisture concentration is adjusted to 40 ppm (V) to 750 ppm (V), for example, and is more preferably 90 ppm (V) to 650 ppm (V). The moisture concentration particularly influences the surface oxygen content derived from the silicon oxide layer on the particle surfaces.

<Adjustment of Particle Size Distribution>

The particle size distribution of the crystalline silicon nitride powder is adjusted by the post-milling treatment conditions. For example, when using a continuous vibration mill, the pulverizing ball diameter, the ball filling amount, the powder filling amount, the mill amplitude and the milling time are comprehensively adjusted to vary the particle size distribution. For example, a pulverizing ball diameter is 15 mm$\varphi$, and a ball space fill factor is 85%. For fine pulverzing, the pulverizing ball diameter is reduced, the ball space fill factor is increased, and the powder filling amount is decreased. In order to obtain the desired cumulative 90% diameter ($D_{90}$) and cumulative 10% diameter ($D_{10}$), the mill amplitude may be adjusted to 6.5 mm to 8.3 mm and the milling time to 25 minutes to 80 minutes, for example. More preferably, the mill amplitude is set to 7.0 mm to 8.1 mm and the milling time to 35 minutes to 70 minutes.

<Adjustment of Thickness of Amorphous Film on Surface of Primary Particles>

The average value of the thickness of the amorphous film present on the surface of the primary particles of the crystalline silicon nitride powder and the coefficient of variation thereof are mainly adjusted by the post-milling treatment conditions. For example, it can be controlled by adjusting the components in the atmosphere in the post-milling treatment (oxygen concentration and moisture concentration), the milling conditions (mill amplitude and treatment time), or the like. In order to reduce the coefficient of variation of the thickness, comprehensive condition setting is carried out by setting the mill amplitude, the moisture concentration, and the like somewhat lower, by making the treatment time somewhat longer, or the like. It is preferable to set the conditions with attention to the fact that the thickness of the amorphous film is also influenced by the components in the firing furnace atmosphere (oxygen concentration and carbon monoxide concentration).

<<Direct Nitriding Method>>

For production of silicon nitride powder by direct nitriding method in which metal silicon powder is heated in a nitrogen-containing non-oxidizing gas atmosphere, the desired silicon nitride powder can be obtained by controlling the average particle diameter and oxygen content of the metal silicon powder used as the raw material, as well as the moisture content of the atmosphere. Specifically, when using metal silicon powder having an appropriately adjusted average particle diameter and oxygen content as the raw material, it is preferably subjected to nitriding in nitrogen gas with a moisture concentration of 1000 ppm or lower or a nitrogen-containing non-oxidizing gas atmosphere, and pulverized, to obtain silicon nitride powder having the specific surface area and oxygen content (total oxygen content, surface oxygen content and internal oxygen content) specified above.

<Metal Silicon Powder as Raw Material>

(Cumulative 50% diameter $D_{50}$ (average particle diameter))

The metal silicon powder used as the starting raw material may be metal silicon powder having a cumulative 50% diameter $D_{50}$ (average particle diameter) of 5.0 $\mu$m or less in the volume-based cumulative particle size distribution, and preferably the average particle diameter is 0.7 $\mu$m to 5.0 $\mu$m. When the average particle diameter of the metal silicon powder is 0.7 $\mu$m or more it will be possible to reduce the internal oxygen content of the silicon nitride powder obtained by nitriding and pulverizing. When the average particle diameter of the metal silicon powder is 5.0 $\mu$m or less, the nitriding reaction time will be shortened, resulting in superior productivity. Residue of unreacted silicon can also be prevented. The average particle diameter of the metal silicon powder is more preferably 1.0 $\mu$m to 3.0 $\mu$m.

(Oxygen Content)

The oxygen content of the metal silicon powder can be adjusted by changing the pulverizing and pre-treatment conditions. As an example, the oxygen content of metal silicon powder with an average particle diameter of 3 $\mu$m is 0.50 mass%, the oxygen content of metal silicon powder with an average particle diameter of 6 $\mu$m is 0.30 mass%, and the oxygen content of metal silicon powder with an average particle diameter of 10 $\mu$m is 0.20 mass%. Since the oxygen content of the metal silicon powder influences the internal oxygen content of the obtained crystalline silicon nitride powder, the oxygen content of the metal silicon powder used for production of the silicon nitride powder of an embodiment of the present invention may be 0.40 mass% to 1.00 mass%, for example. The oxygen content is more preferably 0.50 mass% to 0.90 mass%.

(Additive)

The firing raw material is prepared by adding a dilution material, a nitriding accelerator and an organic binder for molding to the metal silicon powder. The dilution material used is crystalline silicon nitride powder with an average particle diameter of about 0.7 $\mu$m. The nitriding accelerator used is calcium fluoride powder. The organic binder used is polyvinyl alcohol, carboxymethyl cellulose, a waxy emulsion or an acrylic emulsion.

(Dilution Material)

Addition of a dilution material can yield a fired product (nitrided ingot) that is easy to pulverize. The amount of crystalline silicon nitride powder added may be, for example, 2.5 mass% to 20.0 mass% with respect to the total mass of the metal silicon powder, dilution material, and nitriding accelerator. With addition at less than 2.5 mass%, more time will be required for nitriding reaction and the nitrided ingot will be excessively hard, thus undesirably increasing the load during the pulverizing step. Addition at more than 20.0 mass% has little effect on the high-temperature firing conditions or the properties of the fired product, but is undesirable in terms of increased cost.

(Nitriding Accelerator: Calcium Fluoride Powder)

The amount of calcium fluoride powder added may be, for example, 0.01 mass% to 0.10 mass% with respect to the total mass of the metal silicon powder, dilution material, and nitriding accelerator. Addition at more than 0.10 mass% will cause the internal fluorine content of the obtained crystalline silicon nitride powder to increase, which is undesirable. If calcium and fluorine residue in the nitrided ingot is of concern, addition of calcium fluoride may be omitted.

(Organic Binder)

The amount of organic binder added, in the case of polyvinyl alcohol, may be, for example, 0.2 parts by mass to 1.8 parts by mass to 100 parts by mass of the total mass of the metal silicon powder, dilution material, and nitriding accelerator. Addition at more than 1.8 parts by mass will cause the carbon content of the obtained crystalline silicon nitride powder to increase, which is undesirable. If an increased filling amount of the firing raw material into the firing vessel is not necessary, the organic binder does not need to be added.

(Dilution material, nitriding accelerator and organic binder)

The amount of crystalline silicon nitride powder added is preferably 6.0 mass% to 18.0 mass%. The amount of calcium fluoride powder added is preferably 0.02 mass% to 0.08 mass%. The amount of polyvinyl alcohol added is preferably 0.2 parts by mass to 1.6 parts by mass.

<Supply Gas>

Nitrogen or a nitrogen-containing non-oxidizing gas may be used as the supply gas for nitriding the aforementioned starting raw material containing the metal silicon powder. In order to obtain a fired powder with a low oxygen content it is preferred for the supply gas to contain absolutely no oxygen, but if it does contain oxygen, the oxygen concentration may be 120 ppm (V) or lower, and preferably 100 ppm (V) or lower. A preferred lower limit for the oxygen concentration is 15 ppm (V) or higher, or 25 ppm (V) or higher. A nitrogen-containing reducing gas atmosphere is an atmosphere containing nitrogen or a nitrogen-containing inert gas, and a reducing gas such as hydrogen or ammonia. An example of a mixed gas of hydrogen gas and nitrogen gas is a nitrogen gas mixture containing about 0.5 to 15 vol% hydrogen gas, and an example of a mixed gas of ammonia gas and nitrogen gas is a nitrogen gas mixture containing 0.1 vol% to 4.4 vol% ammonia gas. The mixing ratio of ammonia gas is preferably 0.6 vol% to 3.4 vol%. In this case the moisture concentration of the gas atmosphere is preferably 40 ppm to 1000 ppm, as a moisture concentration of 1000 ppm or lower can limit increase in the content of internal oxygen. The moisture concentration is more preferably 100 ppm to 800 ppm. The concentration of components in the furnace atmosphere (moisture, oxygen and carbon monoxide) also influences the surface oxygen content derived from the silicon oxynitride layer on the particle surfaces.

<Nitriding Step; Firing>

(Nitriding Temperature and Duration)

When the firing raw material containing the metal silicon powder is nitrided in a gas atmosphere, the nitriding temperature may be 1150°C to 1565°C or 1200°C to 1555°C, for example. The nitriding duration may be about 15 to 40 hours, but the firing duration including process of temperature increase will be 40 to 70 hours, for example. It is also possible to stabilize the surface state of the obtained crystalline silicon nitride powder by increasing the maximum temperature during high-temperature firing to around 1600°C, while simultaneously serving as a heat treatment of the fired product (Nitrided Ingot).

(Heating Rate)

For production of the silicon nitride powder of an embodiment of the present invention, it is preferred for the nitriding reaction rate to be preliminarily examined, adjusting the heating rate to 3.0°C/h to 10.0°C/h up to a nitriding ratio of 50%. A heating rate of 3.0°C/h or higher up to a nitriding ratio of 50% will shorten the heating duration, which is preferred to avoid cost increase. A heating rate of 10.0°C/h or lower up to a nitriding ratio of 50% is also preferred to avoid increasing the percentage of β-type silicon nitride particles in the fired product (nitrided ingot), and to limit the $\beta/(\alpha + \beta)$ ratio to 40 mass% or less. In the temperature range with a 50% or higher nitriding ratio it is possible to adjust the heating rate to between 10°C/h and 36°C/h, thus increasing the production rate and limiting the nitriding duration to about 15 to 40 hours. When the heating rate at 50% or higher nitriding ratio is 10°C/h or higher, the heating time will be shortened, which is preferred to avoid cost increase. A heating rate at 50% or higher nitriding ratio is 36°C/h or lower is preferred to avoid excessive hardening of the fired product (nitrided ingot) and prevent increase in load during the pulverizing step.
It is more preferred to adjust the heating rate to between 4.5°C/h and 8.8°C/h up to a nitriding ratio of 50%, and to adjust the heating rate to between 15°C/h and 34°C/h at a 50% or higher nitriding ratio.

(Maximum Temperature)

The maximum temperature for high-temperature firing is 1485°C to 1565°C, for example. When the maximum temperature is 1485°C or higher it will be possible to stabilize the quality of the fired product (nitrided ingot), without variation in the degree of pulverizing in the pulverizing step after nitriding is complete, thus allowing the desired particle size distribution (especially the cumulative 10% diameter $D_{10}$ and cumulative 90% diameter $D_{90}$) to be obtained. A maximum temperature of 1565°C or lower is preferred as this will inhibit coagulation of the generated particles, helping to prevent a harder fired product and increased the load during the pulverizing step. This is also preferred to prevent growth of the β-type silicon nitride grains and increase in the $\beta/(\alpha + \beta)$ ratio. In order to obtain a crystalline silicon nitride powder with stable quality and a controlled particle size distribution, the maximum temperature is preferably set to 1505°C to 1555°C.

<Pulverizing>

In the pulverizing step after nitriding is complete, the fired product (nitrided ingot) is preferably pulverized by a method of dry grinding, wet grinding, or the like to adjust the particle size, thus obtaining silicon nitride powder pulverized to an average particle diameter of 1.0 μm or less and more preferably 0.6 to 0.9 μm. The specific surface area of the pulverized silicon nitride powder is 7 to 16 m$^2$/g, for example.
The pulverization time may be 1.0 hour to 10 hours, for example, but the necessary pulverization time will differ depending on the type of pulverizing apparatus. The pulverizing conditions are changed to match the high-temperature firing conditions, but as one example, when the nitrided ingot is to be pulverized under high-temperature firing conditions using a dry vibration mill, the mill amplitude is preferably adjusted to 6.5 mm to 9.0 mm and the milling time is adjusted to 1.3 hours to 4.5 hours, for example. An average particle diameter of 1.0 μm or less is advantageous for sinterability because it can help ensure the densification rate in the sintering step. By setting the mill amplitude and milling time to the aforementioned ranges it is possible to obtain a crystalline silicon nitride powder with the cumulative 10% diameter ($D_{10}$) and cumulative 90% diameter ($D_{90}$) adjusted to the prescribed ranges. The mill amplitude may be 7.0 mm to 8.4 mm, and the milling time may be 1.5 hours to 4.2 hours.
The lower limit of the time of the above pulverizing treatment (pulverization time) may be 1.6 hours or more, 1.8 hours or more, or 2.0 hours or more, for example. By setting the lower limit of the pulverization time within the above range, the pulverized product can be sufficiently finely pulverized, and the efficiency of the acid solution treatment in the acid solution treatment step can be further improved. The upper limit of the time of the above pulverizing treatment may be 4.0 hours or less, 3.8 hours or less, or 3.6 hours or less, for example. By setting the upper limit of the pulverization time within the above range, the fired product can be sufficiently pulverized, and excessive pulverization can be prevented, thereby reducing the manufacturing cost.
Since the particle size distribution of the pulverized product influences the coefficient of variation of the thickness of the amorphous film on the surface of the primary particles after the acid solution treatment and washing described later, attention should also be paid to narrowing the particle size distribution by setting the mill amplitude lower and the milling time longer.
The oxygen content of the pulverized product is adjusted to between 1.5 mass% and 8.0 mass%, for example. The upper limit of the oxygen content of the pulverized product may be 7.5 mass% or less, 7.0 mass% or less, 6.5 mass% or less, or 6.0 mass% or less, for example. By setting the upper limit of the oxygen content of the pulverized product within the above range, the acid solution treatment duration in the subsequent acid solution treatment step can be reduced. The lower limit of the oxygen content of the pulverized product may be 2.0 mass% or more, 2.5 mass% or more or 3.0 mass% or more, for example. By setting the lower limit of the oxygen content of the pulverized product within the above range, adjustment of the thickness of the amorphous film on the surface of the primary particles in the silicon nitride powder after acid solution treatment becomes easier, and the coefficient of variation thereof can be suppressed to a small value. The oxygen content of the pulverized product can be adjusted within the above range, and may be 2.0 to 7.5 mass%, 2.5 to 7.0 mass%, or 3.0 mass% to 6.0 mass%, for example. The oxygen content of the pulverized product can be controlled, for example, by adjusting the oxygen content of the silicon powder, the composition of the atmosphere gas in the firing step, and the pulverization time, and it influences the thickness of the amorphous film on the surface of the primary particles.

<Acid Solution Treatment and Washing>

After pulverizing, the impurities in the pulverized product are removed and purified using hydrofluoric acid (HF) together with an inorganic acid such as hydrochloric acid (HCl), sulfuric acid ($H_2SO_4$) or nitric acid ($HNO_3$). In other words, acid solution treatment and washing are carried out using a mixed acid such as hydrofluoric acid and hydrochloric acid, hydrofluoric acid and sulfuric acid or hydrofluoric acid and nitric acid. A mixed acid of hydrofluoric acid and hydrochloric acid is usually used from the viewpoint of solubility of SUS-based impurities. In this method, the chemical components from mixed acid solution remain, tending to increase the content of impurities such as fluorine.

(Hydrofluoric Acid)

Hydrofluoric acid is preferably used at a concentration of 0.50 mass% to 10.00 mass%. The upper limit for the hydrofluoric acid concentration may be 8.00 mass% or less, 7.00 mass% or less or 6.50 mass% or less, for example. By setting the upper limit of the concentration of hydrofluoric acid within the above range, elution of fine silicon nitride can be suppressed, and excessive reduction of the specific surface area and the surface oxygen content can be prevented. Furthermore, excessive reduction in the thickness of the amorphous film present on the surface of the primary particles can be suppressed. The lower limit for the hydrofluoric acid concentration may be 0.70 mass% or more, 1.00 mass% or more or 1.30 mass% or more, for example. By setting the concentration of hydrofluoric acid within the above range and adjusting the treatment temperature and treatment duration, adjustment of the thickness of the amorphous film on the primary particles of the silicon nitride powder becomes easy. Since the concentration of hydrofluoric acid also influences the coefficient of variation of the thickness of the amorphous film on the surface of the primary particles, it is preferable to set the concentration somewhat lower.

(Inorganic Acids other than Hydrofluoric Acid)

The inorganic acids other than hydrofluoric acid are preferably used at concentrations of 1.0 mass% to 20.0 mass%. The upper limit for the concentration of the inorganic acid other than hydrofluoric acid may be 18.0 mass% or less, 16.0 mass% or less or 14.0 mass% or less, for example. The lower limit for the concentration of the inorganic acid other than hydrofluoric acid may be 2.0 mass% or more, 3.0 mass% or more or 4.0 mass% or more, for example. When the upper limit and lower limit for the concentration of the inorganic acids other than hydrofluoric acid are within this range, it will be easy to adjust the amount of metal impurities in the silicon nitride powder.

(Acid Solution Treatment Conditions for Pulverized Product)

As a means of bringing the pulverized product into contact with the acid solution, for example, a method may be employed in which the pulverized product is dispersed in an acid solution; however, in order to reduce the coefficient of variation of the thickness of the amorphous film on the surface of the primary particles, it is preferable to focus on rapidly and uniformly dispersing the pulverized product.
The temperature of the acid (or its aqueous solution) used for the acid solution treatment step is preferably set to 45°C to 75°C. The lower limit for the temperature of the acid solution in the acid solution treatment step may be 50°C or higher or 55°C or higher, for example. The upper limit for the temperature of the acid solution in the acid solution treatment step may be 70°C or lower or 65°C or lower, for example. It is sufficient to adjust the temperature of the acid solution in the acid solution treatment step to within the range described above, such as 50°C to 70°C or 55°C to 65°C, for example. The immersion time in the treatment solution may be 2 to 10 hours or 4 to 8 hours, for example.

(Liquid Temperature for Washing Step)

Following acid solution treatment, the solid (silicon nitride powder) and acid solution in the acid solution treatment slurry is separated while maintaining a temperature near the preset temperature. It is therefore especially important to manage the liquid temperature during the washing step after acid solution treatment. The temperature of the washing solution (such as ion-exchanged water) is preferably set to 45°C to 75°C. The lower limit for the temperature of the washing water may be 50°C or higher or 55°C or higher, for example. The upper limit for the temperature of the washing water may be 70°C or lower or 65°C or lower, for example. It is sufficient to adjust the temperature of the washing solution in the washing treatment step within the range described above, such as 50°C to 70°C or 55°C to 65°C, for example. If the temperature of the washing solution is lower than 45°C, the solid will cool while in contact with high-concentration acid, resulting in residue of chemical components that have adsorbed onto the solid surface, and tending to increase the content of impurities such as fluorine and chlorine. Setting the temperature of the washing solution to 45 to 70°C means adjusting the slurry temperature after acid solution treatment to a range of 45°C to 70°C.

(Washing Solution PH)

The pH of the washing solution at the washing end point is adjusted to 1.3 to 5.0. The pH of the washing solution may be 3.2 to 4.2 or 3.4 to 4.0.

(Drying temperature)

The drying temperature of the filter cake obtained by washing and filtering the solids in the slurry is preferably adjusted to 70°C to 100°C. The drying temperature may be 75°C to 95°C or 85°C to 90°C. A low drying temperature is undesirable as longer time will be required for drying, while an excessively high drying temperature causes the dried product to be hardened, increasing the load during the pulverizing step.

<Adjustment of Thickness of Amorphous Film on Surface of Primary Particles>

The average value of the thickness of the amorphous film present on the surface of the primary particles of the crystalline silicon nitride powder and the coefficient of variation thereof are mainly controlled by adjusting the above acid solution treatment and washing conditions (hydrofluoric acid concentration, acid solution treatment temperature, and acid solution treatment duration). However, the coefficient of variation of the thickness of the amorphous film is influenced not only by the acid solution treatment and washing conditions, but also by the pulverizing conditions (mill amplitude, milling time), the components of the atmosphere gas in the firing step, the oxygen content of the silicon powder used as the raw material, and the like. Therefore, it is desirable to set the conditions comprehensively. For instance, to reduce the coefficient of variation of the thickness, it is preferable to set conditions such as adjusting the pulverizing conditions (by setting the mill amplitude somewhat lower and the pulverization time somewhat longer) to narrow the particle size distribution, controlling the components in the firing furnace atmosphere (oxygen concentration and carbon monoxide concentration) within a prescribed concentration range, and controlling the oxygen amount of the silicon powder used as the raw material to an appropriate value.

(Method of Measuring Surface Oxygen Content (FSO), Internal Oxygen Content (FIO) and Total Oxygen Content (TO))

The surface oxygen content (FSO), internal oxygen content (FIO) and total oxygen content (TO) of the silicon nitride powder of an embodiment of the present invention can be measured by the following procedure. The silicon nitride powder is weighed out and the oxygen content and nitrogen content of the silicon nitride powder are analyzed using an oxygen/nitrogen simultaneous analyzer. The sample for measurement is heated from 20°C to 2000°C at a heating rate of 4 to 8°C/sec, for example, in a helium gas atmosphere. The oxygen desorbed during this heating process is detected and subjected to the following linear temperature ramp mode analysis. Initially, as the temperature begins to rise, the oxygen bonded on the surface of the silicon nitride powder is desorbed, and the surface oxygen content can thus be determined by quantifying the desorbed oxygen content. In other words, the surface oxygen content derived from the silicon oxide layer on the particle surfaces can be determined. Subsequently, upon reaching a temperature near 1400°C, the silicon oxynitride near the particle surfaces begins to decompose. Since onset of the initial decomposition of silicon oxynitride can be discerned by the beginning of nitrogen detection, it is possible to determine the surface oxygen content derived from the silicon oxynitride layer near the particle surfaces.

The amorphous film on the surface of the primary particles defined in an embodiment of the present invention may be composed of silicon oxide or may be composed of silicon oxynitride; however, based on the results of confirming the elemental distribution of silicon, oxygen, and nitrogen on the observed surface by energy-dispersive X-ray analysis (EDX), it was determined that, in most silicon nitride powders, the amorphous film is an Si-O-N-based compound containing both silicon oxide and silicon oxynitride.

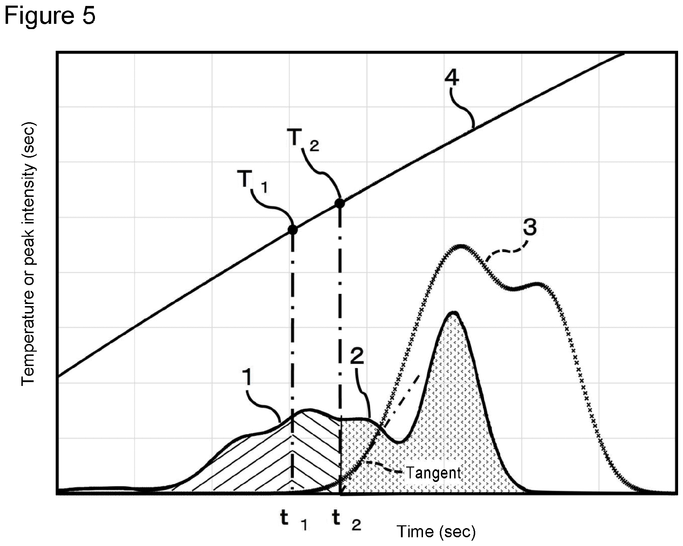

Figure 5 is a drawing showing examples of oxygen and nitrogen concentration charts for silicon nitride powder obtained by simultaneous oxygen/nitrogen analysis. Peak 1 is the surface oxygen peak, and peak 2 is the internal oxygen peak. Peak 3 is the nitrogen peak. The straight line 4 is the temperature increase line.

Peak 1 and peak 2 are divided by the temperature $T_2$. The left end of peak 3 where nitrogen begins to be detected (temperature $T_1$) does not necessarily coincide with the temperature $T_2$ that divides peak 1 and peak 2. In Figure 5, peak 3 clearly begins to increase in the temperature range where the top of peak 1 is detected. This demonstrates that a silicon oxide layer and silicon oxynitride layer have been formed on the surfaces of the silicon nitride particles of an embodiment of the present invention from the rise of peak 3 near temperature $T_1$.

The temperature $T_1$ at which peak 3 rises is usually in the range of 1350 to 1450°C, and the temperature $T_2$ that divides the surface oxygen (peak 1) and the internal oxygen (peak 2) is usually in the range of 1390 to 1460°C. In addition, the temperature at which peak 1 begins to be detected (the temperature at the left end of peak 1) is 750 to 1300°C, for example. The temperature at which peak 2 ceases to be detected (the temperature at the right end of peak 2) is 1900 to 2000°C, for example. The internal oxygen content (FIO) and surface oxygen content (FSO) are detected based on a calibration curve, from the integrated values (areas) of peaks 1 and 2.

Usually, the surface oxygen content derived from the silicon oxide layer on the particle surface is identified by the temperature $T_1$ at which detection of peak 3 begins, i.e., the temperature at which peak 3 rises. However, since the nitrogen concentration peak exhibits a characteristic broadening of a Gaussian function and extends widely on both the lower-temperature side and the higher-temperature side, an error arises in determining the temperature $T_1$ at which nitrogen detection begins, i.e, the temperature at which peak 3 rises. Therefore, in order to improve analytical accuracy, in an embodiment of the present invention, a tangent is drawn to peak 3 at a height corresponding to 20% (i.e., one-fifth) of the maximum value of peak 3 (the peak top height), and the point (time $t_2$) at which the tangent intersects the time axis (zero height) is taken as a reference; at the temperature $T_2$ corresponding to time $t_2$, the concentration peak due to surface oxygen and the concentration peak due to internal oxygen are divided and separated.

In an embodiment of the present invention, the surface oxygen content (FSO) is the amount of oxygen released from both the silicon oxide layer and the silicon oxynitride layer present on the particle surface. The surface oxygen content derived from the silicon oxide layer on the particle surface can be measured based on the temperature $T_1$ at which peak 3 rises from the start of temperature rise. The surface oxygen content derived from the silicon oxynitride layer on the particle surface can be measured based on the temperature $T_2$ corresponding to time $t_2$, i.e., the amount of oxygen released during temperature increase from temperature $T_1$ to temperature $T_2$. Thus, the surface oxygen content derived from the surface layer of the silicon nitride particles (composed of silicon oxide and silicon oxynitride) can be analyzed. Furthermore, the surface nitrogen content derived from the surface layer can also be measured from the amount of nitrogen released during temperature increase from temperature $T_1$ to temperature $T_2$.

As described above, the surface oxygen content (FSO) can be determined, based on the divided temperature $T_2$, as the total content of surface oxygen derived from both the silicon oxide layer and the silicon oxynitride layer on the particle surface. The total of the internal oxygen content (FIO) and surface oxygen content (FSO) is the total oxygen content (TO).

Since the silicon nitride powder exemplified in Figure 5 has a surface oxygen content (FSO) and internal oxygen content (FIO) within appropriate ranges, they can be used as starting materials for sintering to obtain silicon nitride sintered bodies with excellent thermal conductivity and mechanical properties. The reason for this is thought to be that with surface oxygen content (FSO) in an appropriate range the densification rate is fast and a high-density sintered body can be obtained, and that an internal oxygen content (FIO) in an appropriate range inhibits excessive growth of β-type columnar crystals, allowing interior defects to be reduced. The surface oxygen content (FSO) of the silicon nitride powder is preferably equal to or less than the internal oxygen content (FIO), as in Figure 5. It is thus possible to obtain a silicon nitride sintered body having both high thermal conductivity and excellent mechanical properties.

<<Method for Producing Silicon Nitride Sintered Body>>

The silicon nitride sintered body according to an embodiment of the present invention is fabricated by the following method.

After mixing the silicon nitride powder of an embodiment of the present invention with a sintering aid, the obtained mixed powder (sometimes referred to as sintering raw material or raw material mixture) is then molded. The resulting molded body is subsequently sintered to produce a silicon nitride sintered body for use as a high-temperature structural components according to an embodiment of the present invention. Alternatively, molding and sintering may be carried out simultaneously to produce a silicon nitride sintered body for use as a high-temperature structural components of an embodiment of the present invention.

(Sintering Aid)

Because silicon nitride is difficult to sinter, it is common to produce sintered bodies by adding a sintering aid to promote sintering. Because high-temperature stable β-type columnar crystals precipitate out during the sintering process for sintering of silicon nitride, most of the silicon nitride crystal particles in the sintered body are β-type columnar crystals. The microstructure including the aspect ratio and particle diameters of β-type columnar crystals is greatly influenced not only by the silicon nitride powder used as the starting material but also by the type and amount of sintering aid added, as well as the sintering conditions, and these factors are therefore selected as appropriate for the physical properties of the silicon nitride powder and the properties desired for the silicon nitride sintered body.

In order to increase the mechanical strength of a silicon nitride sintered body it is preferable to produce a microstructure with a high aspect ratio of the β-type columnar crystals in the silicon nitride sintered body structure. The sintering aid used in this case will generally be an appropriate combination of magnesium oxide (MgO), aluminum oxide ($Al_2O_3$) and yttrium oxide ($Y_2O_3$). A rare earth oxide such as ytterbium oxide which is effective for improving the heat resistance of the grain boundary phase, is sometimes used in combination with the aforementioned sintering aid in the manufacture of silicon nitride sintered bodies for use in high-temperature structural components that require especially high-temperature strength, such as gas turbine parts. An oxide-based sintering aid may be added to the starting material for producing the sintered body, at 5 mass% to 12 mass%, for example, in the starting material for producing the sintered body.

The method for mixing the silicon nitride powder of an embodiment of the present invention with the sintering aid may be either a wet or dry method, so long as it allows them to be homogeneously mixed, and any publicly known method such as rotary milling, barrel milling or vibration milling may be used. For example, the silicon nitride powder, a sintering aid, a molding binder and a dispersing agent may be dispersed in water and mixed with a ball mill and then spray dried to form granules from the mixed powder.

(Mixed Powder Molding Method)

The method of molding the mixed powder may be a publicly known method such as press molding, cast molding, extrusion forming, injection molding, slip-casting molding or cold isostatic pressing. For example, CIP (cold isostatic press) molding may be employed, in which the obtained granular mixed powder is packed into a rubber die and subjected to pressure to obtain a molded body.

(Sintering Method of Molded Body)

The method of sintering the molded body may be any method such that the obtained sintered body is densified, but it is preferably pressureless sintering in a nitrogen-containing inert gas atmosphere, or pressurized atmosphere sintering with the atmosphere gas pressure increased to about 0.2 to 10 MPa. Preferably, nitrogen gas is used for sintering, with a temperature range of about 1700 to 1800°C for pressureless sintering and about 1800 to 2000°C for pressurized atmosphere sintering. The heating rate from 1400°C to the maximum temperature may be 40°C/h to 150°C/h, for example, and the holding time at the maximum temperature may be 2 hours to 20 hours, for example.

A hot-pressing may also be employed, as a method of simultaneously carrying out molding and sintering. Hot-press sintering is preferably carried out in a nitrogen atmosphere with an applied pressure of 2 to 20 MPa and a sintering temperature of 1750 to 1950°C.

<<Method for Producing Silicon Nitride Sintered Body for Circuit Board>>

A silicon nitride sintered body for a circuit board according to an embodiment of the present invention is produced by the following method.

A sintering aid and organic binder are added to silicon nitride powder of an embodiment of the present invention to prepare a starting mixture, and the obtained starting mixture is used in a sheet forming method such as doctor blading to obtain a molded body (green sheet). Next, after removing the organic binder by degreasing treatment, the obtained degreased molded body may be sintered in a nitrogen-containing inert atmosphere under the sintering conditions (heating rate, maximum temperature and holding time at the maximum temperature) described above, to produce a silicon nitride sintered body for a circuit board according to an embodiment of the present invention. When the purpose is to evaluate the thermal conductivity and mechanical properties of the silicon nitride sintered body for a circuit board, the thermal and mechanical properties of a sintered body obtained by CIP (cold isostatic pressing) molding may be measured.

(Sintering Aid)

According to an embodiment of the present invention, a sintering aid such as yttrium oxide, a lanthanoid rare earth oxide, magnesium oxide, magnesium silicon nitride ($MgSiN_2$, $MgSi_4N_6$) or a rare earth-silicon complex nitride ($Y_2Si_3N_6$) may be used, either alone or in an appropriate combination. The amount of sintering aid added to the starting material for producing the sintered body may be 3 mass% to 8 mass%, for example.

In order to enhance the thermal conductivity of the silicon nitride sintered body it is effective to increase the purity of the β-type crystals and enlarge their dimensions. However, because of the trade-off relationship between such crystalline morphology (large crystal grain dimensions) and mechanical strength for a silicon nitride sintered body, a suitable sintering aid is selected in a suitable amount from among the aforementioned sintering aids, to allow formation of an intricately intertwined structure of β-type crystals with suitable particle diameters, and to allow densification with a minimum amount of grain boundary phase.

<<Mechanical Properties of High-Strength Silicon Nitride Sintered Body for Structural Components>>

The high-strength silicon nitride sintered body for structural components produced as described above has excellent mechanical properties. For example, the three-point bending strength at room temperature may be 800 MPa or higher, or it may be 950 MPa or higher. The three-point bending strength at high temperature (1250°C) may be 520 MPa or higher or 610 MPa or higher.

<<Mechanical Properties and Heat Dissipation of Highly Thermal-Conductive Silicon Nitride Sintered Body for Circuit Board>>

A highly thermal-conductive silicon nitride sintered body for a circuit board has excellent mechanical properties and heat dissipation characteristics. For example, the three-point bending strength at room temperature may be 660 MPa or higher, or it may be 720 MPa or higher. The thermal conductivity at room temperature may be 100 W/(m·K) or higher, and may even be 110 W/(m·K) or higher.

[Examples]

The present invention will now be explained in detail by Examples, with the understanding that these Examples are in no way limitative on the present invention.

(Compositional analysis of amorphous Si-N(-H)-based compound)

The silicon (Si) content of the amorphous Si-N(-H)-based compound was measured by quantitation of the total silicon by the dehydrated gravimetric ICP emission spectroscopy combined method, according to 1603: 2007, "Chemical analysis method for silicon nitride fine powder for fine ceramics". The nitrogen (N) content was measured by quantitation of the total nitrogen content by steam distillation separation neutralization titration method, according to JIS R 1603: 2007. The oxygen (O) content was measured by quantitation of oxygen by the inert gas fusion-carbon dioxide infrared absorbing method of JIS R 1603: 2007, using an oxygen/nitrogen simultaneous analyzer. In order to inhibit oxidation of the amorphous Si-N(-H)-based compound, the sample was handled in a nitrogen-purged glove box. For example, for measurement of the silicon/nitrogen content by ICP emission analysis or steam distillation separation neutralization titration, a nitrogen atmosphere is used for storage of the sample up until directly before pretreatment of the sample for measurement. For measurement of the oxygen content by infrared absorption, a nitrogen atmosphere is used as the atmosphere during sample storage and capsule insertion, up until directly before measurement. The hydrogen (H) content of the amorphous Si-N(-H)-based compound is calculated from the stoichiometric chemical composition, as the remainder after subtracting the silicon (Si), nitrogen (N) and oxygen (O) content from the total content of the amorphous Si-N(-H)-based compound.
The Si, N and H ratio are thus determined to ascertain the compositional formula of the amorphous SiN(-H)-based compound.

<Evaluation of Silicon Nitride Powder: Measurement of Amorphous Film Thickness>

The thickness of the amorphous film in the primary particles of silicon nitride was measured. First, 0.01 g of silicon nitride powder was ultrasonically dispersed in 5 ml of 2-propanol, dropped onto a microgrid Cu mesh, naturally dried, and then subjected to electron microscopy observation. For the electron microscopy observation, a field emission transmission electron microscope (product name: JEM-2100F) manufactured by JEOL Ltd. and a scanning image observation apparatus (product name: EM24541SIOD) manufactured by JEOL Ltd. were used. For the X-ray analysis, an energy dispersive X-ray analyzer (product name: JED-2300) manufactured by JEOL Ltd. was used. The elemental distributions of silicon, oxygen, and nitrogen on the observed surface were confirmed by energy dispersive X-ray spectroscopy (EDX). Since the distribution of silicon corresponds well to the positions of the primary particles of silicon nitride, it was confirmed that oxygen atoms are highly localized in the regions corresponding to the surfaces of the primary particles of silicon nitride. Furthermore, the region in which these oxygen atoms are localized corresponds well to the portions on the surface of the primary particles where lattice fringes corresponding to specific crystal planes of crystalline silicon nitride (α-type $Si_3N_4$ or β-type $Si_3N_4$) are not observed; therefore, in an embodiment of the present invention, the portions with contrast different from the particle interior and without observable lattice fringes were regarded as an amorphous film, and the thickness of the amorphous film was measured.

The thickness of the amorphous film was measured at a total of 30 locations; including at least two locations on any given silicon nitride particle within the observation field for at least 15 silicon nitride particles, and the average value and the coefficient of variation defined by the above expression (1) (paragraph 0016) were then determined (n = 30).

(Method of Measuring Oxygen Content)

Measurement of the oxygen (O) content was based on quantitation of oxygen using an oxygen/nitrogen simultaneous analyzer (Model EMGA-620W manufactured by HORIBA, Ltd.), according to the inert gas fusion-carbon dioxide infrared absorption method specified in JIS R 1603: 2007, measuring the oxygen content of the silicon nitride powder by the following procedure.

30 mg of the silicon nitride powder was weighed out and the measuring sample was set in an oxygen/nitrogen simultaneous analyzer. The temperature was raised from 20°C to 2000°C at a heating rate of 4 to 8°C/sec in a helium gas atmosphere, and the oxygen and nitrogen desorbed during temperature increase were detected to obtain a concentration chart for oxygen (by non-dispersed infrared absorption method) and nitrogen (by thermal conductivity method). An example of the measurement results is shown in Figure 5 (the heating rate is 6.5°C/sec). As shown in Figure 5, peak 1 derived from surface oxygen, peak 2 derived from internal oxygen, and peak 3 derived from nitrogen were detected in the oxygen and nitrogen concentration charts. The straight line 4 indicates temperature.

As described in the above section (Method of Measuring Surface Oxygen Content (FSO), internal oxygen content (FIO) and total oxygen content (TO)), as temperature rise begins, the oxygen bonded on the surface of the silicon nitride powder is desorbed, and therefore the surface oxygen content derived from the silicon oxide layer on the particle surfaces can be determined by quantifying the desorbed oxygen content. The nitrogen then begins to desorb from temperature $T_1$ (for example, 1350 to 1450°C), and peak 3 begins to be detected. Since the oxygen and nitrogen detected at temperature $T_1$ at which peak 3 rises, are those desorbed from the silicon oxynitride layer, the total content of surface oxygen content derived from the silicon oxide layer near the particle surface and the surface oxygen content derived from the silicon oxynitride layer can be obtained by quantifying the amount of oxygen desorbed during the process of temperature increase up to temperature $T_2$. In other words, at $T_2$, the surface oxygen content (FSO) is obtained from the integrated value (area) of the oxygen concentration chart, as the sum of the surface oxygen content derived from the silicon oxide layer near the particle surface and the surface oxygen content derived from the silicon oxynitride layer near the particle surface. Furthermore, at $T_2$, the surface nitrogen content (FSN) derived from the silicon oxynitride layer near the particle surface can be obtained from the integrated value (area) of the nitrogen concentration chart. Accordingly, at temperature $T_2$, the average chemical composition of the surface layer of the silicon nitride particles (composed of silicon oxide and silicon oxynitride), including both the surface oxygen content and the surface nitrogen content, can be measured. From these analytical values, the reciprocal of the mass ratio of surface oxygen content (FSO) to surface nitrogen content (FSN), i.e., FSN/FSO (mass%/mass%) (sometimes referred to as the N/O ratio in the surface layer), can be determined.

As described above, the amount of oxygen desorbed during the process of temperature increase up to temperature $T_2$ was quantified as the surface oxygen content, and the oxygen desorbed at temperatures of equal to or higher than $T_2$ was quantified as the internal oxygen content (FIO). Peak 1 and peak 2 are thus separated by temperature $T_2$, and therefore the internal oxygen content (FIO) and surface oxygen content (FSO) were calculated from the integrated values (areas) of peaks 1 and 2, based on the calibration curve described below. The total of the internal oxygen content (FIO) and surface oxygen content (FSO) was defined as the total oxygen content (TO).

[Expression 2] Total oxygen content (mass%) = Internal oxygen content (mass%) + Surface oxygen content (mass%)          (2)

For measurement of the oxygen content and nitrogen content, first calibration curve was created using a standard sample. The integrated peak intensity value of oxygen detected by the nondispersive infrared absorption cell does not necessarily exhibit linearity with respect to the actual oxygen concentration. Therefore, separately, the amount of desorbed oxygen (which depends on the mass of the standard sample) was varied at about five levels to perform calibration measurements. A calibration curve of oxygen amount versus integrated peak intensity value was prepared, and the oxygen content was determined based on the calibration curve.

(Method of Measuring Fluorine Content)

The total fluorine content of the silicon nitride powder was measured by quantitation of fluorine by thermal hydrolysis separation-ion chromatography, according to JIS R 1603: 2007, "Chemical analysis method for silicon nitride fine powder for fine ceramics". The surface fluorine content was determined by boiling water obtained by dispersing 0.50 g of silicon nitride powder in water to extract the fluorine on the silicon nitride powder surfaces into the water, and quantifying the extracted fluorine using ion chromatography. The internal fluorine content was determined by subtracting the surface fluorine content from the total fluorine content. This is based on the following established expression (3).
[Expression 3] Total fluorine content (mass ppm) = Internal fluorine content (mass ppm) + Surface fluorine content (mass ppm) (3)

(Method of Measuring Chlorine Content)

The total chlorine content of the silicon nitride powder was measured by quantitation of chlorine by thermal hydrolysis separation-ion chromatography, according to JIS R 1603: 2007, "Chemical analysis method for silicon nitride fine powder for fine ceramics".
In an embodiment of the present invention, the halogen content means the total content of fluorine content and chlorine content.

(Method of Measuring Metal Silicon Content)

The metal silicon content of the silicon nitride powder was measured by a hydrogen gas evolution-gas volumetric method according to JIS R1616: 2007, "9. Free silicon quantitation method", as applied for a free silicon content of 0.01 mass% to 1 mass%.

(Method of Measuring Specific Surface Area)

The specific surface areas of the silicon nitride powder and the specific surface area of the amorphous SiN(-H)-based compound were detected by measurement by the BET single-point method, based on nitrogen gas adsorption using a Macsorb by Mountech Co., Ltd.

(Method of Measuring Degree of Crystallinity)

Weighed out 0.15 g of silicon nitride powder was added to a 0.5 N NaOH aqueous solution and heated to 100°C. The $NH_3$ gas generated by decomposition of silicon nitride was absorbed into a 1% boric acid aqueous solution, and the amount of $NH_3$ in the absorbing solution was titrated with a 0.1 N sulfuric acid standard solution. The amount of decomposed nitrogen was calculated from the amount of $NH_3$ in the absorbing solution. The degree of crystallinity was calculated using the following expression (4), based on the amount of decomposed nitrogen and a theoretical nitrogen content of 39.94 mass% in silicon nitride.
[Expression 4] Degree of crystallinity (%) = 100 - (amount of decomposed nitrogen $\times$ 100/39.94) (4)

(Method of Measuring $\alpha$ Phase, $\beta$ Phase and $\beta$/($\alpha$ + $\beta$) Ratio)

X-ray diffraction patterns of the silicon nitride powder were measured using a RINT-TTRIII wide-angle X-ray diffractometer manufactured by Rigaku Corporation. Powder X-ray diffraction measurements were performed using Cu K$\alpha$ radiation, identifying the crystalline phases ($\alpha$ phase and $\beta$ phase) of the produced silicon nitride powder and calculating the $\beta$/($\alpha$+$\beta$) ratio (i.e., the $\beta$ fraction) by the method of Gazzara & Messier in Non-Patent Document 1.

(Method of Measuring Particle Size Distribution, and Median Diameter, 10% Diameter and 90% Diameter of Silicon Nitride Powder)

The particle size distribution of the silicon nitride powder of an embodiment of the present invention was measured in the following manner. A 0.01 g of the powder was added to 200 mL of a 0.2 mass% sodium hexametaphosphate aqueous solution, and dispersed for 6 minutes at an output of 300 W using an ultrasonic homogenizer equipped with a stainless steel center cone having a diameter of 26 mm to prepare a dilute solution, which was used as the measurement sample. The particle size distribution of the test sample was measured using a laser diffraction/scattering particle size distribution analyzer (Microtrac MT3000 manufactured by Microtrac Bell Co., Ltd.). From the volume-based particle size distribution data for the obtained silicon nitride powder of an embodiment of the present invention, the frequency based on the cumulative undersieve distribution (volume %) was calculated, yielding the cumulative particle size distribution curve. The median diameter (50% diameter) in the cumulative particle size distribution curve was defined as the average particle size ($_{D50}$). The particle size corresponding to 10% of the cumulative undersieve distribution was defined as the cumulative 10% diameter ($D_{10}$), and the particle size corresponding to 90% of the cumulative undersieve distribution was defined as the cumulative 90% diameter ($D_{90}$).

(Method of Fabricating and Evaluating High-Strength Sintered Body for Structural Components)

A mixed powder obtained by adding 5 parts by mass of yttrium oxide (specific surface area: 3 $m^2$/g, Shin-Etsu Chemical Co., Ltd.) and 2 parts by mass of aluminum oxide (specific surface area: 7.4 $m^2$/g, SUMITOMO CHEMICAL COMPANY, LIMITED) as sintering aids to 93 parts by mass of silicon nitride powder was wet mixed for 36 hours with a ball mill using ethanol as the medium, and then dried under reduced pressure. The obtained mixture was molded in a die with a $6 \times 45 \times 75$ mm shape under a forming pressure of 50 MPa, followed by CIP forming at a forming pressure of 150 MPa. The obtained molded body was placed in a silicon nitride crucible and sintered at 1780°C for 2 hours under atmospheric nitrogen gas. The obtained sintered body was cut, machined, and polished to fabricate a 3 mm × 4 mm × 40 mm bending test piece conforming to JIS R1601. The bulk density of the sintered body was measured by Archimedes' method. Assuming the silicon nitride particles to have been completely converted to β-type silicon nitride, the relative density (%) (also referred to as the achieved density) was calculated from the density calculated from the starting material composition and the bulk density of the sintered body. The three-point bending strength at room temperature and 1250°C (sometimes referred to as flexural strength (room temperature) and flexural strength (1250°C), respectively) was measured by the method specified in JIS R1601 using Instron Universal Testing Machines. The crosshead speed was 0.5 mm/min. The bending strength at room temperature was the average value for 40 samples. A high temperature bending test was carried out by holding each test piece in an air atmosphere at 1250°C for 10 minutes, measuring the strength of 8 or more test pieces, and calculating the average value. Each of ten 3 mm × 4 mm × 40 mm test pieces were also heat treated for 100 hours in air at 1300°C, measuring the three-point bending strength at room temperature after oxidation (sometimes referred to as the flexural strength after oxidation (room temperature)) of each test piece, and calculating the average value.

(Method of Fabricating and Evaluating High Heat Conduction Sintered Body for Circuit Board)

A mixed powder obtained by adding 3.5 parts by mass of yttrium oxide (specific surface area: 3 $m^2$/g, Shin-Etsu Chemical Co., Ltd.) and 2 parts by mass of magnesium oxide (specific surface area: 3 $m^2$/g, Kojundo Chemical Laboratory Co., Ltd.) as sintering aids to 94.5 parts by mass of silicon nitride powder was wet mixed for 24 hours with a ball mill using ethanol as the medium, and then dried under reduced pressure. The obtained mixture was die molded to a shape of $6 \times 45 \times 75$ mm and a shape of 12.3 mmφ × 1.6 mmt under a forming pressure of 50 MPa, followed by CIP forming at a forming pressure of 150 MPa. The obtained molded body was placed in a boron nitride crucible and sintered at 1900°C for 10 hours under a pressurized nitrogen gas atmosphere of 0.8 MPa. The obtained sintered body was cut, machined and polished, to fabricate a 3 mm × 4 mm × 40 mm bending test piece conforming to JIS R1601, and a 10 mmφ diameter × 1 mmt thick disk-shaped test piece for thermal conductivity measurement conforming to JIS R1611. The bulk density of the sintered body was measured by Archimedes' method. Assuming the silicon nitride particles to have been completely converted to β-type silicon nitride, the relative density (%) (also referred to as the achieved density) was calculated from the density calculated from the starting material composition and the bulk density of the sintered body. The three-point bending strength at room temperature (sometimes referred to as flexural strength (room temperature)) was measured by the method specified in JIS R1601 using Instron Universal Testing Machines, and the thermal conductivity was measured at room temperature by the flash method according to JIS R1611. The crosshead speed for the bending test was 0.5 mm/min. The bending strength at room temperature was the average value for 40 samples. The thermal conductivity was the average value for three disk-shaped test pieces.

(Example 1)

Silicon nitride powder was produced by the following production method (imide decomposition) under the production conditions listed in [Table 1]. The thickness (average value) of the surface amorphous film of the obtained crystalline silicon nitride powder, the coefficient of variation thereof, and the chemical composition (such as surface oxygen content FSO, N/O ratio in the surface layer (ratio of surface nitrogen content to surface oxygen content in the surface portion), internal oxygen content FIO, and total oxygen content TO, etc.) are shown in [Table 2] below, and the halogen impurity concentrations (such as fluorine content, surface fluorine content, and chlorine content) and the powder properties (BET specific surface area SA, crystal phase β/(α+β) ratio, and particle size distribution) are shown in [Table 3] below.

[Method for Producing Silicon Nitride Powder by Imide Decomposition Method]

After replacing the air inside a vertical pressure-resistant reactor with a diameter of 40 cm and a height of 60 cm cooled to 0°C with nitrogen gas, 40 liters of liquid ammonia and 5 liters of toluene were charged into the reactor. The liquid ammonia and toluene were slowly stirred in the reactor while separating liquid ammonia on the upper layer and toluene on the lower layer. A solution (reaction solution) previously prepared to contain 2 liters of silicon tetrachloride and 6 liters of toluene was supplied through a conduit to the lower layer in the reactor that was being slowly stirred. As the solution was supplied, a white reaction product precipitated near the interface between the upper and lower layers. Liquid ammonia was present in large excess at the initial stage of the reaction, but since ammonia was consumed as the reaction proceeds, ammonia was continuously supplied to the reactor. In the steady state, the volume ratio of silicon tetrachloride supplied into the reactor and liquid ammonia in the reactor was 4/100. Upon completion of the reaction, the reaction product and residual solution in the reactor were transferred to a filter tank, after which the reaction product was washed with approximately 43 liters of liquid ammonia in 5 batches (total: 215 liters), and then filtered and dried to obtain about 1 kg of purified silicon diimide with a specific surface area of 800 m$^2$/g and a toluene content of 0.38 mass%.

The obtained silicon diimide was heated and decomposed at 517°C using a rotary kiln furnace while flowing nitrogen gas containing 105 ppm oxygen (by volume), yielding an amorphous Si-N(-H)-based compound represented by the compositional formula $Si_6N_{10.58}H_{7.74}$, i.e. the formula $Si_6N_{2x}(NH)_{12-3x}$ where x is 1.42. The specific surface area of the obtained amorphous Si-N(-H)-based compound was 560 m$^2$/g and the oxygen content was 0.43 mass%.

The obtained amorphous Si-N(-H)-based compound was then subjected to grinding treatment using a vibration mill, after which a briquetting machine was used for forming into an almond-shaped pieces of approximately 6 mm thick × 8 mm short axis diameter × 12 mm long axis diameter. The almond-shaped molded pieces partially including burr-like crushed pieces were filled into a carbon container coated with silicon carbide (SiC) on its surface. This was supplied to a pusher furnace and heated and fired under a nitrogen gas flowing atmosphere under the conditions (furnace carbon monoxide (CO) concentration, heating rate and maximum temperature) listed in [Table 1], to produce grayish white silicon nitride powder. The holding time at the maximum temperature (1585°C) was 1.5 hours. The CO concentration in the furnace was adjusted by the purity (oxygen concentration and dew point) and flow rate of the supplied nitrogen gas. The obtained crystalline silicon nitride powder was loaded into a vibration mill and milling treatment was carried out for 39 minutes at an amplitude of 7.0 mm in an air atmosphere with a moisture concentration of 173 ppm (V). The thickness (average value) of the surface amorphous film of the obtained crystalline silicon nitride powder, the coefficient of variation thereof, and the chemical composition (such as surface oxygen content FSO, N/O ratio in the surface layer (ratio of surface nitrogen content to surface oxygen content in the surface portion), internal oxygen content FIO, and total oxygen content TO, etc.) are shown in [Table 2] below, and the impurity concentrations (such as fluorine content, surface fluorine content, and chlorine content) and the powder properties (BET specific surface area SA, crystal phase β/(α+β) ratio, and particle size distribution) are shown in [Table 3] below.

(Examples 2 to 14)

The properties of the amorphous Si-N(-H)-based compound (x value in the compositional formula, specific surface area and oxygen content) were controlled by the imide decomposition conditions listed in Table 1 (pyrolysis temperature and oxygen concentration of supply gas). The chemical compositions, properties and particle size distributions of the crystalline silicon nitride powders were controlled by the production conditions listed in [Table 1] (imide synthesis conditions, properties of the amorphous Si-N(-H)-based compound, high-temperature firing conditions and fired powder deagglomeration conditions). Silicon nitride powders were produced by the same method as Example 1, except that the production conditions were as listed in [Table 1].

(Examples 15 to 18)

The properties of the amorphous Si-N(-H)-based compound (x value in the compositional formula, specific surface area and oxygen content) were controlled by the imide decomposition conditions listed in Table 1 (pyrolysis temperature and oxygen concentration of supply gas), in the same manner as Examples 2 to 14. The chemical compositions, properties and particle size distributions of the crystalline silicon nitride powders were controlled by the production conditions listed in [Table 1] (imide synthesis conditions, properties of the amorphous Si-N(-H)-based compound, high-temperature firing conditions and fired powder deagglomeration conditions). Silicon nitride powders were produced by the same method as Example 1, except that the production conditions were as listed in [Table 1]. In Examples 15 to 18, the obtained silicon nitride powder was further heated in air to carry out an oxidation treatment. The oxidation treatment conditions were set such that holding was carried out at 910°C for 4 hours in Example 15; holding was carried out at 1000°C for 4 hours in Example 16; holding was carried out at 1050°C for 4 hours in Example 17; and holding was carried out at 1065°C for 4 hours in Example 18. The thickness of the amorphous film on the particle surface increased by the oxidation treatment in air.

The thickness (average value) of the surface amorphous film of the obtained crystalline silicon nitride powder, the coefficient of variation thereof, and the chemical composition (such as surface oxygen content FSO, N/O ratio in the surface layer (ratio of surface nitrogen content to surface oxygen content in the surface portion), internal oxygen content FIO, and total oxygen content TO, etc.) are shown in [Table 2], and the halogen impurity concentrations (such as fluorine content, surface fluorine content, and chlorine content) and the powder properties (BET specific surface area SA, crystal phase $\beta/(\alpha+\beta)$ ratio, and particle size distribution) are shown in [Table 3].

Examples 4 and 11 had a slightly high surface oxygen content after post-milling treatment, and therefore the obtained silicon nitride powders were immersed in a dilute aqueous hydrofluoric acid solution to reduce the surface oxygen content. The temperature of the aqueous hydrofluoric acid solution was 30°C, the immersion time was 0.5 hours, and the hydrofluoric acid concentration was 0.02 mass% in Example 4 and 0.10 mass% in Example 11. The fluorine content of the silicon nitride powders after drying was therefore slightly high.

Examples 1 to 3 and 15 had a thickness (average value) of the amorphous film present on the particle surface of 1.16 nm to 1.40 nm, Examples 4 to 14 had a thickness (average value) of the amorphous film of 0.92 nm or less, and Examples 16 to 18 had a thickness (average value) of the amorphous film of 2.00 nm or more. In addition, Examples 1 to 10, 12, and 14 had the coefficient of variation of the thickness of the amorphous film of 0.49 or less, and Examples 11, 13, and 15 to 18 had the coefficient of variation of the thickness of the amorphous film of 0.51 to 0.58.

Examples 1 to 4, 6 to 11, 16 and 17 had a surface oxygen content (FSO) measured by linear temperature ramp mode analysis of 0.31 mass% to 0.48 mass%, Examples 12 to 14 had the surface oxygen content of 0.14 mass% to 0.19 mass%, and Examples 5, 15 and 18 had the surface oxygen content of 0.53 mass% to 0.66 mass%.

Examples 1 to 3 and 16 to 18 had a reciprocal of a mass ratio of the surface oxygen content (FSO) to the surface nitrogen content (FSN), FSN/FSO (mass%/mass%), which is derived from the silicon oxide layer and the silicon oxynitride layer on the particle surface and measured by linear temperature ramp mode analysis of 0.35 or less, and Examples 4 to 15 had the FSN/FSO (mass%/mass%) of 0.39 or more, indicating that both silicon oxide and silicon oxynitride are present in the surface layer of the silicon nitride particles.

Examples 1, 12, 13 and 16 to 18 had a specific surface area (SA) of lower than 8.0 m$^2$/g, Examples 2 to 11, 14 and 15 had a specific surface area (SA) of 8.3 m$^2$/g to 12.4 m$^2$/g.

Examples 8 to 14 had a surface oxygen content/specific surface area ratio (FSO/SA) of 0.22 to 0.37 mg/m$^2$, and Examples 1 to 7 and 15 to 18 had a surface oxygen content/specific surface area ratio (FSO/SA) of 0.42 mg/m$^2$ or more. In particular, Example 18 has a surface oxygen content/specific surface area (FSO/SA) of 1.00 mg/m$^2$ or more.

Example 11 had a fluorine content of more than 100 ppm and a halogen (F + Cl) content of more than 110 ppm.

Examples 1, 4, 5, 7 to 9, 12, 14, 16, and 18 had a $\beta/(\alpha+\beta)$ of 1.8 mass% to 3.0 mass%, whereas Examples 3, 6, 10, 11, 13, 15, and 17 had a $\beta/(\alpha+\beta)$ of 3.2 mass% to 5.6 mass%.

Examples 1 to 12, 14 and 15 had a cumulative 10% diameter $D_{10}$ of 0.49 $\mu$m or less, and Examples 6 and 11 had a cumulative 10% diameter $D_{10}$ of about 0.25 $\mu$m. Examples 6 and 11 had a cumulative 90% diameter $D_{90}$ of about 1.96 $\mu$m, and Examples 1 to 5, 7 to 10, and 12 to 17 had a cumulative 90% diameter $D_{90}$ of 2.03 $\mu$m to 2.38 $\mu$m.

(Comparative Examples 1 to 6)

The properties of the amorphous Si-N(-H)-based compound (x value in the compositional formula, specific surface area and oxygen content) were controlled by the imide decomposition conditions listed in Table 1 (pyrolysis temperature and oxygen concentration of supply gas), in the same manner as Examples 2 to 18. The chemical compositions, properties and particle size distributions of the crystalline silicon nitride powders were controlled by the production conditions listed in [Table 1] (imide synthesis conditions, properties of the amorphous Si-N(-H)-based compound, high-temperature firing conditions and fired powder deagglomeration conditions). Silicon nitride powders were produced by the same method as Example 1, except that the production conditions were as listed in [Table 1].

Furthermore, in Comparative Examples 1 and 2, the obtained silicon nitride powder was heated in air to carry out an oxidation treatment. The oxidation treatment conditions were set such that holding was carried out at 1100°C for 4 hours in Comparative Example 1, and holding was carried out at 1025°C for 4 hours in Comparative Example 2. The thickness of the amorphous film on the particle surface increased by the oxidation treatment in air.

The thickness (average value) of the surface amorphous film of the obtained crystalline silicon nitride powder, the coefficient of variation thereof, and the chemical composition (such as surface oxygen content FSO, N/O ratio in the surface layer (ratio of surface nitrogen content to surface oxygen content in the surface portion), internal oxygen content FIO, and total oxygen content TO, etc.) are shown in [Table 2], and the halogen impurity concentrations (such as fluorine content, surface fluorine content, and chlorine content) and the powder properties (BET specific surface area SA, crystal phase $\beta/(\alpha+\beta)$ ratio, and particle size distribution) are shown in [Table 3].

Comparative Examples 3 to 5 had a slightly high surface oxygen content after post-milling treatment, and therefore the obtained silicon nitride powders were immersed in a dilute aqueous hydrofluoric acid solution to reduce the surface oxygen content. The temperature of the aqueous hydrofluoric acid solution was 30°C, the immersion time was 0.5 hours, and the hydrofluoric acid concentration was 0.10 mass% in Comparative Examples 3 and 5 and 0.06 mass% in Comparative Example 4. The fluorine contents of the silicon nitride powders after drying were therefore slightly high.

Comparative Examples 4 to 6 had a thickness (average value) of the amorphous film present on the particle surface of 0.60 nm or less, Comparative Examples 2 to 3 had a thickness (average value) of the amorphous film of 1.20 nm to 2.40 nm, and Comparative Example 1 had a thickness (average value) of the amorphous film of more than 5.00 nm. In addition, Comparative Examples 1 and 3 had the coefficient of variation of the thickness of the amorphous film of 0.55 or less, and Comparative Examples 2 and 4 to 6 had the coefficient of variation of the thickness of the amorphous film of 0.65 or more.

Comparative Examples 2, 5 and 6 had a surface oxygen content (FSO) of 0.28 mass% or less, and Comparative Examples 1, 3 and 4 had a surface oxygen content (FSO) of 0.52 mass% or more.

Comparative Example 2 had a specific surface area (SA) of lower than 3.0 $m^2/g$, and Comparative Examples 4 and 6 had a specific surface area (SA) of higher than 13.0 $m^2/g$.

Comparative Examples 5 and 6 had a surface oxygen content/specific surface area ratio (FSO/SA) of 0.20 $mg/m^2$ or less, Comparative Example 4 had a surface oxygen content/specific surface area ratio (FSO/SA) of 0.39 $mg/m^2$, and Comparative Examples 1 to 3 had a surface oxygen content/specific surface area ratio (FSO/SA) of 0.51 $mg/m^2$ or more.

Comparative Examples 3 to 5 had a fluorine content of 100 ppm or more and a halogen (F + Cl) content of more than 130 ppm.

In all of Examples 1 to 34 and Comparative Examples 1 to 13, the degree of crystallinity of the obtained silicon nitride powder was 99.6% or higher.

[Table 1]

| | Imide synthesis | Imide pyrolysis | | | | | High-temperature firing | | | Deagglomeration | | |
| | Washing conditions | Pyrolysis conditions | | Amorphous Si-N(-H)-based compound | | | Atmosphere and temperature conditions for crystallization | | | Post-milling treatment conditions | | |
| | Amount of liquid NH3 for washing /imide amount | Pyrolysis temp. | Oxygen conc. of supply gas | BET Specific surface area | Oxygen content | X value in compositional formula | CO conc. In the furnace | Heating rate | Maximum temp. | Moisture conc. of supply gas | Mill amplitude | Milling time |
| | (L/kg) | (°C) | (ppm(V)) | (m²/g) | (mass%) | | (ppm(V)) | (°C/h) | (°C) | (ppm(V)) | (mm) | (min) |
|---|---|---|---|---|---|---|---|---|---|---|---|---|
| Example 1 | 215 | 517 | 105 | 560 | 0.43 | 1.42 | 94 | 56 | 1585 | 173 | 7.0 | 39 |
| Example 2 | 190 | 560 | 185 | 525 | 0.57 | 1.59 | 124 | 58 | 1555 | 289 | 7.6 | 42 |
| Example 3 | 165 | 600 | 225 | 500 | 0.62 | 1.76 | 129 | 66 | 1545 | 319 | 7.8 | 45 |
| Example 4 | 155 | 641 | 265 | 470 | 0.68 | 1.94 | 130 | 67 | 1555 | 193 | 7.1 | 38 |
| Example 5 | 65 | 820 | 575 | 350 | 1.00 | 2.70 | 175 | 83 | 1515 | 590 | 7.4 | 43 |
| Example 6 | 110 | 690 | 400 | 435 | 0.84 | 2.13 | 145 | 72 | 1525 | 247 | 7.5 | 42 |
| Example 7 | 90 | 790 | 620 | 370 | 1.04 | 2.54 | 160 | 79 | 1520 | 146 | 7.6 | 43 |
| Example 8 | 75 | 830 | 475 | 345 | 0.91 | 2.73 | 150 | 84 | 1515 | 318 | 7.2 | 42 |
| Example 9 | 85 | 715 | 180 | 420 | 0.56 | 2.28 | 110 | 75 | 1535 | 113 | 7.1 | 35 |
| Example 10 | 75 | 790 | 475 | 370 | 0.91 | 2.60 | 145 | 81 | 1525 | 147 | 7.4 | 38 |
| Example 11 | 60 | 865 | 315 | 325 | 0.74 | 2.87 | 127 | 87 | 1505 | 100 | 7.8 | 37 |

| | Imide synthesis | Imide pyrolysis | | | | High-temperature firing | | | Deagglomeration | | |
| | Washing conditions | Pyrolysis conditions | | Amorphous Si-N(-H)-based compound | | | Atmosphere and temperature conditions for crystallization | | | Post-milling treatment conditions | | |
| | Amount of liquid NH3 for washing /imide amount (L/kg) | Pyrolysis temp. (°C) | Oxygen conc. of supply gas (ppm(V)) | BET Specific surface area (m²/g) | Oxygen content (mass%) | X value in compositional formula | CO conc. In the furnace (ppm(V)) | Heating rate (°C/h) | Maximum temp. (°C) | Moisture conc. of supply gas (ppm(V)) | Mill amplitude (mm) | Milling time (min) |
|---|---|---|---|---|---|---|---|---|---|---|---|---|
| Example 12 | 66 | 400 | 160 | 645 | 0.53 | 0.95 | 100 | 43 | 1550 | 65 | 6.9 | 30 |
| Example 13 | 52 | 432 | 286 | 620 | 0.72 | 1.11 | 105 | 44 | 1620 | 40 | 6.9 | 34 |
| Example 14 | 122 | 593 | 485 | 505 | 0.92 | 1.73 | 133 | 65 | 1545 | 60 | 8.1 | 28 |
| Example 15 | 60 | 806 | 237 | 360 | 0.66 | 2.68 | 234 | 88 | 1510 | 655 | 7.7 | 69 |
| Example 16 | 52 | 470 | 85 | 590 | 0.39 | 1.25 | 116 | 50 | 1570 | 443 | 7.7 | 39 |
| Example 17 | 282 | 385 | 75 | 650 | 0.37 | 0.90 | 156 | 45 | 1585 | 504 | 7.8 | 35 |
| Example 18 | 71 | 405 | 71 | 640 | 0.36 | 1.00 | 115 | 40 | 1641 | 620 | 7.9 | 52 |
| Comp. Ex. 1 | 70 | 606 | 385 | 495 | 0.82 | 1.79 | 255 | 64 | 1560 | 800 | 7.8 | 59 |
| Comp. Ex. 2 | 95 | 370 | 20 | 660 | 0.20 | 0.85 | 93 | 40 | 1620 | 100 | 6.2 | 24 |
| Comp. Ex. 3 | 159 | 708 | 605 | 425 | 1.03 | 2.21 | 180 | 75 | 1540 | 560 | 7.8 | 46 |
| Comp. Ex. 4 | 133 | 958 | 1265 | 269 | 1.51 | 3.27 | 245 | 99 | 1466 | 640 | 8.5 | 54 |

EP 4 782 425 A1

31

(continued)

| | Imide synthesis | Imide pyrolysis | | | | | High-temperature firing | | | Deagglomeration | | |
|---|---|---|---|---|---|---|---|---|---|---|---|---|
| | Washing conditions | Pyrolysis conditions | | Amorphous Si-N(-H)-based compound | | | Atmosphere and temperature conditions for crystallization | | | Post-milling treatment conditions | | |
| | Amount of liquid NH3 for washing /imide amount (L/kg) | Pyrolysis temp. (°C) | Oxygen conc. of supply gas (ppm(V)) | BET Specific surface area (m²/g) | Oxygen content (mass%) | X value in compositional formula | CO conc. In the furnace (ppm(V)) | Heating rate (°C/h) | Maximum temp. (°C) | Moisture conc. of supply gas (ppm(V)) | Mill amplitude (mm) | Milling time (min) |
| Comp. Ex. 5 | 76 | 830 | 285 | 345 | 0.67 | 2.73 | 110 | 85 | 1515 | 65 | 8.0 | 28 |
| Comp. Ex. 6 | 55 | 950 | 425 | 275 | 0.86 | 3.22 | 131 | 98 | 1475 | 79 | 8.4 | 33 |

[Table 2]

| | | Surface amorphous film | | State of oxygen impurities | | | | | |
| | | | | Oxygen content and its distribution | | | | Surface oxygen content /specific surface area FSO/SA | Internal oxygen content /specific surface area FIO/SA |
| | | Amorphous film thickness (Average value) (nm) | Coefficient of variation | Surface oxygen content FSO (mass%) | N/O ratio in surface layer (mass%/mass%) | Internal oxygen content FIO (mass%) | Total oxygen content TO (mass%) | (mg/m²) | (mg/m²) |
|---|---|---|---|---|---|---|---|---|---|
| Example 1 | | 1.33 | 0.23 | 0.38 | 0.16 | 0.46 | 0.84 | 0.51 | 0.61 |
| Example 2 | | 1.25 | 0.43 | 0.43 | 0.29 | 0.60 | 1.03 | 0.52 | 0.72 |
| Example 3 | | 1.16 | 0.48 | 0.44 | 0.35 | 0.65 | 1.09 | 0.50 | 0.74 |
| Example 4 | | 0.92 | 0.27 | 0.39 | 0.39 | 0.70 | 1.09 | 0.42 | 0.75 |
| Example 5 | | 0.90 | 0.36 | 0.53 | 0.56 | 0.97 | 1.50 | 0.45 | 0.82 |
| Example 6 | | 0.81 | 0.42 | 0.42 | 0.58 | 0.85 | 1.27 | 0.42 | 0.85 |
| Example 7 | | 0.85 | 0.49 | 0.48 | 0.56 | 0.94 | 1.42 | 0.42 | 0.83 |
| Example 8 | | 0.71 | 0.31 | 0.44 | 0.60 | 0.92 | 1.36 | 0.37 | 0.77 |
| Example 9 | | 0.60 | 0.24 | 0.33 | 0.62 | 0.62 | 0.95 | 0.32 | 0.60 |
| Example 10 | | 0.56 | 0.38 | 0.36 | 0.70 | 0.93 | 1.29 | 0.32 | 0.82 |
| Example 11 | | 0.42 | 0.51 | 0.31 | 0.74 | 0.74 | 1.05 | 0.25 | 0.60 |
| Example 12 | | 0.80 | 0.36 | 0.17 | 0.47 | 0.57 | 0.74 | 0.33 | 1.10 |
| Example 13 | | 0.50 | 0.58 | 0.14 | 0.52 | 0.77 | 0.91 | 0.24 | 1.30 |
| Example 14 | | 0.42 | 0.49 | 0.19 | 0.84 | 0.96 | 1.15 | 0.22 | 1.10 |
| Example 15 | | 1.40 | 0.51 | 0.66 | 0.51 | 0.88 | 1.54 | 0.57 | 0.76 |
| Example 16 | | 2.00 | 0.53 | 0.42 | 0.22 | 0.42 | 0.84 | 0.64 | 0.64 |
| Example 17 | | 3.99 | 0.56 | 0.40 | 0.21 | 0.40 | 0.80 | 0.95 | 0.94 |
| Example 18 | | 3.50 | 0.56 | 0.57 | 0.20 | 0.39 | 0.96 | 1.10 | 0.75 |
| Comp. Ex. 1 | | 5.10 | 0.55 | 1.20 | 0.05 | 0.90 | 2.10 | 1.36 | 1.02 |

(continued)

|  | Surface amorphous film | | State of oxygen impurities | | | | | |
|---|---|---|---|---|---|---|---|---|
|  | | | Oxygen content and its distribution | | | | Surface oxygen content /specific surface area FSO/SA | Internal oxygen content /specific surface area FIO/SA |
|  | Amorphous film thickness (Average value) (nm) | Coefficient of variation | Surface oxygen content FSO (mass%) | N/O ratio in surface layer (mass%/mass%) | Internal oxygen content FIO (mass%) | Total oxygen content TO (mass%) | (mg/m$^2$) | (mg/m$^2$) |
| Comp. Ex. 2 | 2.40 | 0.69 | 0.18 | 0.09 | 0.22 | 0.40 | 0.70 | 0.86 |
| Comp. Ex. 3 | 1.20 | 0.53 | 0.52 | 0.46 | 1.04 | 1.56 | 0.51 | 1.02 |
| Comp. Ex. 4 | 0.60 | 0.80 | 0.54 | 0.64 | 1.40 | 1.94 | 0.39 | 1.00 |
| Comp. Ex. 5 | 0.29 | 0.65 | 0.22 | 0.79 | 0.68 | 0.90 | 0.18 | 0.57 |
| Comp. Ex. 6 | 0.27 | 0.74 | 0.28 | 0.83 | 0.80 | 1.08 | 0.20 | 0.58 |

[Table 3]

| | Halogen impurities | | | | | Specific surface area | X-ray diffraction | Particle size distribution | | |
|---|---|---|---|---|---|---|---|---|---|---|
| | Fluorine content | Surface fluorine content | Surface fluorine content /total fluorine content | Chlorine content | Halogen (F + Cl) content | BET Specific surface area SA | Crystal phase $\beta/(\alpha+\beta)$ | Cumulative 10% diameter $D_{10}$ | Cumulative 90% diameter $D_{90}$ | $D_{90} - D_{10}$ |
| | (ppm) | (ppm) | | (ppm) | (ppm) | (m$^2$/g) | (mass%) | ($\mu$m) | ($\mu$m) | ($\mu$m) |
| Example 1 | < 5 | < 5 | | 19 | 24 | 7.5 | 2.3 | 0.48 | 2.28 | 1.80 |
| Example 2 | < 5 | < 5 | | 24 | 29 | 8.3 | 1.2 | 0.38 | 2.08 | 1.70 |
| Example 3 | 15 | 14 | 0.95 | 29 | 44 | 8.8 | 3.6 | 0.30 | 2.04 | 1.74 |
| Example 4 | 45 | 43 | 0.95 | 30 | 35 | 9.4 | 2.1 | 0.41 | 2.18 | 1.77 |
| Example 5 | < 5 | < 5 | | 66 | 71 | 11.8 | 2.0 | 0.36 | 2.11 | 1.75 |
| Example 6 | 23 | 22 | 0.94 | 42 | 65 | 10.0 | 3.2 | 0.24 | 1.97 | 1.73 |
| Example 7 | < 5 | < 5 | | 52 | 57 | 11.3 | 2.0 | 0.32 | 2.04 | 1.72 |
| Example 8 | < 5 | < 5 | | 60 | 65 | 11.9 | 2.1 | 0.34 | 2.10 | 1.76 |
| Example 9 | 15 | 14 | 0.95 | 54 | 59 | 10.3 | 3.0 | 0.44 | 2.23 | 1.79 |
| Example 10 | <5 | <5 | | 58 | 63 | 11.3 | 4.0 | 0.40 | 2.17 | 1.77 |
| Example 11 | 110 | 106 | 0.96 | 9 | 119 | 12.4 | 3.8 | 0.27 | 1.96 | 1.69 |
| Example 12 | 10 | 9 | 0.90 | 65 | 75 | 5.2 | 1.8 | 0.49 | 2.18 | 1.69 |
| Example 13 | 26 | 25 | 0.96 | 80 | 106 | 5.9 | 3.2 | 0.53 | 2.38 | 1.85 |
| Example 14 | 18 | 17 | 0.95 | 40 | 58 | 8.7 | 2.7 | 0.30 | 2.03 | 1.73 |
| Example 15 | 15 | 15 | 0.97 | 72 | 87 | 11.5 | 5.6 | 0.30 | 2.20 | 1.90 |
| Example 16 | 35 | 34 | 0.96 | 80 | 115 | 6.6 | 2.9 | 0.53 | 2.20 | 1.67 |
| Example 17 | < 5 | < 5 | | 58 | 63 | 4.2 | 3.5 | 0.51 | 2.38 | 1.87 |
| Example 18 | 28 | 27 | 0.96 | 89 | 117 | 5.2 | 2.7 | 0.54 | 2.53 | 1.99 |
| Comp. Ex. 1 | 15 | 14 | 0.96 | 60 | 75 | 8.8 | 2.8 | 0.53 | 2.58 | 2.05 |
| Comp. Ex. 2 | < 5 | < 5 | | 48 | 53 | 2.6 | 20 | 0.61 | 2.41 | 1.80 |

EP 4 782 425 A1

| | Halogen impurities | | | | | Specific surface area | X-ray diffraction | Particle size distribution | | |
|---|---|---|---|---|---|---|---|---|---|---|
| | Fluorine content | Surface fluorine content | Surface fluorine content /total fluorine content | Chlorine content | Halogen (F + Cl) content | BET Specific surface area SA | Crystal phase $\beta/(\alpha+\beta)$ | Cumulative 10% diameter $D_{10}$ | Cumulative 90% diameter $D_{90}$ | $D_{90}$ - $D_{10}$ |
| | (ppm) | (ppm) | | (ppm) | (ppm) | (m$^2$/g) | (mass%) | ($\mu$m) | ($\mu$m) | ($\mu$m) |
| Comp. Ex. 3 | 120 | 114 | 0.95 | 30 | 150 | 10.2 | 3.5 | 0.48 | 2.46 | 1.98 |
| Comp. Ex. 4 | 100 | 93 | 0.93 | 35 | 135 | 14.0 | 3.4 | 0.18 | 1.85 | 1.67 |
| Comp. Ex. 5 | 128 | 124 | 0.97 | 58 | 186 | 11.9 | 5.7 | 0.40 | 2.37 | 1.97 |
| Comp. Ex. 6 | 30 | 28 | 0.93 | 78 | 108 | 13.8 | 3.3 | 0.19 | 1.83 | 1.64 |

(Example 19)

Silicon nitride powder was produced by the following production method (direct nitriding method) under the production conditions listed in [Table 4] and [Table 5]. The thickness (average value) of the surface amorphous film of the obtained crystalline silicon nitride powder, the coefficient of variation thereof, and the chemical composition (such as surface oxygen content FSO, N/O ratio in the surface layer (ratio of surface nitrogen content to surface oxygen content in the surface portion), internal oxygen content FIO, and total oxygen content TO, etc.) are shown in Table 6, and the halogen impurity concentrations (such as fluorine content, surface fluorine content, and chlorine content) and the powder properties (BET specific surface area SA, crystal phase $\beta/(\alpha+\beta)$ ratio, and particle size distribution) are shown in Table 7.

[Method for Producing Silicon Nitride Powder by Direct Nitriding Method]

A commercially available metal silicon powder (average particle diameter $D_{50}$: 4.0 $\mu$m, oxygen content: 0.40 mass%) was mixed with 3.7 mass% of crystalline silicon nitride powder (average particle diameter $D_{50}$: 0.7 $\mu$m, oxygen content: 0.90 mass%, $\beta/(\alpha + \beta)$ = 6.0 (mass%)) and 0.03 mass% of calcium fluoride. An organic binder (polyvinyl alcohol) was further added in a slurry state in an amount of 1.6 parts by mass to 100 parts by mass of the mixture, after which the resulting mixture was dried to prepare a raw material powder. The raw material powder was used to fabricate an almond-shaped molded pieces of approximately 4 mm thickness × 5 mm short axis diameter × 8 mm long axis diameter using a briquetting machine, which was then packed into a silicon nitride firing vessel. The packing density was 1.0 g/cm$^3$. The almond-shaped molded pieces were increased in temperature to 1540°C using an electric furnace for firing, to fabricate a silicon nitride ingot. The temperature increase program was a heating rate of 9.2°C/h from 1100°C up to the temperature at which nitriding ratio reaches 50%, with the heating rate set to 33°C/h from the temperature at which nitriding ratio reaches 50% up to 1540°C, followed by holding for 1 hour at the maximum temperature (1540°C) and then temperature decrease. The atmosphere during firing was a nitrogen/ammonia mixed atmosphere ($N_2$:$NH_3$ = 96.5:3.5 (by volume)). The moisture concentration of the supply gas was 80 ppm (V), and the oxygen concentration was 18 ppm (V) .

After nitriding was complete, the fired article was cooled and the produced ingot was removed and crushed to coarse and medium sizes using a jaw crusher and roll crusher. After which a grinding aid (methyl ethyl ketone) was added and dry grinding was carried out in a vibration mill packed with silicon nitride balls (SUS304 vessel), to produce silicon nitride powder. The mill amplitude was 7.3 mm and the milling time was 140 minutes.

The silicon nitride powder obtained by dry grinding was post-treated by immersion for 7 hours in a mixed acid solution of hydrofluoric acid (concentration: 2.0 mass%)-hydrochloric acid (concentration: 4.4 mass%) heated to 70°C. The mixed acid solution slurry was then repeatedly washed and filtered in ion-exchanged water heated to 47°C. At the washing end point, as the time point when the washing solution reached a pH of 4.1, the filter cake was removed out and dried in a dryer at 95°C. A crystalline silicon nitride powder was thus obtained for Example 19.

(Examples 20 to 34)

Commercially available metal silicon powder was subjected to milling treatment using a vibration mill (having the inner walls coated with polyurethane) packed with silicon nitride balls, to prepare metal silicon powders with different average particle diameters and oxygen contents. To this powder, crystalline silicon nitride powder (average particle diameter $D_{50}$: 0.7 $\mu$m, oxygen content: 0.90 mass%, $\beta/(\alpha + \beta)$ = 6.0 (mass%)), calcium fluoride (including the case of no addition) and an organic binder (polyvinyl alcohol) were added, and a silicon nitride ingot was produced by direct nitriding method according to the same method as in Example 19 except that the production conditions (firing raw material, and nitriding conditions with high-temperature firing) were as listed in [Table 4]. Silicon nitride powders were produced by the same method as in Example 19, except that the obtained silicon nitride ingots were treated under the post-treatment conditions (pulverizing conditions, mixed acid solution treatment conditions, and washing and drying conditions) listed in [Table 5].

The thickness (average value) of the surface amorphous film of the obtained crystalline silicon nitride powder, the coefficient of variation thereof, and the chemical composition (such as surface oxygen content FSO, N/O ratio in the surface layer (ratio of surface nitrogen content to surface oxygen content in the surface portion), internal oxygen content FIO, and total oxygen content TO, etc.) are shown in Table 6, and the halogen impurity concentrations (such as fluorine content, surface fluorine content, and chlorine content) and the powder properties (BET specific surface area SA, crystal phase $\beta/(\alpha+\beta)$ ratio, and particle size distribution) are shown in Table 7.

Examples 19 to 27 and 29 to 32 had a thickness (average value) of the amorphous film present on the particle surface of 0.74 nm or less, Example 28 had a thickness (average value) of the amorphous film of 0.94 nm, Example 33 had a thickness (average value) of the amorphous film of 1.90 nm, and Example 34 had a thickness (average value) of the amorphous film of 2.35 nm. In addition, Examples 19 to 28, 30 to 32, and 34 had the coefficient of variation of the thickness of the amorphous film of 0.49 or less, and Examples 29 and 33 had the coefficient of variation of the thickness of the amorphous film of about 0.58.

Examples 20, 31 and 32 had the surface oxygen content (FSO) measured by linear temperature ramp mode analysis of 0.13 to 0.18 mass%, Examples 19, 21 to 30 had the surface oxygen content (FSO) of 0.30 to 0.50 mass%, and Examples 33 and 34 had the surface oxygen content (FSO) of 0.80 to 0.86 mass%.

Examples 33 and 34 had a reciprocal of a mass ratio of the surface oxygen content (FSO) to the surface nitrogen content (FSN), FSN/FSO (mass%/mass%), which is derived from the silicon oxide layer and the silicon oxynitride layer on the particle surface and measured by linear temperature ramp mode analysis of 0.17 or less.

On the other hand, Examples 19 and 21 to 31 had the FSN/FSO (mass%/mass%) of 0.35 to 0.73, indicating that both silicon oxide and silicon oxynitride are present in the surface layer of the silicon nitride particles.

Examples 19, 20, 30, and 31 had a specific surface area (SA) of lower than 8.0 $m^2/g$, whereas Examples 21 to 29 and 32 to 34 had a specific surface area (SA) of 8.1 to 12.4 $m^2/g$.

Examples 29, 31, and 32 had a surface oxygen content/specific surface area ratio (FSO/SA) of 0.20 $mg/m^2$ to 0.27 $mg/m^2$, and Examples 19 to 28 and 30 had a surface oxygen content/specific surface area ratio (FSO/SA) of 0.31 $mg/m^2$ to 0.46 $mg/m^2$.

Examples 30 and 31 had a fluorine content of more than 80 ppm, while Examples 29 to 34 had a halogen (F + Cl) content of more than 100 ppm.

Examples 19 to 34 had $\beta/(\alpha + \beta)$ ratios of 4.2 mass% to 13.7 mass%.

Examples 20 and 22 to 30 had a cumulative 10% diameter $D_{10}$ of 0.45 $\mu$m or less. Examples 24 and 29 had a cumulative 90% diameter $D_{90}$ of 1.98 $\mu$m or less, and Examples 19 to 23, 25 to 28, and 30 to 34 had a cumulative 90% diameter $D_{90}$ of 2.02 to 2.36 $\mu$m.

(Comparative Examples 7 to 13)

Commercially available metal silicon powder was subjected to milling treatment using a vibration mill (having the inner walls coated with polyurethane) packed with silicon nitride balls, to prepare metal silicon powders with different average particle diameters and oxygen contents. To this powder, crystalline silicon nitride powder (average particle diameter $D_{50}$: 0.7 $\mu$m, oxygen content: 0.90 mass%, $\beta/(\alpha + \beta)$ = 6.0 (mass%)), calcium fluoride (including the case of no addition) and an organic binder (polyvinyl alcohol) were added, and a silicon nitride ingot was produced by direct nitriding method according to the same method as in Example 19 except that the production conditions (firing raw material, and nitriding conditions with high-temperature firing) were as listed in [Table 4]. Silicon nitride powders were produced by the same method as in Example 19, except that the obtained silicon nitride ingots were treated under the post-treatment conditions (pulverizing conditions, mixed acid solution treatment conditions, and washing and drying conditions) listed in [Table 5].

The thickness (average value) of the surface amorphous film of the obtained crystalline silicon nitride powder, the coefficient of variation thereof, and the chemical composition (such as surface oxygen content FSO, N/O ratio in the surface layer (ratio of surface nitrogen content to surface oxygen content in the surface portion), internal oxygen content FIO, and total oxygen content TO, etc.) are shown in Table 6, and the halogen impurity concentrations (such as fluorine content, surface fluorine content, and chlorine content) and the powder properties (BET specific surface area SA, crystal phase $\beta/(\alpha+\beta)$ ratio, and particle size distribution) are shown in Table 7.

Comparative Examples 11 to 13 had a thickness (average value) of the amorphous film present on the particle surface of 0.69 nm or less, Comparative Examples 8 to 10 had a thickness (average value) of the amorphous film of 1.00 nm to 1.28 nm, and Comparative Example 7 had a thickness (average value) of the amorphous film of more than 5.00 nm. In addition, Comparative Examples 7, 9, and 11 had the coefficient of variation of the thickness of the amorphous film of 0.54 or less, and Comparative Examples 8, 10, 12, and 13 had the coefficient of variation of the thickness of the amorphous film of 0.63 or more.

Comparative Examples 8 and 11 to 13 had a surface oxygen content (FSO) of 0.21 mass% to 0.26 mass%, and Comparative Example 7 had a surface oxygen content (FSO) of 1.20 mass%.

Comparative Example 8 had a specific surface area (SA) of lower than 3.0 $m^2/g$, and Comparative Example 13 had a specific surface area (SA) of higher than 13.0 $m^2/g$.

Comparative Examples 12 and 13 had a surface oxygen content/specific surface area ratio (FSO/SA) of 0.22 $mg/m^2$ or less, Comparative Example 11 had a surface oxygen content/specific surface area ratio (FSO/SA) of 0.49 $mg/m^2$, and Comparative Examples 8 to 10 had a surface oxygen content/specific surface area ratio (FSO/SA) of 0.52 to 0.76 $mg/m^2$.

Comparative Examples 7 to 13 had a fluorine content of 89 ppm or more, and particularly Comparative Examples 11 and 13 had a fluorine content of more than 120 ppm. Comparative Examples 8, 9 and 11 to 13 had a halogen (F + Cl) content of 140 ppm or more. Comparative Examples 7, 12 and 13 had $\beta/(\alpha + \beta)$ ratio of 18.5 mass% or more.

Metal silicon was not detected in the obtained silicon nitride powders of any of Examples 19 to 34 or Comparative Examples 7 to 13. In other words, the metal silicon content of the obtained silicon nitride powders was less than 0.01 mass%.

[Table 4]

| | Firing starting material | | | | | | Nitriding conditions with high-temperature firing | | | | | | |
| | Silicon powder | | Amount of additive | | | Packing density | Atmosphere gas composition | | | | Heating rate and maximum temperature | | |
| | Average particle diameter D50 | Oxygen content | Dilution material ($Si_3N_4$) addition | Calcium fluoride addition | Organic binder addition | | Nitrogen | Ammonia | Water conc. | Oxygen conc. | Heating rate up to a nitriding ratio of 50% | Heating rate for nitriding ratios of 50% or higher | Maximum temp. |
| | (μm) | (mass%) | (mass%) | (mass%) | (parts by mass) | (g/cm³) | (vol%) | (vol%) | ppm(v) | (ppm(V)) | (°C/h) | (°C/h) | (°C) |
| Example 19 | 4.0 | 0.40 | 3.7 | 0.03 | 1.6 | 1.0 | 96.5 | 3.5 | 80 | 18 | 9.2 | 33 | 1540 |
| Example 20 | 3.2 | 0.46 | 5.0 | 0.02 | 1.2 | 0.9 | 97.5 | 2.5 | 50 | 50 | 6.2 | 30 | 1530 |
| Example 21 | 3.7 | 0.42 | 5.6 | 0.02 | 1.5 | 1.0 | 97.0 | 3.0 | 105 | 16 | 8.9 | 31 | 1545 |
| Example 22 | 2.2 | 0.64 | 8.4 | 0 | 1.4 | 0.7 | 97.0 | 3.0 | 387 | 88 | 6.6 | 28 | 1530 |
| Example 23 | 2.5 | 0.59 | 10.7 | 0 | 1.2 | 0.7 | 97.5 | 2.5 | 375 | 39 | 6.2 | 21 | 1510 |
| Example 24 | 1.8 | 0.75 | 12.1 | 0.01 | 0.8 | 0.7 | 98.4 | 1.5 | 600 | 97 | 5.7 | 19 | 1505 |
| Example 25 | 2.2 | 0.66 | 16.9 | 0.01 | 0.8 | 0.9 | 98.0 | 2.0 | 440 | 23 | 7.7 | 28 | 1530 |
| Example 26 | 0.9 | 0.87 | 14.3 | 0.01 | 0.6 | 0.9 | 98.4 | 1.5 | 785 | 116 | 7.9 | 23 | 1520 |
| Example 27 | 0.9 | 0.86 | 16.4 | 0 | 1.0 | 0.8 | 97.9 | 2.0 | 800 | 79 | 7.6 | 26 | 1525 |
| Example 28 | 2.5 | 0.58 | 13.2 | 0.01 | 1.0 | 1.0 | 98.0 | 2.0 | 448 | 24 | 8.6 | 31 | 1535 |
| Example 29 | 2.4 | 0.61 | 16.7 | 0.02 | 0.6 | 0.9 | 99.0 | 1.0 | 325 | 18 | 7.7 | 19 | 1500 |

| | Firing starting material | | | | | | Nitriding conditions with high-temperature firing | | | | | | |
| | Silicon powder | | Amount of additive | | | | Atmosphere gas composition | | | | Heating rate and maximum temperature | | |
| | Average particle diameter D50 (μm) | Oxygen content (mass%) | Dilution material (Si$_3$N$_4$) addition (mass%) | Calcium fluoride addition (mass%) | Organic binder addition (parts by mass) | Packing density (g/cm$^3$) | Nitrogen (vol%) | Ammonia (vol%) | Water conc. ppm(v)) | Oxygen conc. (ppm(V)) | Heating rate up to a nitriding ratio of 50% (°C/h) | Heating rate for nitriding ratios of 50% or higher ('C/h) | Maximum temp. (°C) |
|---|---|---|---|---|---|---|---|---|---|---|---|---|---|
| Example 30 | 4.5 | 0.33 | 2.8 | 0.04 | 1.3 | 1.0 | 97.7 | 2.3 | 190 | 44 | 7.0 | 12 | 1481 |
| Example 31 | 2.1 | 0.51 | 3.4 | 0.03 | 0.8 | 1.1 | 98.7 | 1.3 | 235 | 45 | 8.5 | 15 | 1485 |
| Example 32 | 2.2 | 0.65 | 7.7 | 0.04 | 1.2 | 1.0 | 97.8 | 2.2 | 250 | 100 | 7.8 | 36 | 1540 |
| Example 33 | 2.3 | 0.61 | 13.2 | 0.01 | 1.0 | 1.0 | 97.9 | 2.1 | 920 | 42 | 8.3 | 27 | 1565 |
| Example 34 | 3.0 | 0.49 | 6.8 | 0.04 | 1.5 | 0.6 | 96.9 | 3.0 | 681 | 20 | 4.2 | 36 | 1545 |
| Comp. Ex. 7 | 0.6 | 1.01 | 15.8 | 0.05 | 1.4 | 1.4 | 96.9 | 3.0 | 505 | 156 | 15.9 | 35 | 1535 |
| Comp. Ex. 8 | 9.7 | 0.21 | 2.4 | 0.09 | 1.6 | 0.9 | 96.5 | 3.5 | 29 | 82 | 7.8 | 47 | 1588 |
| Comp. Ex. 9 | 0.9 | 0.88 | 11.6 | 0.07 | 1.2 | 1.1 | 97.4 | 2.5 | 850 | 156 | 8.9 | 40 | 1560 |
| Comp. Ex. 10 | 1.8 | 0.74 | 7.4 | 0.04 | 1.4 | 0.9 | 96.9 | 3.0 | 635 | 170 | 7.9 | 42 | 1570 |
| Comp. Ex. 11 | 0.6 | 0.29 | 2.5 | 0.09 | 1.2 | 1.0 | 98.4 | 1.6 | 113 | 124 | 7.2 | 17 | 1507 |
| Comp. Ex. 12 | 2.5 | 0.58 | 16.4 | 0.09 | 2.2 | 1.2 | 95.5 | 4.5 | 239 | 15 | 10.5 | 37 | 1540 |

(continued)

| | Firing starting material | | | | | | Nitriding conditions with high-temperature firing | | | | | | |
|---|---|---|---|---|---|---|---|---|---|---|---|---|---|
| | Silicon powder | | Amount of additive | | | | Atmosphere gas composition | | | | Heating rate and maximum temperature | | |
| | Average particle diameter D50 (μm) | Oxygen content (mass%) | Dilution material ($Si_3N_4$) addition (mass%) | Calcium fluoride addition (mass%) | Organic binder addition (parts by mass) | Packing density (g/cm³) | Nitrogen (vol%) | Ammonia (vol%) | Water conc. ppm(v)) | Oxygen conc. (ppm(V)) | Heating rate up to a nitriding ratio of 50% (°C/h) | Heating rate for nitriding ratios of 50% or higher ('C/h) | Maximum temp. (°C) |
| Comp. Ex. 13 | 2.3 | 0.64 | 20.2 | 0.16 | 2.4 | 1.1 | 95.0 | 5.0 | 295 | 13 | 11.1 | 10 | 1465 |

[Table 5]

| | Post-treatment conditions | | | | | | | | |
|---|---|---|---|---|---|---|---|---|---|
| | Pulverizing conditions | | Mixed acid solution treatment conditions | | | | Washing/drying conditions | | |
| | Mill amplitude (mm) | Milling time (min) | HF conc. (mass%) | HCl conc. (mass%) | Temp. (°C) | Treatment time (h) | Washing/ filtration temp. (°C) | Washing end point PH | Drying temp. (°C) |
| Example 19 | 7.3 | 130 | 2.40 | 4.4 | 70 | 7 | 47 | 4.1 | 95 |
| Example 20 | 7.1 | 120 | 4.04 | 6.3 | 60 | 10 | 52 | 4.0 | 92 |
| Example 21 | 7.6 | 145 | 2.80 | 5.8 | 70 | 6 | 47 | 4.0 | 90 |
| Example 22 | 7.7 | 160 | 3.26 | 10.8 | 65 | 7 | 65 | 3.7 | 90 |
| Example 23 | 7.5 | 160 | 3.88 | 9.4 | 65 | 7 | 57 | 3.8 | 85 |
| Example 24 | 7.8 | 150 | 4.44 | 9.8 | 65 | 6 | 52 | 3.7 | 81 |
| Example 25 | 8.0 | 155 | 6.40 | 11.2 | 55 | 5 | 57 | 3.7 | 90 |
| Example 26 | 8.0 | 165 | 5.26 | 12.3 | 65 | 5 | 60 | 3.6 | 85 |
| Example 27 | 7.8 | 170 | 6.10 | 15.5 | 60 | 7 | 60 | 3.5 | 85 |
| Example 28 | 8.0 | 180 | 4.70 | 11.4 | 65 | 6 | 59 | 3.7 | 90 |
| Example 29 | 8.1 | 140 | 7.00 | 15.1 | 55 | 5 | 53 | 3.4 | 82 |
| Example 30 | 7.6 | 135 | 2.50 | 7.4 | 60 | 5 | 45 | 1.8 | 83 |
| Example 31 | 7.2 | 115 | 5.90 | 7.7 | 60 | 5 | 48 | 1.8 | 83 |
| Example 32 | 7.7 | 110 | 6.00 | 7.0 | 70 | 7 | 45 | 3.9 | 97 |
| Example 33 | 8.4 | 190 | 2.00 | 12.1 | 65 | 6 | 47 | 1.3 | 90 |
| Example 34 | 7.8 | 220 | 1.41 | 7.2 | 70 | 7 | 47 | 3.9 | 97 |
| Comp. Ex. 7 | 8.6 | 230 | 2.20 | 6.3 | 70 | 5 | 42 | 3.9 | 95 |
| Comp. Ex. 8 | 7.1 | 145 | 1.70 | 17.2 | 70 | 7 | 32 | 3.8 | 107 |
| Comp. Ex. 9 | 8.5 | 140 | 3.95 | 18.4 | 70 | 6 | 40 | 3.1 | 100 |
| Comp. Ex. 10 | 8.2 | 135 | 2.79 | 2.3 | 70 | 7 | 31 | 4.4 | 105 |

(continued)

| | Post-treatment conditions | | | | | | | | |
| | Pulverizing conditions | | Mixed acid solution treatment conditions | | | | Washing/drying conditions | | |
| | Mill amplitude (mm) | Milling time (min) | HF conc. (mass%) | HCl conc. (mass%) | Temp. (°C) | Treatment time (h) | Washing/ filtration temp. (°C) | Washing end point PH | Drying temp. (°C) |
|---|---|---|---|---|---|---|---|---|---|
| Comp. Ex. 11 | 7.5 | 125 | 2.65 | 3.6 | 60 | 5 | 23 | 1.0 | 84 |
| Comp. Ex. 12 | 8.3 | 165 | 6.99 | 12.4 | 50 | 7 | 38 | 3.4 | 98 |
| Comp. Ex. 13 | 8.5 | 130 | 10.26 | 9.9 | 45 | 6 | 27 | 3.5 | 74 |

[Table 6]

| | State of oxygen impurities | | | | | | | |
| | Surface amorphous film | | Oxygen content and its distribution | | | | Surface oxygen content /specific surface area FSO/SA | Internal oxygen content /specific surface area FIO/SA |
| | Amorphous film thickness (Average value) (nm) | Coefficient of variation | Surface oxygen content FSO (mass%) | N/O ratio in surface layer (mass%/ mass%) | Internal oxygen content FIO (mass%) | Total oxygen content TO (mass%) | (mg/m$^2$) | (mg/m$^2$) |
|---|---|---|---|---|---|---|---|---|
| Example 19 | 0.72 | 0.26 | 0.32 | 0.49 | 0.46 | 0.78 | 0.43 | 0.62 |
| Example 20 | 0.50 | 0.32 | 0.17 | 0.80 | 0.56 | 0.73 | 0.33 | 1.10 |
| Example 21 | 0.72 | 0.30 | 0.33 | 0.43 | 0.49 | 0.82 | 0.41 | 0.60 |
| Example 22 | 0.65 | 0.29 | 0.35 | 0.48 | 0.79 | 1.14 | 0.39 | 0.87 |
| Example 23 | 0.55 | 0.26 | 0.42 | 0.67 | 0.71 | 1.13 | 0.43 | 0.72 |
| Example 24 | 0.44 | 0.49 | 0.41 | 0.70 | 0.92 | 1.33 | 0.40 | 0.89 |
| Example 25 | 0.56 | 0.44 | 0.38 | 0.41 | 0.81 | 1.19 | 0.31 | 0.65 |
| Example 26 | 0.64 | 0.38 | 0.46 | 0.55 | 1.04 | 1.50 | 0.41 | 0.94 |
| Example 27 | 0.74 | 0.33 | 0.50 | 0.43 | 1.02 | 1.52 | 0.42 | 0.85 |
| Example 28 | 0.94 | 0.43 | 0.49 | 0.35 | 0.89 | 1.38 | 0.46 | 0.83 |
| Example 29 | 0.37 | 0.58 | 0.33 | 0.64 | 0.75 | 1.08 | 0.27 | 0.62 |

(continued)

| | | Surface amorphous film | | State of oxygen impurities | | | | | |
| | | | | Oxygen content and its distribution | | | | Surface oxygen content /specific surface area FSO/SA | Internal oxygen content /specific surface area FIO/SA |
| | | Amorphous film thickness (Average value)<br><br>(nm) | Coefficient of variation | Surface oxygen content FSO<br><br>(mass%) | N/O ratio in surface layer<br><br>(mass%/ mass%) | Internal oxygen content FIO<br><br>(mass%) | Total oxygen content TO<br><br>(mass%) | (mg/m²) | (mg/m²) |
|---|---|---|---|---|---|---|---|---|---|
| Example 30 | | 0.69 | 0.49 | 0.30 | 0.53 | 0.42 | 0.71 | 0.44 | 0.62 |
| Example 31 | | 0.35 | 0.39 | 0.13 | 0.73 | 0.67 | 0.80 | 0.22 | 1.11 |
| Example 32 | | 0.24 | 0.22 | 0.18 | 0.85 | 0.82 | 1.00 | 0.20 | 0.93 |
| Example 33 | | 1.90 | 0.59 | 0.80 | 0.10 | 0.71 | 1.51 | 0.75 | 0.66 |
| Example 34 | | 2.35 | 0.28 | 0.86 | 0.17 | 0.54 | 1.40 | 1.01 | 0.64 |
| Comp. Ex. 7 | | 5.50 | 0.54 | 1.20 | 0.07 | 1.19 | 2.39 | 1.03 | 1.02 |
| Comp. Ex. 8 | | 1.28 | 0.63 | 0.21 | 0.50 | 0.25 | 0.46 | 0.76 | 0.89 |
| Comp. Ex. 9 | | 1.03 | 0.51 | 0.53 | 0.34 | 1.03 | 1.56 | 0.52 | 1.02 |
| Comp. Ex. 10 | | 1.00 | 0.65 | 0.45 | 0.36 | 0.91 | 1.36 | 0.52 | 1.05 |
| Comp. Ex. 11 | | 0.69 | 0.40 | 0.22 | 0.61 | 0.40 | 0.62 | 0.49 | 0.91 |
| Comp. Ex. 12 | | 0.62 | 0.66 | 0.26 | 0.05 | 0.72 | 0.98 | 0.22 | 0.60 |
| Comp. Ex. 13 | | 0.20 | 0.77 | 0.26 | 0.84 | 0.79 | 1.05 | 0.19 | 0.57 |

[Table 7]

| | Halogen impurities | | | | | Specific surface area | X-ray diffraction | Particle size distribution | | |
|---|---|---|---|---|---|---|---|---|---|---|
| | Fluorine content | Surface fluorine content | Surface fluorine content /total fluorine content | Chlorine content | Halogen (F + Cl) content | BET Specific surface area SA | Crystal phase $\beta/(\alpha+\beta)$ | Cumulative 10% diameter $D_{10}$ | Cumulative 90% diameter $D_{90}$ | $D_{90}$ - $D_{10}$ |
| | (ppm) | (ppm) | | (ppm) | (ppm) | (m$^2$/g) | (mass%) | ($\mu$m) | ($\mu$m) | ($\mu$m) |
| Example 19 | 71 | 60 | 0.85 | 16 | 87 | 7.4 | 13.7 | 0.47 | 2.30 | 1.83 |
| Example 20 | 60 | 51 | 0.85 | 15 | 75 | 5.1 | 5.0 | 0.40 | 2.20 | 1.80 |
| Example 21 | 68 | 59 | 0.87 | 22 | 90 | 8.1 | 12.4 | 0.48 | 2.22 | 1.74 |
| Example 22 | 21 | 19 | 0.92 | 35 | 56 | 9.0 | 6.0 | 0.42 | 2.16 | 1.74 |
| Example 23 | 39 | 37 | 0.95 | 33 | 72 | 9.8 | 5.2 | 0.29 | 2.02 | 1.73 |
| Example 24 | 52 | 48 | 0.93 | 37 | 89 | 10.3 | 4.2 | 0.25 | 1.97 | 1.72 |
| Example 25 | 45 | 42 | 0.94 | 40 | 85 | 12.4 | 8.8 | 0.35 | 2.15 | 1.80 |
| Example 26 | 40 | 37 | 0.93 | 43 | 83 | 11.1 | 9.7 | 0.33 | 2.05 | 1.72 |
| Example 27 | 35 | 33 | 0.94 | 55 | 90 | 12.0 | 8.6 | 0.37 | 2.13 | 1.76 |
| Example 28 | 41 | 38 | 0.94 | 40 | 81 | 10.7 | 11.5 | 0.45 | 2.23 | 1.78 |
| Example 29 | 54 | 45 | 0.84 | 58 | 112 | 12.1 | 9.2 | 0.28 | 1.98 | 1.70 |
| Example 30 | 83 | 69 | 0.83 | 30 | 113 | 6.7 | 6.2 | 0.45 | 2.05 | 1.60 |
| Example 31 | 88 | 74 | 0.84 | 30 | 118 | 6.0 | 100 | 0.47 | 2.04 | 1.57 |
| Example 32 | 77 | 64 | 0.83 | 28 | 105 | 8.8 | 9.0 | 0.46 | 2.28 | 1.82 |
| Example 33 | 63 | 59 | 0.94 | 50 | 113 | 10.7 | 9.2 | 0.46 | 2.25 | 1.79 |
| Example 34 | 73 | 60 | 0.83 | 28 | 101 | 8.5 | 9.0 | 0.48 | 2.36 | 1.88 |
| Comp. Ex. 7 | 89 | 70 | 0.79 | 26 | 115 | 11.7 | 42.3 | 0.36 | 2.35 | 1.99 |
| Comp. Ex. 8 | 108 | 79 | 0.73 | 90 | 198 | 2.8 | 9.2 | 0.74 | 2.64 | 1.88 |
| Comp. Ex. 9 | 95 | 74 | 0.77 | 85 | 180 | 10.1 | 12.6 | 0.47 | 2.45 | 1.98 |
| Comp. Ex. 10 | 110 | 93 | 0.85 | 9 | 119 | 8.7 | 9.7 | 0.52 | 2.58 | 2.06 |

EP 4 782 425 A1

46

(continued)

| | Halogen impurities | | | | | Specific surface area | X-ray diffraction | Particle size distribution | | |
|---|---|---|---|---|---|---|---|---|---|---|
| | Fluorine content | Surface fluorine content | Surface fluorine content /total fluorine content | Chlorine content | Halogen (F + Cl) content | BET Specific surface area SA | Crystal phase $\beta/(\alpha+\beta)$ | Cumulative 10% diameter $D_{10}$ | Cumulative 90% diameter $D_{90}$ | $D_{90} - D_{10}$ |
| | (ppm) | (ppm) | | (ppm) | (ppm) | (m$^2$/g) | (mass%) | (µm) | (µm) | (µm) |
| Comp. Ex. 11 | 121 | 96 | 0.80 | 19 | 140 | 4.4 | 9.4 | 0.53 | 2.03 | 1.89 |
| Comp. Ex. 12 | 100 | 70 | 0.70 | 58 | 158 | 12.0 | 18.5 | 0.42 | 2.39 | 1.97 |
| Comp. Ex. 13 | 125 | 90 | 0.72 | 55 | 180 | 13.9 | 21.0 | 0.20 | 1.83 | 1.63 |

USE TEST EXAMPLES

[Sintering Test for Silicon Nitride Powder Produced by Imide Decomposition Method]

The silicon nitride powders obtained in Examples 1 to 18 and Comparative Examples 1 to 6, via imide decomposition method, were used as starting materials to fabricate silicon nitride sintered bodies for structural components by the method described in the preceding section (Method of Fabricating and Evaluating High-Strength Sintered Body for Structural Components), and their strength properties were evaluated. The measurement results for achieved density (relative density) and flexural strength (flexural strength (room temperature), flexural strength (1250°C) and flexural strength after oxidation (room temperature)) of the sintered bodies are shown in [Table 8] below.

The silicon nitride powders obtained in Examples 1 to 18 and Comparative Examples 1 to 6, via imide decomposition method, as starting materials in the same manner, to fabricate silicon nitride sintered bodies for circuit boards by the method described in the preceding section (Method of Fabricating and Evaluating High Heat Conduction Sintered Body for Circuit Board), and their strength properties and thermal conductivities were evaluated. The measurement results for achieved density (relative density), flexural strength (room temperature) and thermal conductivity (room temperature) of the sintered bodies are shown in [Table 8] below.

[Table 8]

| | High-strength material | | | | High heat-conductive material | | |
|---|---|---|---|---|---|---|---|
| | Y$_2$O$_3$-Al$_2$O$_3$-based sintered body | | | | Y$_2$O$_3$-MgO-based sintered body | | |
| | Relative density achieved (%) | Flexural strength (room temp.) (MPa) | Flexural strength (1250°C) (MPa) | Flexural strength after oxidation (room temp.) (MPa) | Relative density achieved (%) | Flexural strength (room temp.) (MPa) | Thermal conductivity (room temp.) (W/(m·K)) |
| Example 1 | 98.9 | 1080 | 740 | 705 | 99.3 | 825 | 114 |
| Example 2 | 97.5 | 1018 | 705 | 780 | 98.5 | 820 | 110 |
| Example 3 | 97.0 | 1005 | 693 | 785 | 97.8 | 743 | 108 |
| Example 4 | 99.4 | 1250 | 810 | 839 | 99.6 | 889 | 130 |
| Example 5 | 99.2 | 1210 | 781 | 800 | 99.6 | 837 | 119 |
| Example 6 | 98.9 | 1177 | 795 | 810 | 99.4 | 851 | 118 |
| Example 7 | 99.1 | 1165 | 770 | 855 | 99.3 | 840 | 116 |
| Example 8 | 99.8 | 1240 | 830 | 869 | 99.9 | 914 | 131 |
| Example 9 | 99.2 | 1205 | 814 | 825 | 99.4 | 884 | 127 |
| Example 10 | 98.3 | 1060 | 723 | 805 | 98.5 | 794 | 115 |
| Example 11 | 97.0 | 1005 | 610 | 660 | 97.6 | 750 | 108 |
| Example 12 | 98.6 | 1130 | 760 | 780 | 99.0 | 840 | 125 |
| Example 13 | 96.4 | 910 | 630 | 660 | 96.8 | 670 | 98 |
| Example 14 | 96.6 | 940 | 665 | 740 | 97.5 | 715 | 98 |
| Example 15 | 97.3 | 1010 | 675 | 690 | 97.9 | 770 | 111 |
| Example 16 | 96.8 | 970 | 660 | 680 | 97.3 | 720 | 108 |
| Example 17 | 96.6 | 935 | 655 | 670 | 96.9 | 680 | 102 |
| Example 18 | 96.4 | 900 | 640 | 650 | 96.7 | 660 | 97 |
| Comp. Ex. 1 | 96.7 | 780 | 530 | 600 | 97.2 | 635 | 80 |
| Comp. Ex. 2 | 89.2 | 440 | 355 | 310 | 91.0 | 420 | 73 |
| Comp. Ex. 3 | 97.1 | 830 | 500 | 655 | 97.3 | 645 | 96 |
| Comp. Ex. 4 | 97.1 | 840 | 525 | 635 | 97.3 | 660 | 86 |

(continued)

| | High-strength material | | | | High heat-conductive material | | |
| | Y$_2$O$_3$-Al$_2$O$_3$-based sintered body | | | | Y$_2$O$_3$-MgO-based sintered body | | |
| | Relative density achieved (%) | Flexural strength (room temp.) (MPa) | Flexural strength (1250°C) (MPa) | Flexural strength after oxidation (room temp.) (MPa) | Relative density achieved (%) | Flexural strength (room temp.) (MPa) | Thermal conductivity (room temp.) (W/(m·K)) |
|---|---|---|---|---|---|---|---|
| Comp. Ex. 5 | 95.5 | 785 | 420 | 550 | 96.2 | 610 | 75 |
| Comp. Ex. 6 | 96.2 | 820 | 585 | 645 | 96.7 | 630 | 91 |

(Results of Sintering Test for Silicon Nitride Powders of Examples 1 to 18)

The crystalline silicon nitride powder of Examples 1 to 3 have a thickness (average value) of the amorphous film on the particle surface of 1.16 to 1.33 nm, the coefficient of variation thereof of 0.23 to 0.48, and a surface oxygen content/specific surface area ratio (FSO/SA) of 0.50 to 0.52 mg/m$^2$. Possibly as a result of this, high-strength materials (Sintered bodies containing Y$_2$O$_3$-Al$_2$O$_3$ -based additives) exhibited flexural strength of 1005 to 1080 MPa at room temperature and 693 to 740 MPa at high temperature (1250°C), having flexural strength after oxidation (room temperature) of 705 to 785 MPa. The flexural strength (room temperature) of high heat-conductive materials (Sintered bodies containing Y$_2$O$_3$-MgO-based additives) was 743 to 825 MPa, and the thermal conductivity was 108 to 114 W/(m·K).

The crystalline silicon nitride powders of Examples 4 to 9 and 12 have a thickness (average value) of the amorphous film on the particle surface of 0.60 to 0.92 nm, the coefficient of variation thereof of 0.24 to 0.49, a surface oxygen content/specific surface area ratio (FSO/SA) of 0.32 to 0.45 mg/m$^2$, and a reciprocal of a mass ratio of the surface oxygen content (FSO) to the surface nitrogen content (FSN), FSN/FSO (mass%/mass%), which is derived from the silicon oxide layer and the silicon oxynitride layer on the particle surface of 0.39 to 0.62. Possibly as a result of this, high-strength materials (Sintered bodies containing Y$_2$O$_3$-Al$_2$O$_3$-based additives) exhibited flexural strength of 1130 MPa or higher at room temperature and 760 MPa or higher at high temperature (1250°C), while the flexural strength after oxidation (room temperature) was increased to 780 MPa or higher. The flexural strength of high heat-conductive materials (Sintered bodies containing Y$_2$O$_3$-MgO-based additives) (room temperature) was about 837 MPa or higher, and the thermal conductivity was increased to 116 to 131 W/(m·K). Silicon nitride sintered bodies having excellent strength properties and thermal conductivities can be obtained.

The crystalline silicon nitride powders of Examples 4 to 9 and 12 had the difference between the cumulative 90% diameter D$_{90}$ and the cumulative 10% diameter D$_{10}$, [D$_{90}$ - D$_{10}$], of 1.69 to 1.79 $\mu$m.

The crystalline silicon nitride powders of Examples 10 and 11 have a thickness (average value) of the amorphous film on the particle surface of 0.42 to 0.56 nm, the coefficient of variation thereof of 0.38 to 0.51, a surface oxygen content/specific surface area ratio (FSO/SA) of 0.25 to 0.32 mg/m$^2$, and a reciprocal of a mass ratio of the surface oxygen content (FSO) to the surface nitrogen content (FSN), FSN/FSO (mass%/mass%), which is derived from the silicon oxide layer and the silicon oxynitride layer on the particle surface of about 0.72. Possibly as a result of this, high-strength materials (Sintered bodies containing Y$_2$O$_3$-Al$_2$O$_3$-based additives) exhibited, as, flexural strength of 1005 to 1060 MPa at room temperature and 610 to 723 MPa at high temperature (1250°C), while the flexural strength after oxidation (room temperature) was 660 to 805 MPa. The flexural strength of high heat-conductive materials (Sintered bodies containing Y$_2$O$_3$-MgO-based additives) (room temperature) was 750 to 794 MPa, and the thermal conductivity was 108 to 115 W/(m·K).

The crystalline silicon nitride powder of Examples 13 and 14 (having specific surface areas of 5.9 and 8.7 m$^2$/g, respectively) have a thickness (average value) of the amorphous film on the particle surface of 0.42 to 0.50 nm, the coefficient of variation thereof of 0.49 to 0.58, and a surface oxygen content/specific surface area ratio (FSO/SA) of 0.24 or 0.22 mg/m$^2$. Possibly as a result of this, high-strength materials (Sintered bodies containing Y$_2$O$_3$-Al$_2$O$_3$-based additives) exhibited flexural strength of 910 to 940 MPa at room temperature and 630 to 665 MPa at high temperature (1250°C), having flexural strength after oxidation (room temperature) of 660 to 740 MPa. The flexural strength of the high heat-conductive materials (Sintered bodies containing Y$_2$O$_3$-MgO-based additives) (room temperature) was 670 to 715 MPa, and the thermal conductivity was 98 W/(m·K) or higher. The thermal and mechanical properties of the resulting sintered body tend to be lower.

The crystalline silicon nitride powder of Example 15 have a thickness (average value) of the amorphous film on the particle surface of 1.40 nm, the coefficient of variation thereof of 0.51, and a somewhat higher surface oxygen content/specific surface area ratio (FSO/SA) of 0.57 mg/m$^2$. Possibly as a result of this, a high-strength material (Sintered

body containing $Y_2O_3$-$Al_2O_3$-based additives) exhibited flexural strength of 1010 MPa at room temperature and 675 MPa at high temperature (1250°C), while having flexural strength after oxidation (room temperature) of 690 MPa. The flexural strength of the high heat-conductive material (Sintered body containing $Y_2O_3$-MgO-based additives) (room temperature) was 770 MPa, and the thermal conductivity was 111 W/(m·K).

The crystalline silicon nitride powders of Examples 16 to 18 have a thickness (average value) of the amorphous film on the particle surface of 2.00 to 3.50 nm, the coefficient of variation thereof of 0.53 to 0.56, a surface oxygen content/specific surface area ratio (FSO/SA) of 0.64 mg/m$^2$ or more, and a reciprocal of a mass ratio of the surface oxygen content (FSO) to the surface nitrogen content (FSN), FSN/FSO (mass%/mass%), which is derived from the silicon oxide layer and the silicon oxynitride layer on the particle surface of about 0.21. Possibly as a result of this, high-strength materials (Sintered bodies containing $Y_2O_3$-$Al_2O_3$-based additives) exhibited flexural strength of 900 to 970 MPa at room temperature and 640 to 660 MPa at high temperature (1250°C), while the flexural strength after oxidation (room temperature) was 650 to 680 MPa. The flexural strength of high heat-conductive materials (Sintered bodies containing $Y_2O_3$-MgO-based additives) (room temperature) was 660 to 720 MPa, and the thermal conductivity was 97 to 108 W/(m·K). The thermal and mechanical properties of the resulting sintered body tend to be somewhat lower.

Examples 4 to 9 (in which the thickness (average value) of the amorphous film on the particle surface is 0.60 to 0.92 nm and the coefficient of variation thereof is 0.24 to 0.49) are classified as Group A, whereas Examples 2 and 3 (in which the thickness (average value) of the amorphous film on the particle surface is about 1.20 nm), Examples 13 and 14 (in which the thickness (average value) of the amorphous film on the particle surface is 0.50 nm or less), and Examples 15 to 18 (in which the coefficient of variation of the thickness of the amorphous film on the particle surface is 0.51 or more) are classified as Group B. The fluorine content in both groups is 45 ppm or less, and there is no difference between the groups. Nevertheless, the flexural strength at high temperature (1250°C) of the high-strength materials (Sintered bodies containing $Y_2O_3$-$Al_2O_3$-based additives) was 770 to 830 MPa for Group A, whereas it was 630 to 705 MPa for Group B, indicating that Group A exhibits higher strength. In addition, the thermal conductivity of the high heat-conductive materials (Sintered bodies containing $Y_2O_3$-MgO-based additives) is also higher in Group A.

It has been known that the impurity fluorine contained in silicon nitride powder influences the high-temperature strength of the resulting sintered body. However, in one embodiment of the present invention, it has been clarified that not the fluorine content alone, but rather the combination of the halogen content or fluorine content with the thickness of the amorphous film on the particle surface and the coefficient of variation thereof governs the high-temperature strength and thermal conductivity of the resulting sintered body. In particular, when the thickness of the amorphous film on the particle surface is 0.50 nm or less, or 1.16 nm or more, and its coefficient of variation thereof exceeds 0.43, the thermal and mechanical properties of the resulting sintered body tended to deteriorate (this deterioration was particularly pronounced when the coefficient of variation exceeded 0.53).

(Results of Sintering Test for Silicon Nitride Powders of Comparative Examples 1 to 6)

Reflecting the powder properties listed in [Table 2] and [Table 3], the crystalline silicon nitride powders of Comparative Examples 1 to 6 yielded high-strength materials (Sintered bodies containing $Y_2O_3$-$Al_2O_3$-based additives) having flexural strength of 840 MPa or lower at room temperature and 585 MPa or lower at high temperature (1250°C), with flexural strength after oxidation (room temperature) of 655 MPa or lower. The flexural strength (room temperature) of the high heat-conductive materials (Sintered bodies containing $Y_2O_3$-MgO-based additives) was 660 MPa or lower and the thermal conductivity was 96 W/(m·K) or lower, and therefore the properties of the obtained sintered bodies were inferior to Examples 1 to 18.

[Sintering Test for Silicon Nitride Powders Produced by Direct Nitriding Method]

The silicon nitride powders obtained by direct nitriding method in Examples 19 to 34 and Comparative Examples 7 to 13 were used as starting materials to fabricate silicon nitride sintered bodies for structural components by the method described in the proceeding section "(Method of Fabricating and Evaluating High-Strength Sintered Body for Structural Components)", and their strength properties were evaluated. The measurement results for achieved density (relative density) and flexural strength (flexural strength (room temperature), flexural strength (1250°C) and flexural strength after oxidation (room temperature)) of the sintered bodies are shown in [Table 9] below.

The silicon nitride powders obtained in Examples 19 to 34 and Comparative Examples 7 to 13 were used as starting materials in the same manner, to fabricate silicon nitride sintered bodies for circuit boards by the method described in the proceeding section (Method of Fabricating and Evaluating High Heat Conduction Sintered Body for Circuit Board), and their strength properties and thermal conductivities were evaluated. The measurement results for achieved density (relative density), flexural strength (room temperature) and thermal conductivity (room temperature) of the sintered bodies are shown in [Table 9] below.

[Table 9]

| | High-strength material | | | | High heat-conductive material | | |
|---|---|---|---|---|---|---|---|
| | Y$_2$O$_3$-Al$_2$O$_3$-based sintered body | | | | Y$_2$O$_3$-MgO-based sintered body | | |
| | Relative density achieved (%) | Flexural strength (room temp.) (MPa) | Flexural strength (1250°C) (MPa) | Flexural strength after oxidation (room temp.) (MPa) | Relative density achieved (%) | Flexural strength (room temp.) (MPa) | Thermal conductivity (room temp.) (W/(m·K)) |
| Example 19 | 96.9 | 870 | 600 | 605 | 97.8 | 700 | 112 |
| Example 20 | 98.0 | 920 | 625 | 640 | 98.7 | 770 | 115 |
| Example 21 | 97.4 | 880 | 605 | 610 | 98.3 | 715 | 111 |
| Example 22 | 99.2 | 985 | 640 | 665 | 99.6 | 790 | 114 |
| Example 23 | 99.1 | 975 | 630 | 640 | 99.3 | 785 | 112 |
| Example 24 | 99.2 | 920 | 620 | 665 | 99.1 | 790 | 110 |
| Example 25 | 98.9 | 980 | 625 | 640 | 99.4 | 770 | 111 |
| Example 26 | 98.9 | 940 | 630 | 620 | 99.1 | 750 | 111 |
| Example 27 | 99.2 | 970 | 635 | 645 | 99.4 | 775 | 112 |
| Example 28 | 98.5 | 950 | 610 | 642 | 98.8 | 742 | 109 |
| Example 29 | 97.8 | 860 | 595 | 585 | 98.6 | 730 | 107 |
| Example 30 | 95.5 | 805 | 540 | 535 | 96.9 | 710 | 98 |
| Example 31 | 96.5 | 800 | 520 | 540 | 96.7 | 670 | 95 |
| Example 32 | 98.0 | 850 | 560 | 630 | 98.2 | 700 | 94 |
| Example 33 | 98.8 | 890 | 590 | 620 | 99.0 | 740 | 100 |
| Example 34 | 98.3 | 835 | 520 | 650 | 98.5 | 720 | 95 |
| Comp. Ex. 7 | 96.2 | 725 | 470 | 520 | 97.0 | 635 | 90 |
| Comp. Ex. 8 | 87.0 | 475 | 300 | 310 | 90.1 | 500 | 70 |
| Comp. Ex. 9 | 96.4 | 740 | 440 | 525 | 97.2 | 630 | 87 |
| Comp. Ex. 10 | 96.6 | 675 | 440 | 505 | 97.4 | 615 | 89 |
| Comp. Ex. 11 | 94.9 | 725 | 450 | 530 | 95.6 | 685 | 93 |
| Comp. Ex. 12 | 94.9 | 640 | 430 | 415 | 96.4 | 575 | 92 |
| Comp. Ex. 13 | 96.5 | 660 | 370 | 450 | 96.2 | 585 | 86 |

(Results of Sintering Test for Silicon Nitride Powders of Examples 19 to 34)

The crystalline silicon nitride powder of Examples 19 and 21 have a thickness (average value) of the amorphous film on the particle surface of 0.72 nm, the coefficient of variation thereof of 0.26 to 0.30, the surface oxygen content (FSO) of 0.32 mass%, a surface oxygen content/specific surface area ratio (FSO/SA) of 0.41 to 0.43 mg/m$^2$, and the specific surface area of 7.4 to 8.1 m$^2$/g. Possibly as a result of this, high-strength materials (Sintered bodies containing Y$_2$O$_3$-Al$_2$O$_3$-based additives) exhibited flexural strength of about 870 MPa at room temperature and about 600 MPa at high temperature (1250°C), having flexural strength after oxidation (room temperature) of about 610 MPa. The flexural strength of high heat-conductive materials (Sintered bodies containing Y$_2$O$_3$-MgO-based additives) (room temperature) was 700 to 715 MPa, and the thermal conductivity was about 111 W/(m·K).

The crystalline silicon nitride powders of Examples 22 to 27 have a thickness (average value) of the amorphous film on the particle surface of 0.44 to 0.74 nm, the coefficient of variation thereof of 0.26 to 0.49, a surface oxygen content/specific surface area ratio (FSO/SA) of 0.31 to 0.43 mg/m$^2$, and a reciprocal of a mass ratio of the surface oxygen content (FSO) to the surface nitrogen content (FSN), FSN/FSO (mass%/mass%), which is derived from the silicon oxide layer and the silicon oxynitride layer on the particle surface of 0.41 to 0.70, and the specific surface area of 9.0 to 12.4 m$^2$/g.

Possibly as a result of this, high-strength materials (Sintered bodies containing $Y_2O_3$-$Al_2O_3$-based additives) exhibited flexural strength of 920 MPa or higher at room temperature and 620 MPa or higher at high temperature (1250°C), while the flexural strength after oxidation (room temperature) was increased to 620 MPa or higher. The flexural strength (room temperature) of high heat-conductive materials (Sintered bodies containing $Y_2O_3$-MgO-based additives) was 750 MPa or higher and the thermal conductivity was 110 W/(m·K) or higher, indicating excellent thermal and mechanical properties. The crystalline silicon nitride powders of Examples 22 to 27 had the difference between the cumulative 90% diameter $D_{90}$ and the cumulative 10% diameter $D_{10}$, $[D_{90} - D_{10}]$, of 1.72 to 1.80 $\mu$m.

The crystalline silicon nitride powder of Example 28 has a thickness (average value) of the amorphous film on the particle surface of 0.94 nm, the coefficient of variation thereof of 0.43, a surface oxygen content/specific surface area ratio (FSO/SA) of 0.46 mg/m$^2$, and the above-described FSN/FSO (mass%/mass%) of 0.35. Possibly as a result of this, the high-strength material (Sintered body containing $Y_2O_3$-$Al_2O_3$-based additives) exhibited flexural strength of 950 MPa at room temperature and 610 MPa at high temperature (1250°C), having flexural strength after oxidation (room temperature) of 642 MPa. The flexural strength of the high heat-conductive material (Sintered body containing $Y_2O_3$-MgO-based additives) (room temperature) was 742 MPa, and the thermal conductivity was 109 W/(m·K).

The crystalline silicon nitride powder of Example 29 has a thickness (average value) of the amorphous film on the particle surface of 0.37 nm, the coefficient of variation thereof of 0.58 (somewhat more), a surface oxygen content/specific surface area ratio (FSO/SA) of 0.27 mg/m$^2$, and the above-described FSN/FSO (mass%/mass%) of 0.64. Possibly as a result of this, the high-strength material (Sintered body containing $Y_2O_3$-$Al_2O_3$-based additives) exhibited flexural strength of 860 MPa at room temperature and 595 MPa at high temperature (1250°C), while having flexural strength after oxidation (room temperature) of 585 MPa. The flexural strength of the high heat-conductive material (Sintered body containing $Y_2O_3$-MgO-based additives) (room temperature) was 730 MPa, and the thermal conductivity was 107 W/(m·K) or higher.

Example 29 had a small cumulative 10% diameter $D_{10}$ of 0.28 $\mu$m and a cumulative 90% diameter $D_{90}$ of 1.98 $\mu$m, with a difference $[D_{90} - D_{10}]$ of 1.70 $\mu$m.

The crystalline silicon nitride powder of Example 30 has a thickness (average value) of the amorphous film on the particle surface of 0.69 nm, the coefficient of variation thereof of 0.49, a surface oxygen content (FSO) of 0.30 mass%, and a surface oxygen content/specific surface area ratio (FSO/SA) of 0.44 mg/m$^2$, and a lower specific surface area of 6.7 m$^2$/g. Possibly as a result of this, the high-strength material (Sintered body containing $Y_2O_3$-$Al_2O_3$-based additives) exhibited flexural strength of 805 MPa at room temperature and 540 MPa at high temperature (1250°C), having flexural strength after oxidation (room temperature) of 535 MPa. The flexural strength of the high heat-conductive material (Sintered body containing $Y_2O_3$-MgO-based additives) (room temperature) was 710 MPa, and the thermal conductivity was 98 W/(m•K).

The crystalline silicon nitride powder of Examples 31 and 32 have a thickness (average value) of the amorphous film on the particle surface of 0.24 to 0.35 nm, the coefficient of variation thereof of 0.39 or 0.22, a surface oxygen content (FSO) of 0.13 to 0.18 mass%, and a surface oxygen content/specific surface area ratio (FSO/SA) of 0.22 mg/m$^2$ or less, thus the oxygen concentration in the surface layer is too low (the surface amorphous film is thin). Possibly as a result of this, high-strength materials (Sintered bodies containing $Y_2O_3$-$Al_2O_3$-based additives) exhibited flexural strength of 800 to 850 MPa at room temperature and 520 to 560 MPa at high temperature (1250°C), having flexural strength after oxidation of 540 to 630 MPa. The flexural strength of high heat-conductive materials (Sintered bodies containing $Y_2O_3$-MgO-based additives) (room temperature) was 670 to 700 MPa (tending to be lower than Examples 22 to 27). The thermal conductivity was 94 to 95 W/(m·K).

The crystalline silicon nitride powder of Examples 33 and 34 have a thickness (average value) of the amorphous film on the particle surface of 1.90 to 2.35 nm, the coefficient of variation thereof of 0.59 or 0.28, a surface oxygen content (FSO) of 0.80 to 0.86 mass%, and a surface oxygen content/specific surface area ratio (FSO/SA) of 0.75 or 1.01 mg/m$^2$, thus the oxygen concentration in the surface layer is too high (the surface amorphous film is thick). Possibly as a result of this, high-strength materials (Sintered bodies containing $Y_2O_3$-$Al_2O_3$-based additives) exhibited flexural strength of 835 to 890 MPa at room temperature and 520 to 590 MPa at high temperature (1250°C), having flexural strength after oxidation of 620 to 650 MPa. The flexural strength of high heat-conductive materials (Sintered bodies containing $Y_2O_3$-MgO-based additives) (room temperature) was 720 to 740 MPa (tending to be lower than Examples 22 to 27). The thermal conductivity was 95 to 100 W/(m·K).

Examples 22 to 28 (in which the thickness (average value) of the amorphous film on the particle surface is 0.44 to 0.94 nm and the coefficient of variation thereof is 0.26 to 0.49) are classified as Group C, whereas Example 29 (in which the coefficient of variation of the thickness of the amorphous film on the particle surface is 0.58), Example 32 (in which the thickness (average value) of the amorphous film on the particle surface is 0.24 (thin)), and Examples 33 and 34 (in which the thickness (average value) of the amorphous film on the particle surface is 1.90 to 2.35 (thick)) are classified as Group D. The fluorine content in both groups is 21 to 77 ppm, and there is small difference between the groups. Nevertheless, the flexural strength at high temperature (1250°C) of the high-strength materials (Sintered bodies containing $Y_2O_3$-$Al_2O_3$-based additives) was 610 to 640 MPa for Group C, whereas it was 520 to 595 MPa for Group D, indicating that Group C exhibits higher strength. The thermal conductivity of the high thermal-conductivity materials (Sintered bodies containing

$Y_2O_3$-MgO-based additives) was 109 to 114 W/(m·K) for Group C, whereas it was 94 to 107 W/(m·K) for Group D, indicating that Group C has high thermal conductivity. Accordingly, similarly to the comparison between Group A and Group B in Examples 2 to 9 and Examples 13 to 18, it can be found that not the fluorine content alone, but the combination of the halogen content or fluorine content with the thickness of the amorphous film on the particle surface and the coefficient of variation thereof, influences the mechanical properties and thermal conductivity of the resulting sintered body.

(Results of Sintering Test for Silicon Nitride Powders of Comparative Examples 7 to 13)

Reflecting the powder properties listed in [Table 6] and [Table 7], the crystalline silicon nitride powders of Comparative Examples 7 to 13 yielded high-strength materials (Sintered bodies containing $Y_2O_3$-$Al_2O_3$-based additives) having flexural strength of 740 MPa or lower at room temperature and 470 MPa or lower at high temperature (1250°C), with flexural strength after oxidation (room temperature) of 530 MPa or lower. The flexural strength (room temperature) of the high heat-conductive materials (Sintered bodies containing $Y_2O_3$-MgO-based additives) was 685 MPa or lower and the thermal conductivity was 93 W/(m·K) or lower, and therefore the properties of the obtained sintered bodies were significantly inferior compared to Examples 19 to 34.

[Industrial Applicability]

As explained above, the present invention can provide silicon nitride powder having suitable ranges for the thickness of the amorphous film on the particle surface and the coefficient of variation thereof, and the halogen content (particularly the fluorine content), and that can yield silicon nitride sintered bodies that have both excellent mechanical properties and high thermal conductivity, as well as a method for production of the same. Furthermore, by appropriately adjusting the BET specific surface area, the ratio of surface oxygen content to specific surface area (FSO/SA), and the like, the mechanical properties and the thermal conductivity can also be enhanced. The present invention can also provide a method for producing a silicon nitride sintered body which has high thermal conductivity in addition to the inherent mechanical property of high strength (high room-temperature strength, high-temperature strength and high room-temperature strength after oxidation) of a silicon nitride sintered body, and which therefore exhibits excellent mechanical properties and high thermal conductivity.

[Reference Signs List]

1 Peak derived from surface oxygen
2 Peak derived from internal oxygen
3 Peak derived from Nitrogen
4 Temperature
$T_1$ Temperature at left end of peak 3 where nitrogen is initially detected (temperature where peak 3 rises)
$T_2$ Temperature at time $t_2$, which is the point where a tangent drawn to peak 3 at a height corresponding to 20% (i.e., one-fifth) of the maximum value of peak 3 (the peak top height) intersects the time axis (zero height), and is used to divide and separate the concentration peak due to surface oxygen from the concentration peak due to internal oxygen.

**Claims**

1. A silicon nitride powder comprising primary particles of silicon nitride, having an amorphous film composed of silicon oxide and/or silicon oxynitride on the surface of said primary particles, wherein an average value of the thickness of said amorphous film is 5.0 nm or less, and a coefficient of variation of the thickness of said amorphous film, represented by the following expression (1), is 0.60 or less, and a halogen content is 130 ppm or less.[Expression 1]

$$C_v = \frac{\sqrt{\dfrac{1}{n}\sum_{i=1}^{n}(x_i - \overline{x})^2}}{\overline{x}} \qquad \cdots\cdots\cdots \quad (1)$$

wherein, in the expression (1), $\overline{x}$ represents the average value of the thickness of the amorphous film, n represents the number of measurement points for the thickness of the amorphous film, and $x_i$ represents the thickness of the amorphous film measured at i-th point, respectively.

2. The silicon nitride powder according to claim 1, wherein a BET specific surface area (SA) is 3.0 $m^2$/g to 13.0 $m^2$/g, a surface oxygen content (FSO) measured by linear temperature ramp mode analysis is 0.15 mass% to 0.65 mass%, and an internal oxygen content (FIO) measured by linear temperature ramp mode analysis is 0.25 mass% to 1.00 mass%.

3. The silicon nitride powder according to claim 2, wherein the BET specific surface area (SA) is 3.0 $m^2$/g or higher and lower than 8.0 $m^2$/g, the surface oxygen content (FSO) measured by linear temperature ramp mode analysis is 0.15 mass% to 0.40 mass%, the internal oxygen content (FIO) measured by linear temperature ramp mode analysis is 0.25 mass% to 0.90 mass%, and a ratio of the surface oxygen content to the BET specific surface area (FSO/SA) is 0.25 mg/$m^2$ or more and less than 0.50 mg/$m^2$.

4. The silicon nitride powder according to claim 2, wherein the BET specific surface area (SA) is 8.0 $m^2$/g to 13.0 $m^2$/g, the surface oxygen content (FSO) measured by linear temperature ramp mode analysis is 0.20 mass% to 0.65 mass%, the internal oxygen content (FIO) measured by linear temperature ramp mode analysis is 0.50 mass% to 1.00 mass%, and a ratio of the surface oxygen content to the BET specific surface area (FSO/SA) is 0.23 mg/$m^2$ or more and less than 0.50 mg/$m^2$.

5. The silicon nitride powder according to claim 1, wherein a fluorine content is less than 120 ppm.

6. The silicon nitride powder according to claim 5, wherein a β fraction is 1.3 mass% to 14.0 mass%.

7. A method for producing a silicon nitride sintered body, comprising a step of forming and sintering raw materials for sintering containing the silicon nitride powder according to any one of claims 1 to 6, and a sintering aid.

# Figure 1

Figure 2

Figure 3

Figure 4

Figure 5

## INTERNATIONAL SEARCH REPORT

| International application No. |
|---|
| **PCT/JP2024/032058** |

**A. CLASSIFICATION OF SUBJECT MATTER**

*C04B 35/587*(2006.01)i; *C01B 21/068*(2006.01)i; *H05K 1/03*(2006.01)i
FI: C04B35/587; C01B21/068 P; H05K1/03 610D

According to International Patent Classification (IPC) or to both national classification and IPC

**B. FIELDS SEARCHED**

Minimum documentation searched (classification system followed by classification symbols)

C04B35/00-C04B35/84; C01B21/068; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JSTChina /JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | JP 7-206409 A (DENKI KAGAKU KOGYO KK) 08 August 1995 (1995-08-08) paragraphs [0067]-[0071], tables 2, 11 | 1-7 |
| A | KLEEBE, H-J. Statistical Analysis of the Intergranular Film Thickness in Silicon Nitride Ceramics. Journal of the American Ceramic Society. 1993, vol. 76, no. 8, pp. 1969-1977, doi: 10.1111/j.1151-2916.1993.tb08319.x | 1-7 |
| A | 劉　天泉, ポリシラザン溶液の噴霧熱分解法によるSi3N4球状粒子の合成, 日本セラミックス協会学術論文誌, 1989, vol. 97, no. 10, pp. 1321-1325, 10.2109/jcersj.97.1321, (Journal of the Ceramic Society of Japan), non-official translation (LIU, Tensen, Synthesis of spherical Si3N4 particles by spray pyrolysis of polysilazane solution) | 1-7 |
| A | JP 2007-84354 A (UBE INDUSTRIES, LTD.) 05 April 2007 (2007-04-05) | 1-7 |
| A | WO 2013/146713 A1 (UBE INDUSTRIES, LTD.) 03 October 2013 (2013-10-03) | 1-7 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **21 October 2024** | **19 November 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/032058**

| Patent document<br>cited in search report | | | Publication date<br>(day/month/year) | Patent family member(s) | | | Publication date<br>(day/month/year) |
|---|---|---|---|---|---|---|---|
| JP | 7-206409 | A | 08 August 1995 | (Family: none) | | | |
| JP | 2007-84354 | A | 05 April 2007 | (Family: none) | | | |
| WO | 2013/146713 | A1 | 03 October 2013 | US<br>CN | 2015/0056121<br>104203813 | A1<br>A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI72005206409 A
- JP 2009231388 A
- JP HEI5200370110 A
- WO 2021200868 A
- JP HEI5200387441 B
- JP HEI62004329404 A
- WO 2013146713 A
- WO 2021200830 A

**Non-patent literature cited in the description**

- **G.P. GAZZARA** ; **D.P. MESSIER**. *Am. Ceram. Soc. Bull*, 1977, vol. 56 (9), 777-80